# EUROPEAN PATENT APPLICATION

(11) **EP 4 462 188 A2**
(43) Date of publication of application: **13.11.2024**
(21) Application number: 24173115.7
(22) Date of filing: 29.04.2024
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 10.05.2023 JP 2023077813
(71) Applicant: SHIN-ETSU CHEMICAL CO., LTD., Tokyo 1000005 (JP)
(72) Inventor: Masunaga, Keiichi, NIIGATA-KEN (JP); Watanabe, Satoshi, NIIGATA-KEN (JP); Fukushima, Masahiro, NIIGATA-KEN (JP); Kotake, Masaaki, NIIGATA-KEN (JP); Matsuzawa, Yuta, NIIGATA-KEN (JP)
(74) Representative: Ter Meer Steinmeister & Partner

(57) **Abstract**

A chemically amplified positive resist composition is provided comprising (A) a quencher containing an onium salt having a nitrogen-containing aliphatic heterocycle and an aromatic carboxylic acid structure in its anion and (B) a base polymer containing a specific polymer which is decomposed under the action of acid to increase its solubility in alkaline developer. The resist composition exhibits a high resolution during pattern formation and forms a pattern of rectangular profile with improved LER, fidelity and dose margin.

## Description

### TECHNICAL FIELD

This invention relates to a chemically amplified positive resist composition and a resist pattern forming process using the same.

### BACKGROUND ART

To meet the recent demand for higher integration density and operating speed of LSIs, the effort to reduce the pattern rule is in rapid progress. Acid-catalyzed chemically amplified resist compositions are most often used in forming resist patterns with a feature size of 0.2 µm or less. High-energy radiation such as UV, deep-UV or EB is used as the light source for exposure of these resist compositions. In particular, while EB lithography is utilized as the ultra-fine microfabrication technique, it is also indispensable in processing photomask blanks to form photomasks for use in semiconductor device fabrication.

Polymers comprising a major proportion of aromatic structure having an acidic side chain, for example, polyhydroxystyrene are useful in resist materials for the KrF excimer laser lithography. These polymers are not used in resist materials for the ArF excimer laser lithography because they exhibit strong absorption at a wavelength of around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid-decomposable protective group (acid labile group). Upon exposure to high-energy radiation, the acid-decomposable protective group is deprotected by the catalysis of an acid generated from a photoacid generator so that the polymer may turn soluble in alkaline developer.

Typical of the acid-decomposable protective group are tertiary alkyl, tert-butoxycarbonyl, and acetal groups. The use of protective groups requiring a relatively low level of activation energy for deprotection such as acetal groups offers the advantage that a resist film having a high sensitivity is obtainable. However, if the diffusion of generated acid is not fully controlled, deprotection reaction can occur even in the unexposed region of the resist film, giving rise to problems like a lowering of line edge roughness (LER) and degradation of critical dimension uniformity (CDU) of pattern line width.

One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. In recent years, the multibeam mask writing (MBMW) process is used in the processing of mask blanks to achieve further miniaturization. The resist used in the MBMW process is a low-sensitivity resist (or high-dose region) which is advantageous in roughness while a spotlight is brought to the optimization of the resist composition in the high-dose region.

Attempts were made to ameliorate resist sensitivity and pattern profile in a controlled way by properly selecting and combining components used in resist compositions and adjusting processing conditions. One outstanding problem is the diffusion of acid. Since acid diffusion has a significant impact on the sensitivity and resolution of a chemically amplified resist composition, many studies are made on the acid diffusion problem.

Patent Documents 1 and 2 describe photoacid generators capable of generating bulky acids like benzenesulfonic acid upon exposure, for thereby controlling acid diffusion and reducing roughness. Since these acid generators are still insufficient to control acid diffusion, it is desired to have an acid generator with more controlled diffusion.

Patent Document 3 proposes to control acid diffusion in a resist composition by binding an acid generator capable of generating a sulfonic acid upon light exposure to a base polymer. This approach of controlling acid diffusion by binding repeat units capable of generating acid upon exposure to a base polymer is effective in forming a pattern with reduced LER. However, a problem arises with respect to the solubility in organic solvent of the base polymer having bound therein repeat units capable of generating acid upon exposure, depending on the structure and proportion of the repeat units.

Patent Document 4 describes a resist composition comprising a polymer comprising repeat units having an acetal group and a sulfonium salt capable of generating an acid having a high acid strength such as fluoroalkanesulfonic acid. The composition forms a pattern with noticeable LER. This is because the acid strength of fluoroalkanesulfonic acid is too high for the deprotection of the acetal group requiring a relatively low level of activation energy for deprotection. Even if acid diffusion is controlled, deprotection reaction can be promoted in the unexposed region by a minor amount of acid that has diffused thereto. The same problem arises with sulfonium salts capable of generating benzenesulfonic acids as described in Patent Documents 1 and 2. It is thus desired to have an acid generator capable of generating an acid having an appropriate strength to deprotect the acetal group.

While the aforementioned methodology of generating a bulky acid is effective for suppressing acid diffusion, the methodology of tailoring a quencher (also known as acid diffusion inhibitor) is also considered effective. The quencher is, in fact, essential for controlling acid diffusion and improving resist performance. Studies have been made on the quencher while amines and weak acid onium salts have been generally used. The weak acid onium salts are exemplified in several patent documents. For example, Patent Document 5 describes that the addition of triphenylsulfonium acetate ensures to form a satisfactory resist pattern without T-top profile, a difference in line width between isolated and grouped patterns, and standing waves. Patent Document 6 describes the addition of ammonium salts of sulfonic acids or carboxylic acids for achieving improvements in sensitivity, resolution and exposure margin. Also, Patent Document 7 describes that a resist composition for KrF or EB lithography comprising a PAG capable of generating a fluorinated carboxylic acid is improved in resolution and process latitudes such as exposure margin and depth of focus. These compositions are used in the KrF, EB and F₂ lithography processes.

Patent Document 8 describes a positive photosensitive composition for ArF lithography comprising a carboxylic acid onium salt. This system is based on the mechanism that a salt exchange occurs between a weak acid onium salt and a strong acid (sulfonic acid) generated by a PAG upon exposure, to form a weak acid and a strong acid onium salt. That is, the strong acid (sulfonic acid) having high acidity is replaced by a weak acid (carboxylic acid), thereby suppressing acid-catalyzed decomposition reaction of acid labile group and reducing or controlling the distance of acid diffusion. The onium salt apparently functions as a quencher.

Patent Documents 9 to 11 describe carboxylic acid onium salts having an indole, indoline or piperidine carboxylic acid structure which is a nitrogen-containing heterocyclic compound. Patent Document 12 describes a carboxylic acid onium salt having an aminobenzoic acid structure. Patent Document 13 describes a carboxylic acid onium salt having an amide bond. Although these compounds act as the quencher, some problems remain. Since the aromatic amine and amide bond are not highly basic, the acid diffusion controlling ability is not sufficient. The piperidine carboxylic acid is highly water soluble and difficult to manufacture in an industrially acceptable manner and incurs a swell problem during pattern formation.

When resist compositions comprising the carboxylic acid onium salts or fluorocarboxylic acid onium salts are used in patterning, LER and resolution are insufficient for the current lithography which must comply with advanced miniaturization. It is desired to have a quencher which has a reduced LER and is improved in resolution, rectangularity, pattern fidelity and dose margin.

### Citation List

| | |
|---|---|
| Patent Document 1: | JP-A 2009-053518 |
| Patent Document 2: | JP-A 2010-100604 |
| Patent Document 3: | JP-A 2011-022564 |
| Patent Document 4: | JP 5083528 |
| Patent Document 5: | JP 3955384 (USP 6479210) |
| Patent Document 6: | JP-A H11-327143 |
| Patent Document 7: | JP 4231622 (USP 6485883) |
| Patent Document 8: | JP 4226803 (USP 6492091) |
| Patent Document 9: | JP 6217561 |
| Patent Document 10: | JP 6874738 |
| Patent Document 11: | JP 6512049 |
| Patent Document 12: | JP 6323302 |
| Patent Document 13: | WO 2019/087626 |

### DISCLOSURE OF INVENTION

An object of the invention is to provide a chemically amplified positive resist composition which is processed by lithography to form a resist pattern of rectangular profile with improved LER, resolution, fidelity, and dose margin, and a pattern forming process using the resist composition.

The inventors have found that a resist composition comprising a quencher in the form of an onium salt containing an anion having a nitrogen-containing aliphatic heterocycle and an aromatic carboxylic acid structure can be processed by lithography to form a resist pattern of rectangular profile with improved resolution, LER, fidelity, and dose margin.

Accordingly, the invention provides a chemically amplified positive resist composition and resist pattern forming process, as defined below.
1. A chemically amplified positive resist composition comprising (A) a quencher containing an onium salt having the formula (A) and (B) a base polymer containing a polymer which is decomposed under the action of acid to increase its solubility in alkaline developer, the polymer comprising repeat units having the formula (B1), 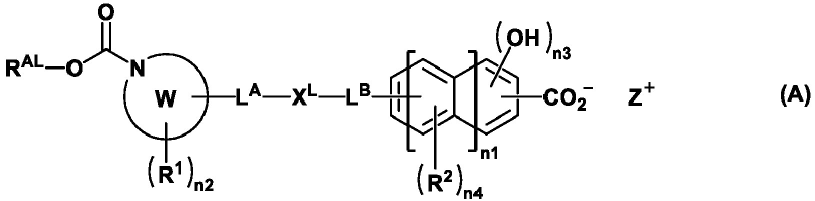
   wherein n1 is 0 or 1, n2 is an integer of 0 to 6, n3 is an integer of 0 to 3, n4 is an integer of 0 to 4,
      W is a C₂-C₂₀ nitrogen-containing aliphatic heterocycle which may contain a heteroatom,
      L^{A} and L^{B} are each independently a single bond, ether bond, ester bond, amide bond, sulfonate ester bond, carbonate bond or carbamate bond,
      X^{L} is a single bond or a C₁-C₄₀ hydrocarbylene group which may contain a heteroatom,
      R¹ is a C₁-C₂₀ hydrocarbyl group which may contain a heteroatom, and when n2 is 2 or more, a plurality of R¹ may bond together to form a ring with the carbon atoms on W to which they are attached,
      R² is halogen or a C₁-C₂₀ hydrocarbyl group which may contain a heteroatom, and when n4 is 2 or more, a plurality of R² may bond together to form a ring with the carbon atoms on the aromatic ring to which they are attached,
      R^{AL} is an acid labile group, and
      Z⁺ is an onium cation, 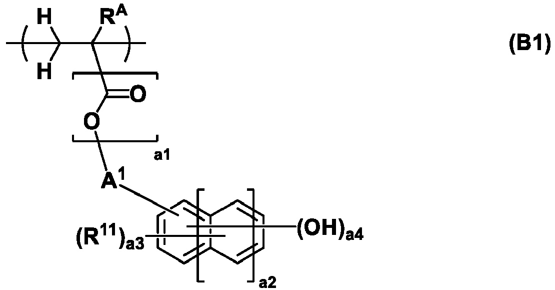
   wherein a1 is 0 or 1, a2 is an integer of 0 to 2, a3 is an integer satisfying 0 ≤ a3 ≤ 5+2(a2)-a4, a4 is an integer of 1 to 3,
      R^{A} is hydrogen, fluorine, methyl or trifluoromethyl,
      R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
      A¹ is a single bond or C₁-C₁₀ saturated hydrocarbylene group in which some constituent -CH₂- may be replaced by -O-.
2. The positive resist composition of 1 wherein R^{AL} is a group having the formula (AL-1) or (AL-2): 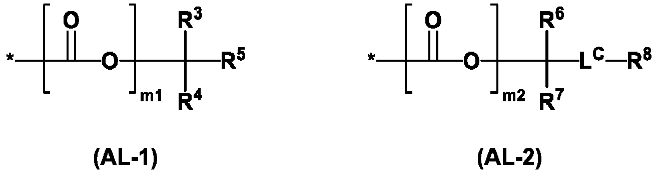 wherein L^{C} is -O- or -S-,
   R³, R⁴ and R⁵ are each independently a C₁-C₁₀ hydrocarbyl group, any two of R³, R⁴ and R⁵ may bond together to form a ring with the carbon atom to which they are attached,
   R⁶ and R⁷ are each independently hydrogen or a C₁-C₁₀ hydrocarbyl group, R⁸ is a C₁-C₂₀ hydrocarbyl group in which -CH₂- may be replaced by -O- or -S-, R⁷ and R⁸ may bond together to form a C₃-C₂₀ heterocyclic group with the carbon atom and L^{C} to which they are attached, -CH₂- in the heterocyclic group may be replaced by -O- or -S-,
   m1 and m2 are each independently 0 or 1, and
   * designates a point of attachment to the adjacent -O-.
3. The positive resist composition of 1 or 2 wherein Z⁺ is a sulfonium cation having the formula (cation-1), iodonium cation having the formula (cation-2), or ammonium cation having the formula (cation-3): 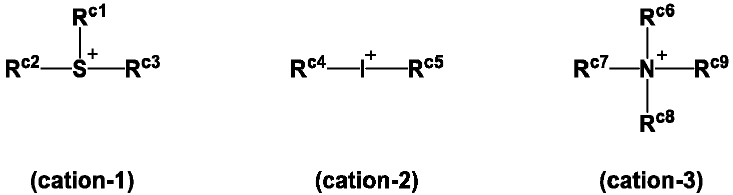 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.
4. The positive resist composition of any one of 1 to 3 wherein the onium salt has the formula (A1): 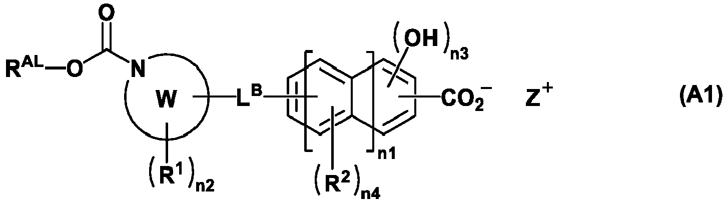 wherein n1 to n4, W, L^{B}, R¹, R², R^{AL} and Z⁺ are as defined above.
5. The positive resist composition of 4 wherein the onium salt has the formula (A2): 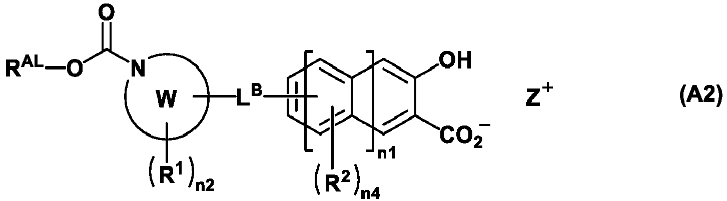 wherein n1, n2, n4, W, L^{B}, R¹, R², R^{AL} and Z⁺ are as defined above.
6. The positive resist composition of any one of 1 to 5 wherein the polymer further comprises repeat units of at least one type selected from repeat units having the formula (B2-1) and repeat units having the formula (B2-2): 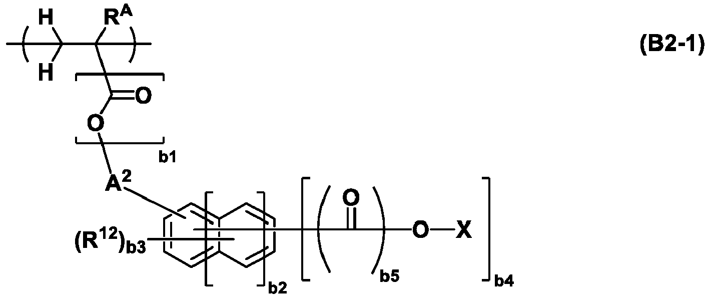 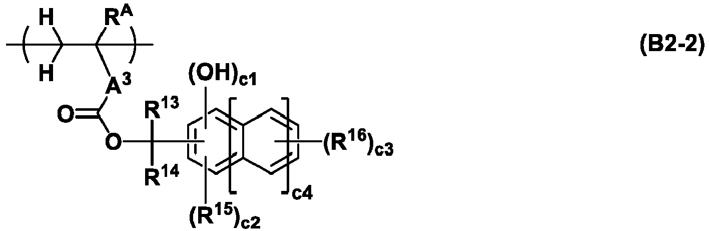 wherein b1 is 0 or 1, b2 is an integer of 0 to 2, b3 is an integer meeting 0 ≤ b3 ≤ 5+2(b2)-b4, b4 is an integer of 1 to 3, b5 is 0 or 1,
   c1 is an integer of 0 to 2, c2 is an integer of 0 to 2, c3 is an integer of 0 to 5, c4 is an integer of 0 to 2,
   R^{A} is hydrogen, fluorine, methyl or trifluoromethyl,
   R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
   R¹³ and R¹⁴ are each independently a C₁-C₁₀ hydrocarbyl group which may contain a heteroatom, R¹³ and R¹⁴ may bond together to form a ring with the carbon atom to which they are attached,
   R¹⁵ is each independently fluorine, a C₁-C₅ fluorinated alkyl group or C₁-C₅ fluorinated alkoxy group,
   R¹⁶ is each independently a C₁-C₁₀ hydrocarbyl group which may contain a heteroatom,
   A² is a single bond or a C₁-C₁₀ saturated hydrocarbylene group in which -CH₂- may be replaced by -O-,
   X is an acid labile group in case of b4=1, and X is each independently hydrogen or an acid labile group, at least one being an acid labile group, in case of b4=2 or 3, and
   A³ is a single bond, phenylene group, naphthylene group or *-C(=O)-O-A³¹-, A³¹ is a C₁-C₂₀ aliphatic hydrocarbylene group which may contain a hydroxy moiety, ether bond, ester bond or lactone ring, or a phenylene group or naphthylene group, and * designates a point of attachment to the carbon atom in the backbone.
7. The positive resist composition of any one of 1 to 6 wherein the polymer further comprises repeat units of at least one type selected from repeat units having the formula (B3), repeat units having the formula (B4), and repeat units having the formula (B5): 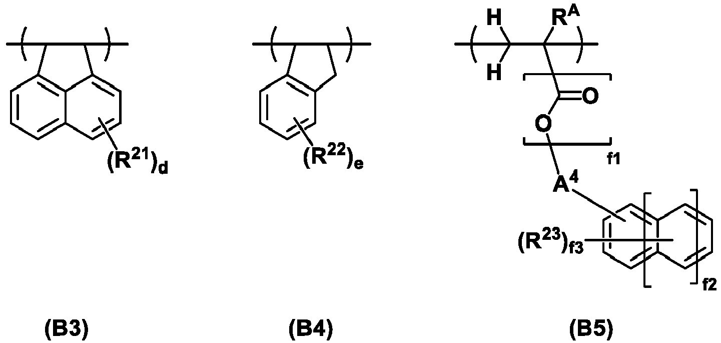 wherein d and e are each independently an integer of 0 to 4, f1 is 0 or 1, f2 is an integer of 0 to 2, f3 is an integer of 0 to 5,
   R^{A} is hydrogen, fluorine, methyl or trifluoromethyl,
   R²¹ and R²² are each independently hydroxy, halogen, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
   R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group, and
   A⁴ is a single bond or C₁-C₁₀ saturated hydrocarbylene group in which -CH₂- may be replaced by -O-.
8. The positive resist composition of any one of 1 to 7 wherein the polymer further comprises repeat units of at least one type selected from repeat units having the formulae (B6) to (B 13): 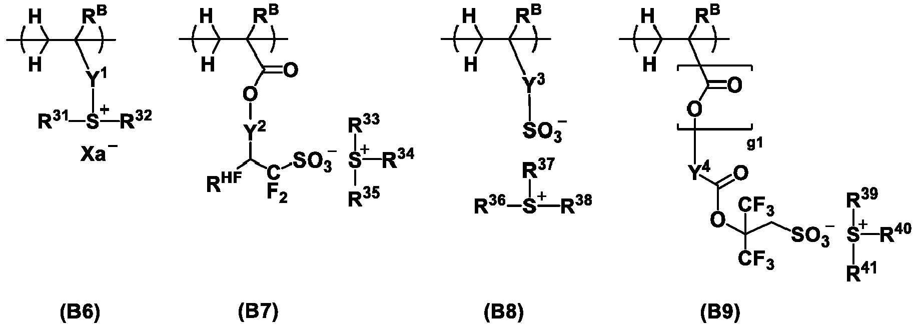 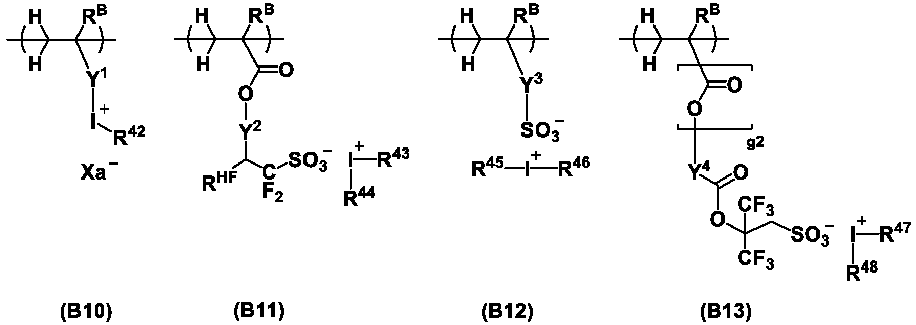 wherein R^{B} is each independently hydrogen or methyl,
   Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
   Y² is a single bond or **-Y²¹-C(=O)-O-, Y²¹ is a C₁-C₂₀ hydrocarbylene group which may contain a heteroatom,
   Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
   * designates a point of attachment to the carbon atom in the backbone, ** designates a point of attachment to the oxygen atom in the formula,
   Y⁴ is a single bond or C₁-C₃₀ hydrocarbylene group which may contain a heteroatom,
   g1 and g2 are each independently 0 or 1, g1 and g2 are 0 when Y⁴ is a single bond,
   R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
   R^{HF} is hydrogen or trifluoromethyl, and
   Xa⁻ is a non-nucleophilic counter ion.
9. The positive resist composition of any one of 1 to 8 wherein repeat units having an aromatic ring structure account for at least 60 mol% of the overall repeat units of the polymer in the base polymer.
10. The positive resist composition of any one of 1 to 9, further comprising (C) a photoacid generator.
11. The positive resist composition of 10 wherein the acid generator contains an anion having an acid strength (pKa) of -3.0 or larger.
12. The positive resist composition of 10 or 11 wherein the acid generator (C) and the quencher (A) are present in a weight ratio of less than 6/1.
13. The positive resist composition of any one of 1 to 12, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 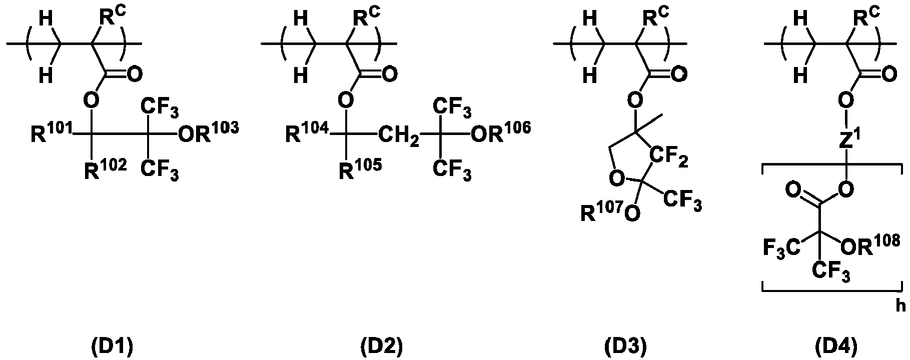 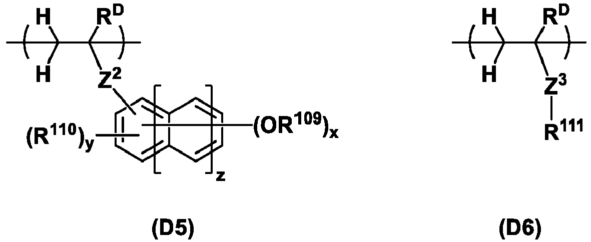 wherein x is an integer of 1 to 3, y is an integer satisfying 0 ≤ y ≤ 5+2z-x, z is 0 or 1, h is an integer of 1 to 3,
   R^{C} is each independently hydrogen, fluorine, methyl or trifluoromethyl,
   R^{D} is each independently hydrogen or methyl,
   R¹⁰¹, R¹⁰², R¹⁰⁴ and R¹⁰⁵ are each independently hydrogen or a C₁-C₁₀ saturated hydrocarbyl group,
   R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
   R¹⁰⁹ is hydrogen or a C₁-C₅ straight or branched hydrocarbyl group in which a heteroatom-containing moiety may intervene in a carbon-carbon bond,
   R¹¹⁰ is a C₁-C₅ straight or branched hydrocarbyl group in which a heteroatom-containing moiety may intervene in a carbon-carbon bond,
   R¹¹¹ is a C₁-C₂₀ saturated hydrocarbyl group in which at least one hydrogen is substituted by fluorine, and in which some constituent -CH₂- may be replaced by an ester bond or ether bond,
   Z¹ is a C₁-C₂₀ (h+1)-valent hydrocarbon group or C₁-C₂₀ (h+1)-valent fluorinated hydrocarbon group,
   Z² is a single bond, *-C(=O)-O- or *-C(=O)-NH-, * designates a point of attachment to the carbon atom in the backbone,
   Z³ is a single bond, -O-, *-C(=O)-O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.
14. The positive resist composition of any one of 1 to 13, further comprising (E) an organic solvent.
15. A resist pattern forming process comprising the steps of:
   applying the chemically amplified positive resist composition of any one of 1 to 14 onto a substrate to form a resist film thereon,
   exposing the resist film patternwise to high-energy radiation, and
   developing the exposed resist film in an alkaline developer.
16. The process of 15 wherein the high-energy radiation is EUV or EB.
17. The process of 15 or 16 wherein the substrate has the outermost surface of a material containing at least one element selected from chromium, silicon, tantalum, molybdenum, cobalt, nickel, tungsten, and tin.
18. The process of any one of 15 to 17 wherein the substrate is a mask blank of transmission or reflection type.
19. A mask blank of transmission or reflection type which is coated with the chemically amplified positive resist composition of any one of 1 to 14.

### ADVANTAGEOUS EFFECTS OF INVENTION

Owing to the function of the onium salt of formula (A) having an appropriate degree of lipophilicity, a resist composition comprising the onium salt is effective for controlling acid diffusion upon light exposure for pattern formation. When the composition is coated onto a substrate to form a resist film, which is processed by EUV or EB lithography, a pattern of rectangular profile having a very high resolution, high fidelity, improved LER and dose margin can be formed. Owing to the repeat units having formula (B 1), the adhesion of the resist film to the substrate is enhanced and the dissolution of the resist film in alkaline developer is facilitated.

Since the resist pattern forming process using the chemically amplified positive resist composition can form a pattern having a very high resolution, high fidelity, improved LER and dose margin, the resist composition and the pattern forming process are advantageously applicable to the micropatterning technology, especially EUV and EB lithography processes.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group.

In chemical formulae, Me stands for methyl, and Ac for acetyl. Both the broken line (---) and the asterisk (*) designate a point of attachment or valence bond. As used herein, the term "fluorinated" refers to a fluorine-substituted or fluorine-containing compound or group. The terms "group" and "moiety" are interchangeable.

The abbreviations and acronyms have the following meaning.
EB: electron beam
EUV: extreme ultraviolet
Mw: weight average molecular weight
Mn: number average molecular weight
Mw/Mn: molecular weight distribution or dispersity
GPC: gel permeation chromatography
PEB: post-exposure bake
PAG: photoacid generator
LER: line edge roughness
EL: exposure latitude
DOF: depth of focus
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Chemically amplified positive resist composition

One embodiment of the invention is a chemically amplified positive resist composition comprising (A) a quencher containing an onium salt having a specific nitrogen-containing heterocycle and an aromatic carboxylic acid structure and (B) a base polymer containing a polymer which is decomposed under the action of acid to increase its solubility in alkaline developer.

### (A) Quencher

The quencher as component (A) contains an onium salt having the formula (A).

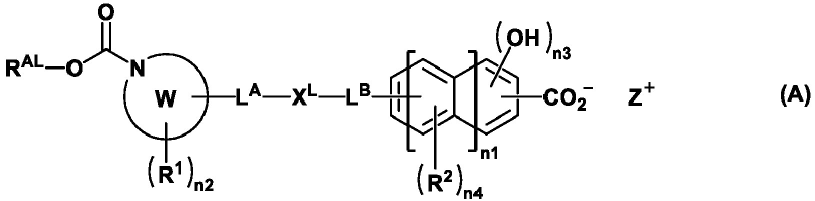

In formula (A), n1 is 0 or 1. The relevant structure represents a benzene ring in case of n1=0, and a naphthalene ring in case of n1=1. From the aspect of solvent solubility, a benzene ring corresponding to n1=0 is preferred. The subscript n2 is an integer of 0 to 6. The subscript n3 is an integer of 0 to 3, preferably 0 to 2, more preferably 0 or 1. When n3 is 1, 2 or 3, the aromatic hydroxy group(s) on the aromatic ring functions as an acid diffusion controlling group and when it is adjacent the carboxylate group on the aromatic ring, solvent solubility is improved by the resultant hydrogen bond. The subscript n4 is an integer of 0 to 4.

In formula (A), W is a C₂-C₂₀ nitrogen-containing aliphatic heterocycle which may contain a heteroatom. Exemplary structures of W are shown below, but not limited thereto. It is noted that in each structure, * designates a point of attachment to L^{A}, and ** designates a point of attachment to R^{AL}-O-C(=O)-.

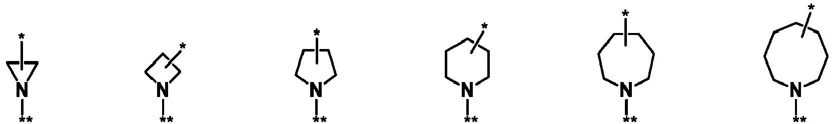

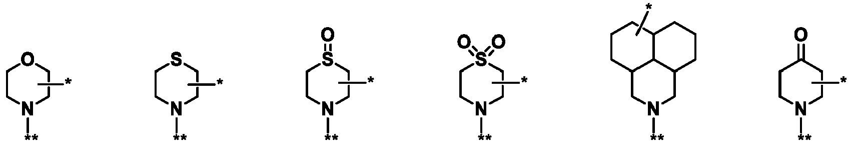

In formula (A), L^{A} and L^{B} are each independently a single bond, ether bond, ester bond, amide bond, sulfonate ester bond, carbonate bond or carbamate bond. Of these, a single bond, ether bond, ester bond and amide bond are preferred, with a single bond, ester bond and amide bond being more preferred.

In formula (A), X^{L} is a single bond or a C₁-C₄₀ hydrocarbylene group which may contain a heteroatom. The hydrocarbylene group may be straight, branched or cyclic and examples thereof include alkanediyl groups and cyclic saturated hydrocarbylene groups. Suitable heteroatoms include oxygen, nitrogen, and sulfur.

Examples of the optionally heteroatom-containing C₁-C₄₀ hydrocarbylene group X^{L} are shown below, but not limited thereto. Herein * each designates a point of attachment to L^{A} or L^{B}.

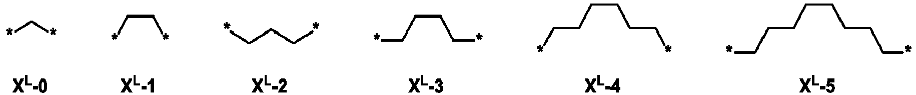

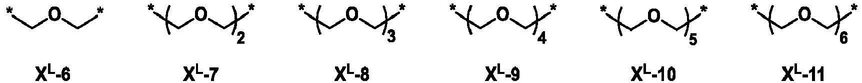

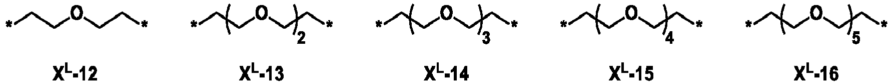

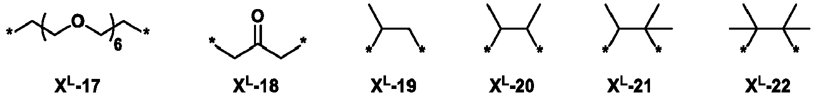

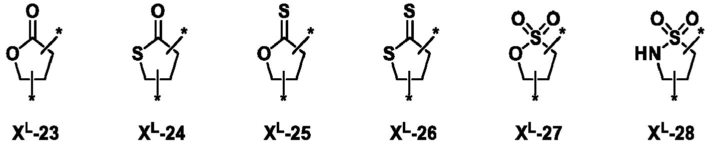

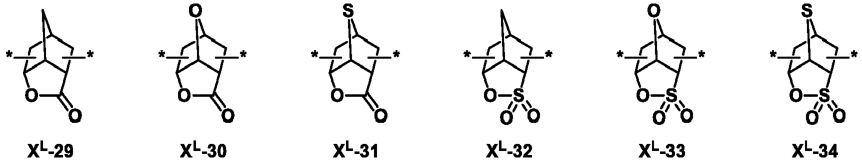

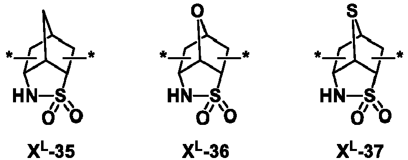

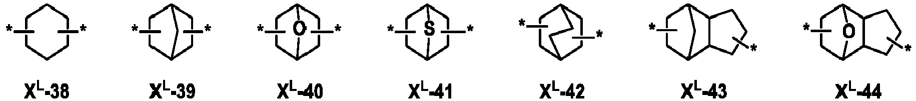

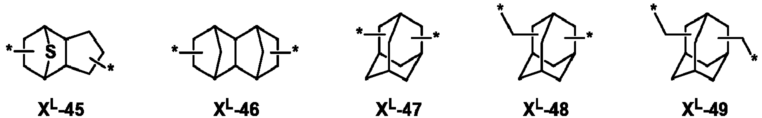

Of these, X^{L}-0 to X^{L}-22 and X^{L}-47 to X^{L}-49 are preferred, with X^{L}-0 to X^{L}-17 being more preferred.

In formula (A), R¹ is a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, propyl, isopropyl, n-butyl, isobutyl, sec-butyl, tert-butyl, n-pentyl, tert-pentyl, n-hexyl, n-octyl, 2-ethylhexyl, n-nonyl, and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₆-C₂₀ aryl groups such as phenyl, naphthyl and anthryl, and combinations thereof. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, carbonyl moiety, ether bond, ester bond, sulfonate ester bond, carbonate bond, carbamate bond, amide bond, imide bond, lactone ring, sultone ring, thiolactone ring, lactam ring, sultam ring, carboxylic anhydride (-C(=O)-O-C(=O)-) or haloalkyl moiety.

When n2 is 2 or more (i.e., n2 ≥ 2), a plurality of R¹ may bond together to form a ring with the carbon atoms on W to which they are attached. Examples of the ring include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the ring may contain a hydroxy moiety, fluorine, chlorine, bromine, iodine, cyano moiety, carbonyl moiety, ether bond, ester bond, sulfonate ester bond, carbonate bond, lactone ring, sultone ring, carboxylic anhydride (-C(=O)-O-C(=O)-) or haloalkyl moiety. Also, two R¹ may bond with a common atom on W and bond together to form a ring, i.e., spiro ring.

In formula (A), R² is halogen or a C₁-C₂₀ hydrocarbyl group which may contain a heteroatom. Suitable halogen atoms include fluorine, chlorine, bromine, and iodine. The hydrocarbyl group may be saturated or unsaturated and straight, branched or cyclic. Examples thereof are as exemplified above for the hydrocarbyl group R¹. When n4 is 2 or more (i.e., n4 ≥ 2), a plurality of R² may bond together to form a ring with the carbon atoms on the aromatic ring to which they are attached. Examples of the ring are as exemplified above for the ring that a plurality of R¹ bond together and form with carbon atoms on W.

In formula (A), R^{AL} is an acid labile group. Preferably, R^{AL} is a group having the formula (AL-1) or (AL-2).

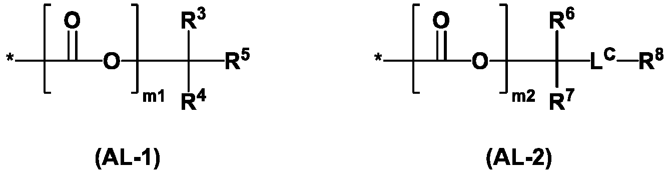

Herein * designates a point of attachment to the adjacent -O-.

In formula (AL-1), R³, R⁴ and R⁵ are each independently a C₁-C₁₀ hydrocarbyl group. Any two of R³, R⁴ and R⁵ may bond together to form a ring with the carbon atom to which they are attached. The subscript m1 is 0 or 1.

In formula (AL-2), L^{C} is -O- or -S-. R⁶ and R⁷ are each independently hydrogen or a C₁-C₁₀ hydrocarbyl group. R⁸ is a C₁-C₂₀ hydrocarbyl group in which -CH₂- may be replaced by -O- or -S-. R⁷ and R⁸ may bond together to form a C₃-C₂₀ heterocyclic group with the carbon atom and L^{C} to which they are attached. Some constituent -CH₂- in the heterocyclic group may be replaced by -O- or -S-. The subscript m2 is 0 or 1.

Examples of the acid labile group having formula (AL-1) are shown below, but not limited thereto. Herein * designates a point of attachment to the adjacent -O-.

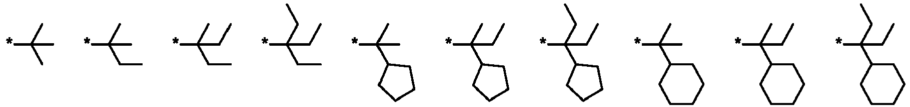

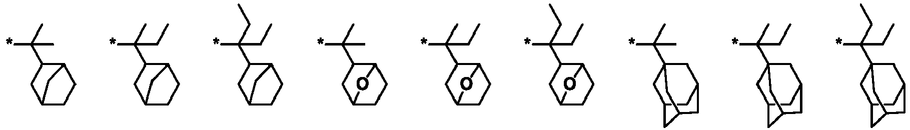

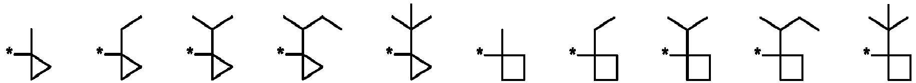

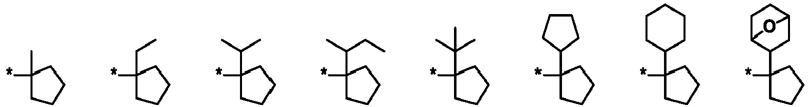

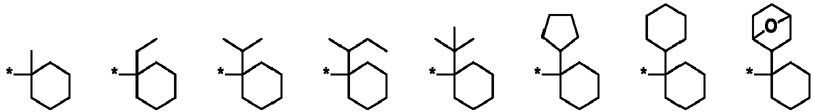

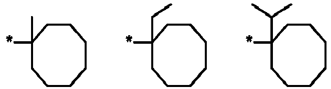

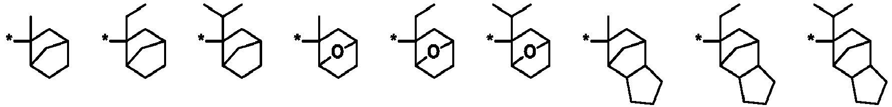

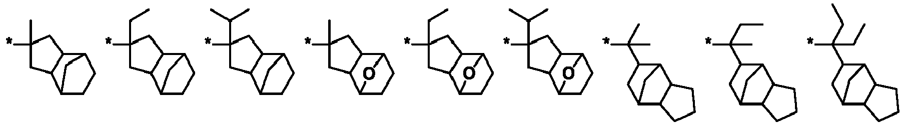

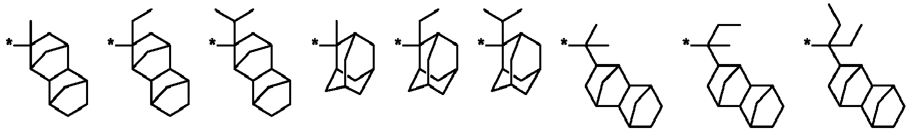

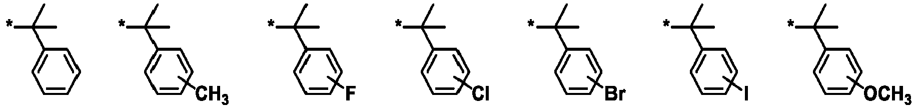

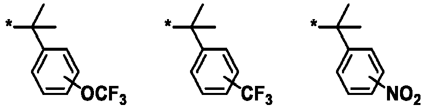

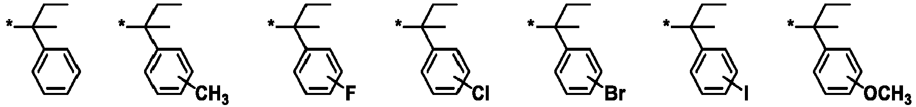

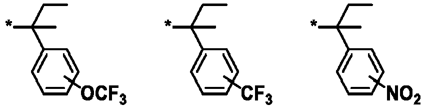

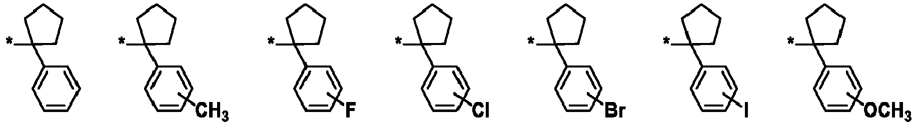

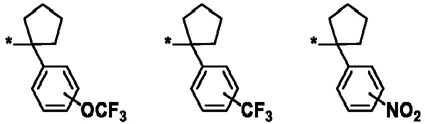

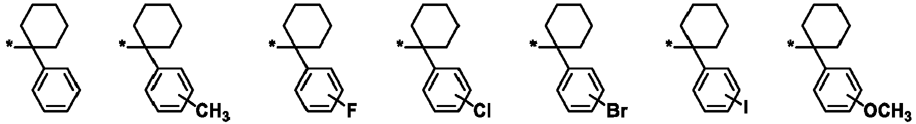

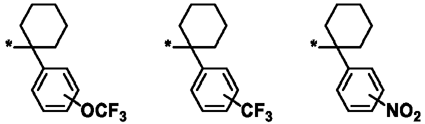

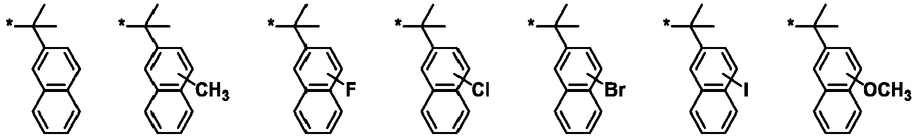

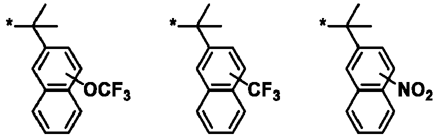

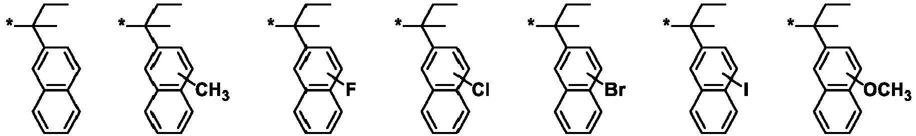

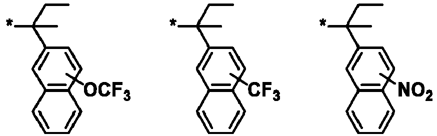

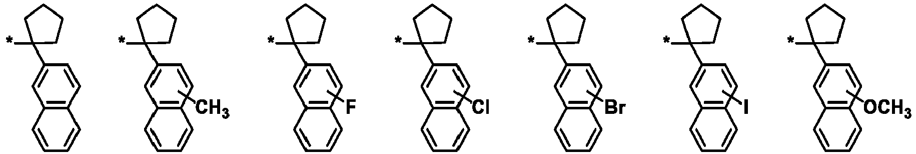

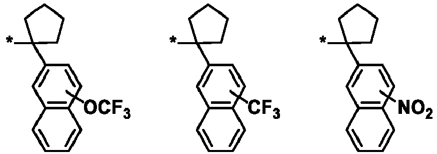

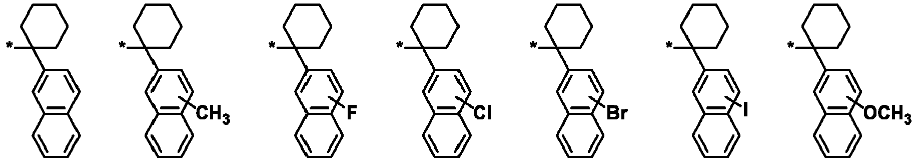

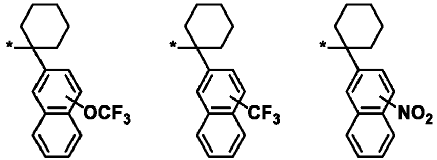

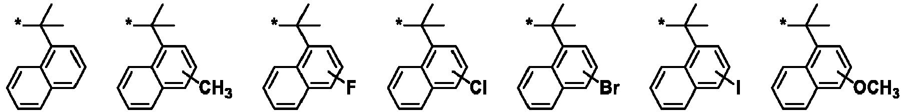

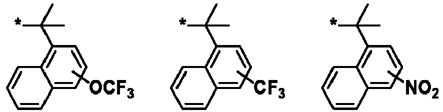

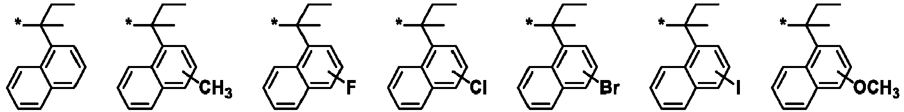

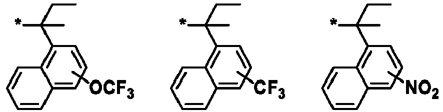

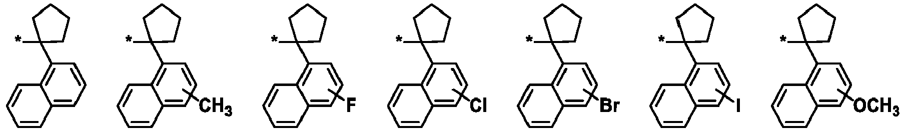

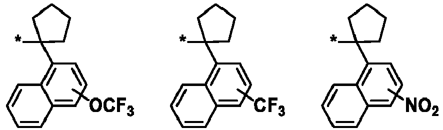

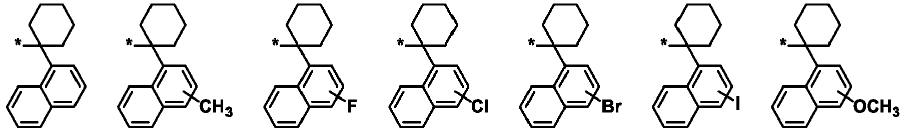

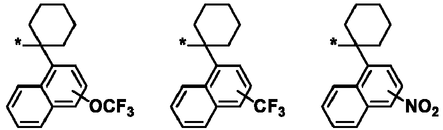

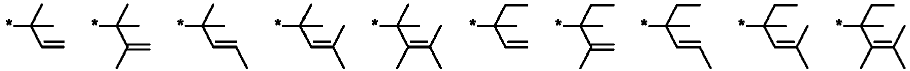

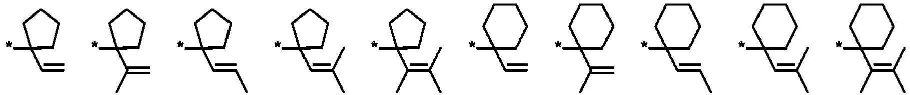

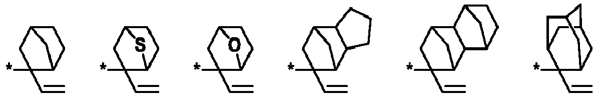

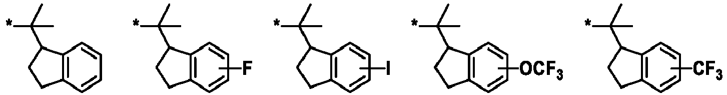

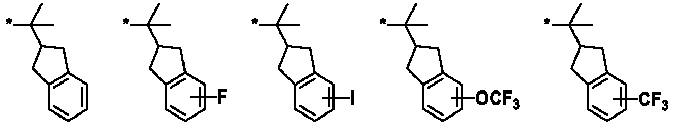

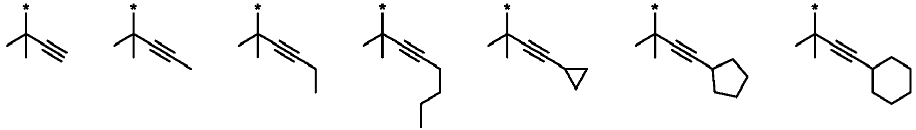

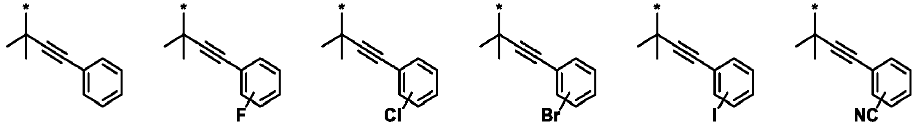

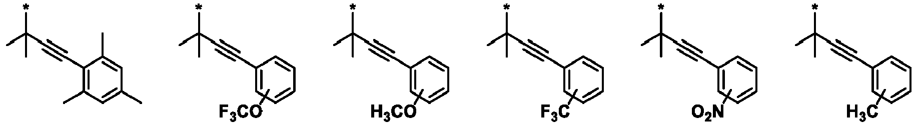

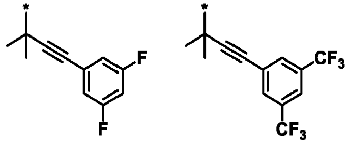

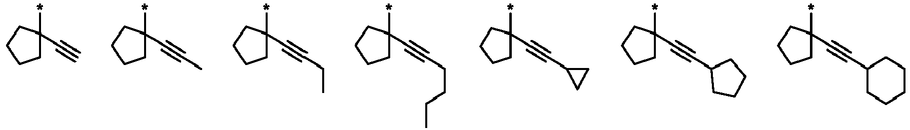

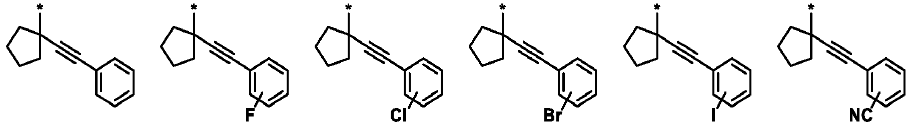

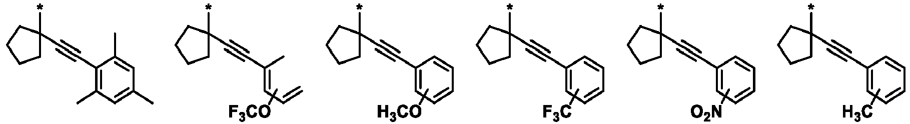

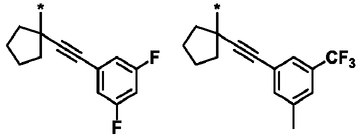

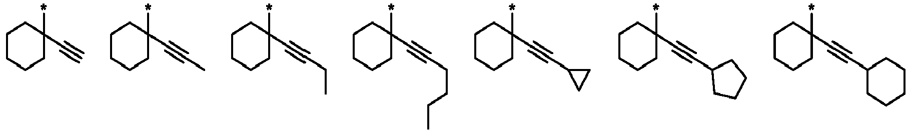

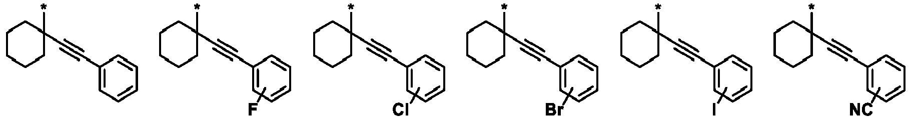

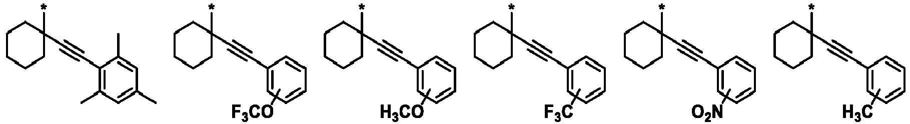

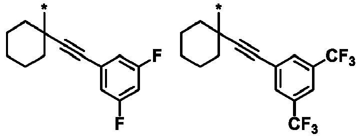

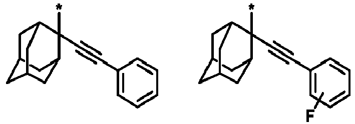

Examples of the acid labile group having formula (AL-2) are shown below, but not limited thereto. Herein * designates a point of attachment to the adjacent -O-.

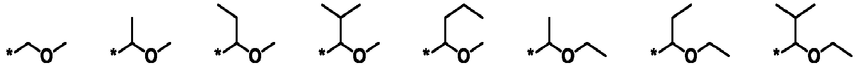

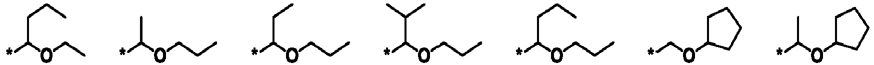

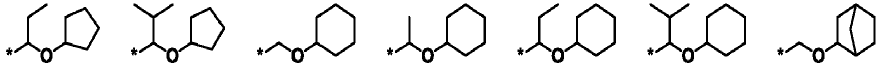

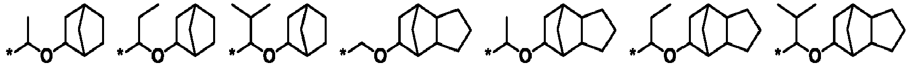

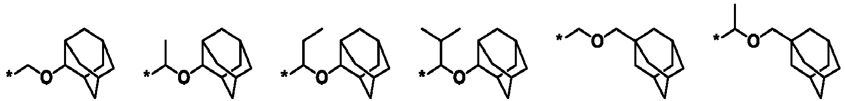

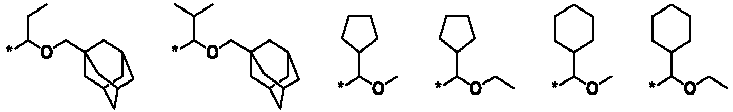

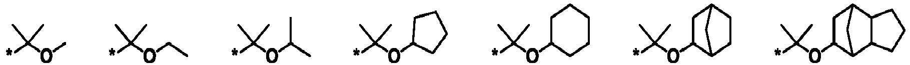

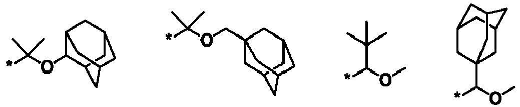

Of the onium salts having formula (A), those having the formula (A1) are preferred. 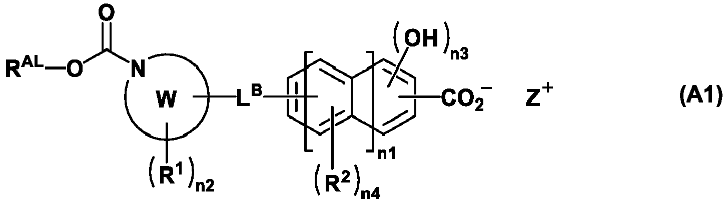 Herein n1 to n4, W, L^{B}, R¹, R², R^{AL} and Z⁺ are as defined above.

Of the onium salts having formula (A1), those having the formula (A2) are more preferred. 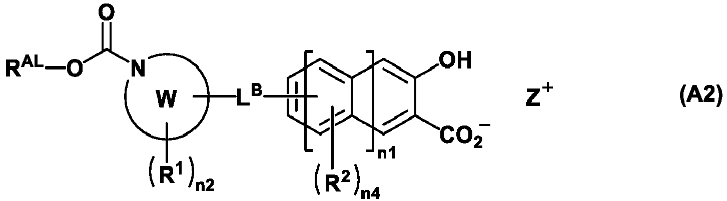 Herein n1, n2, n4, W, L^{B}, R¹, R², R^{AL} and Z⁺ are as defined above.

Examples of the anion in the onium salt having formula (A) are shown below, but not limited thereto.

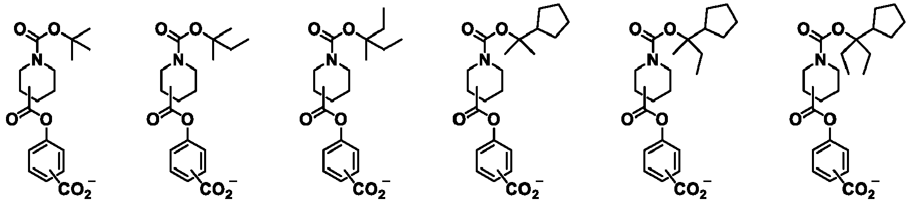

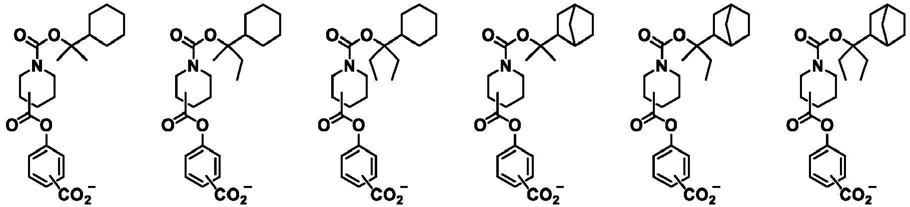

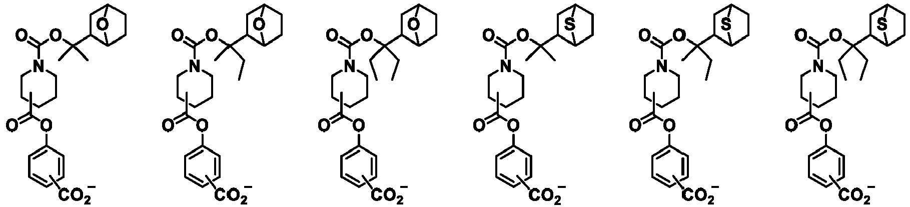

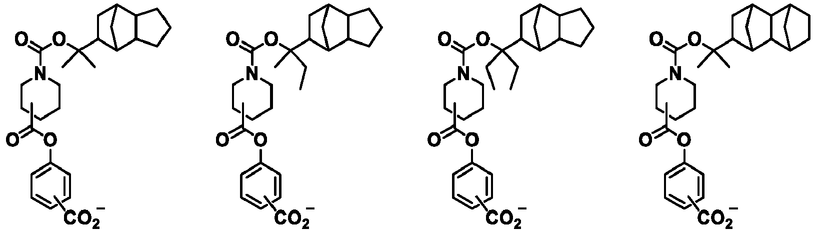

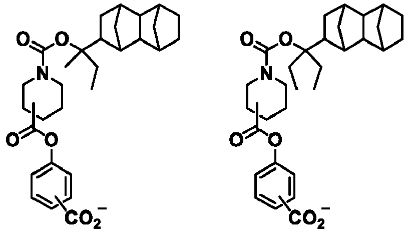

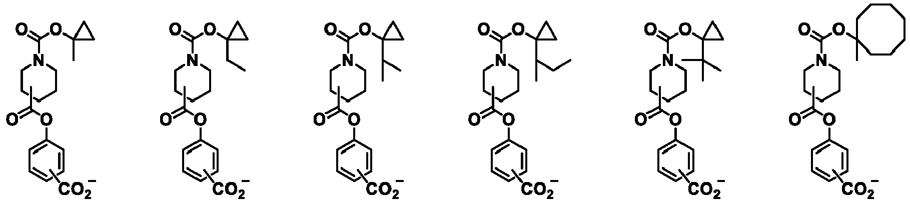

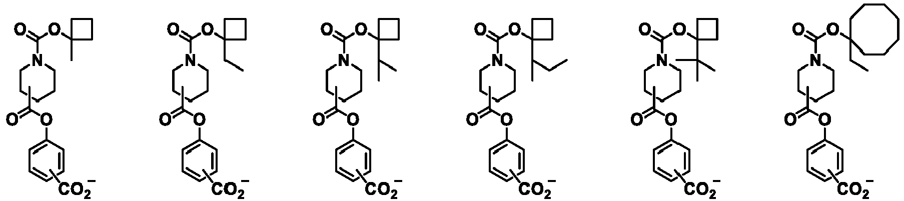

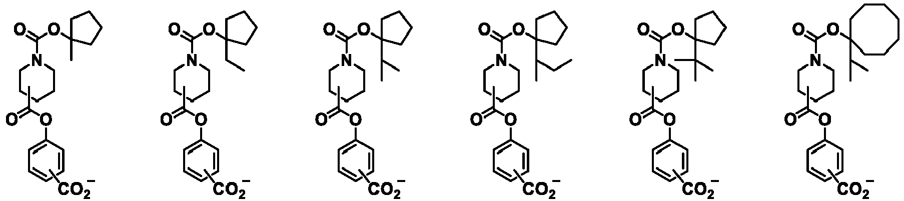

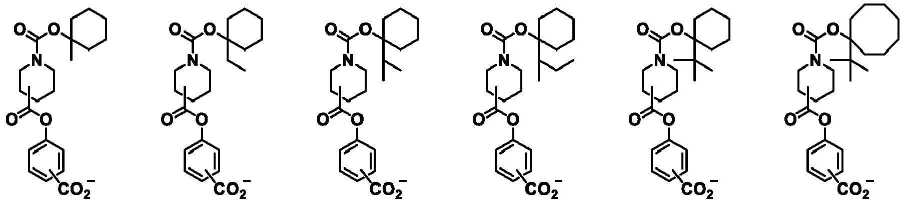

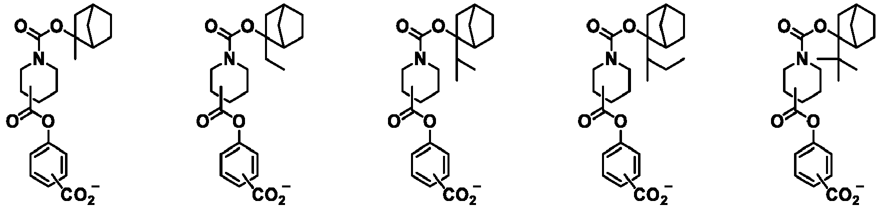

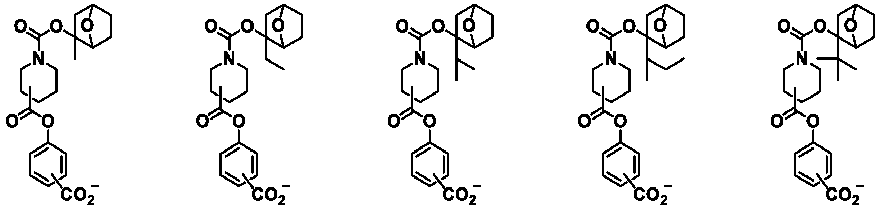

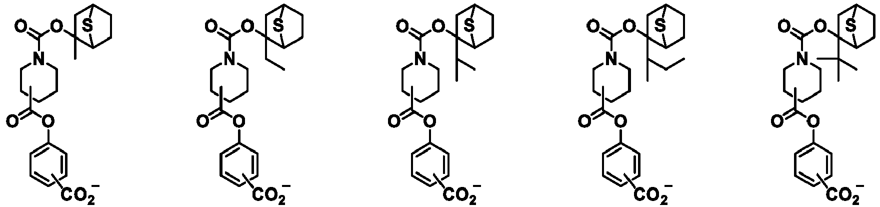

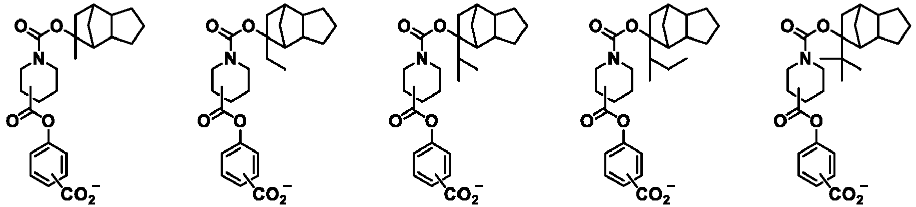

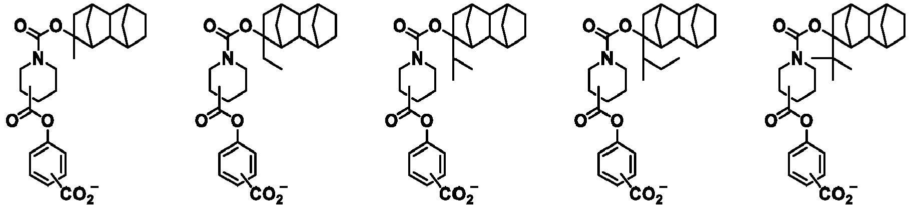

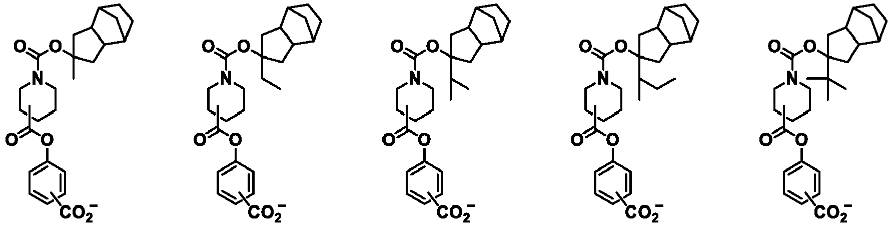

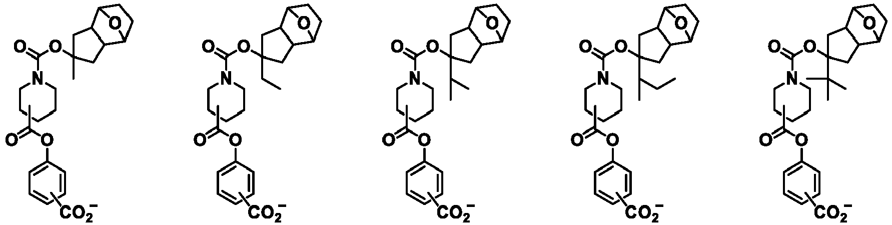

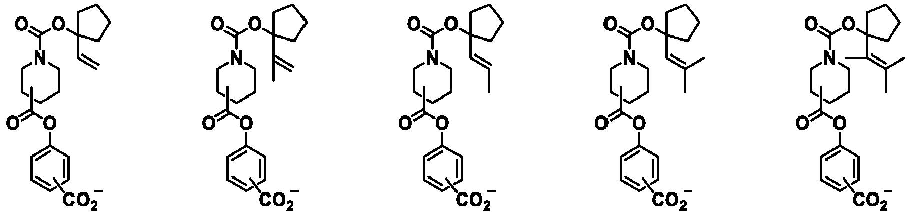

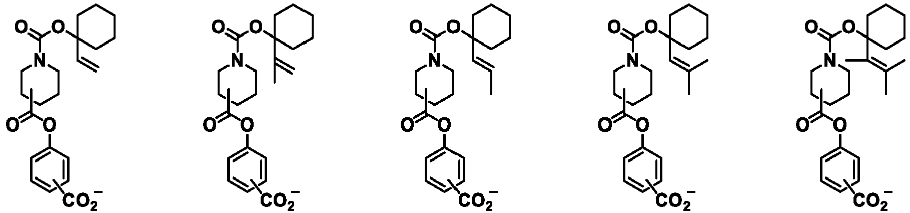

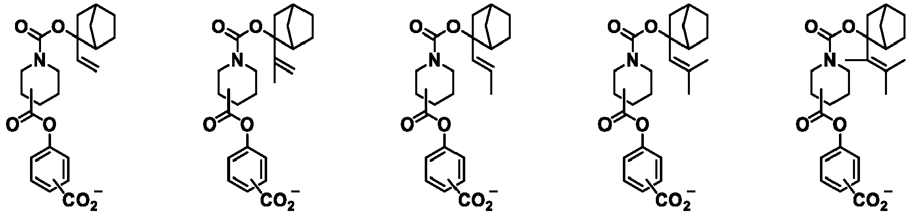

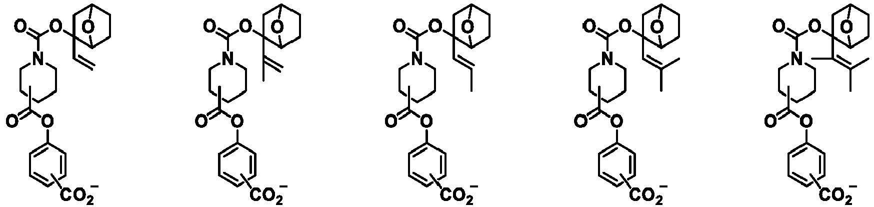

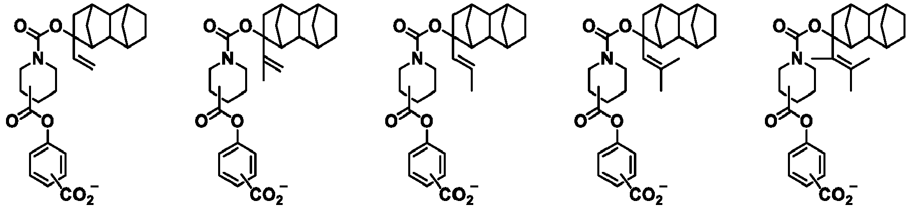

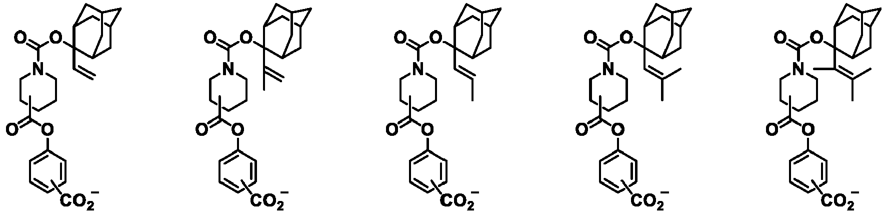

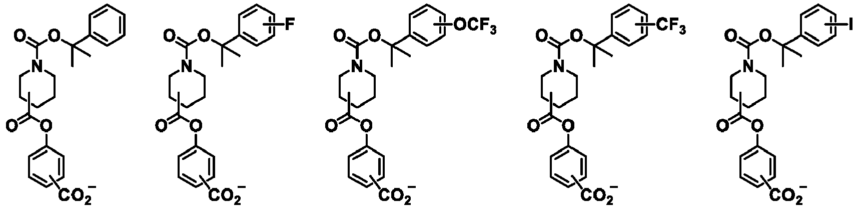

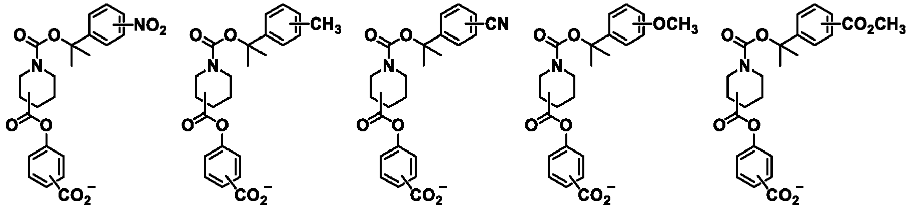

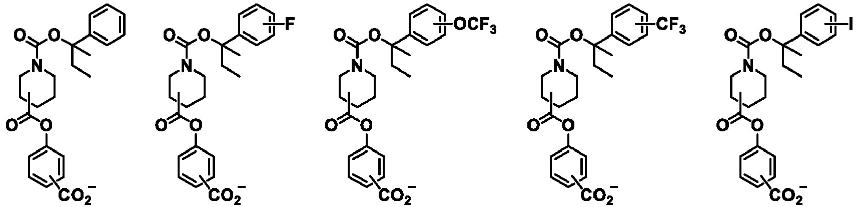

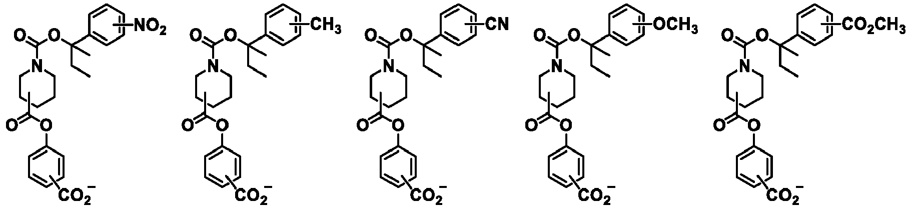

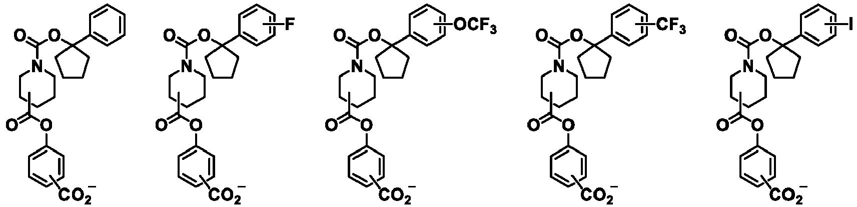

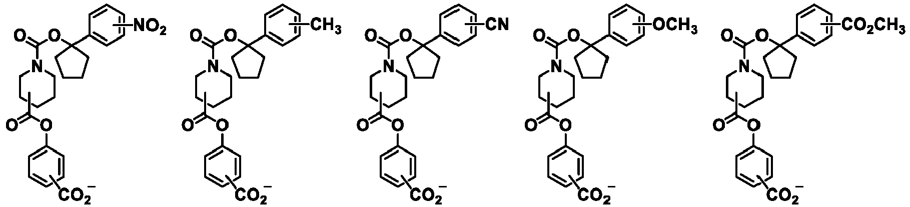

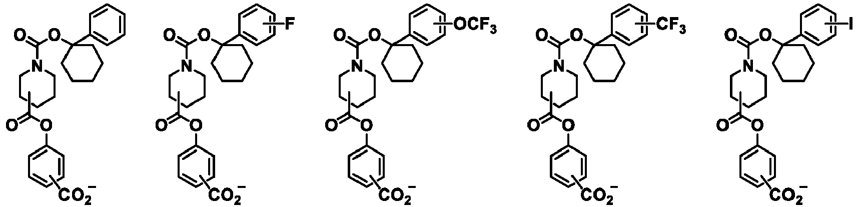

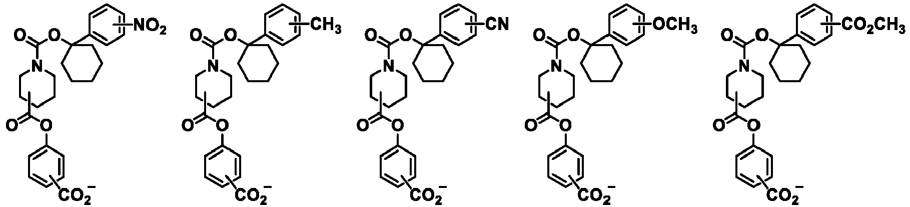

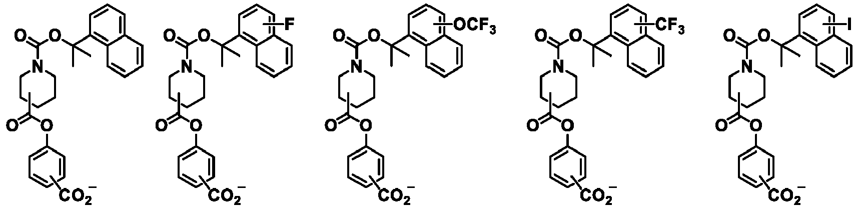

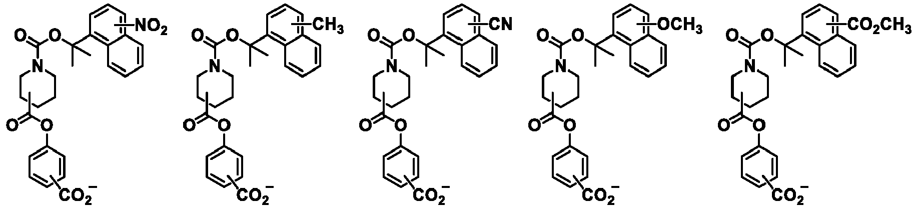

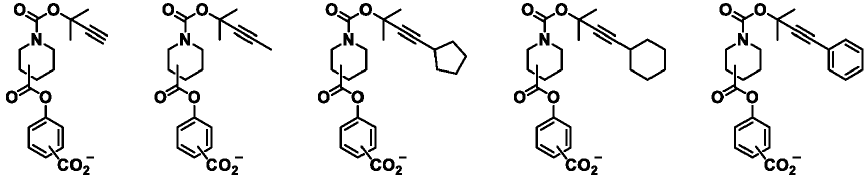

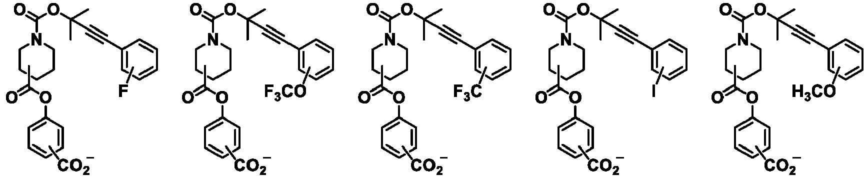

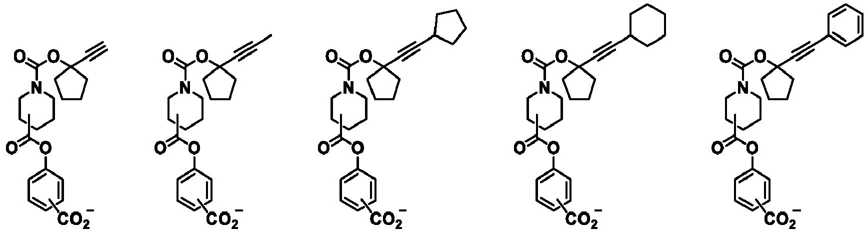

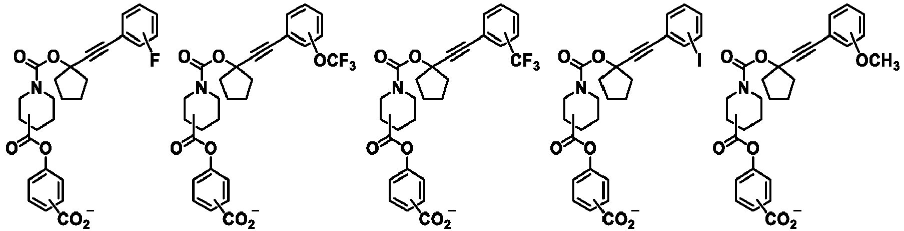

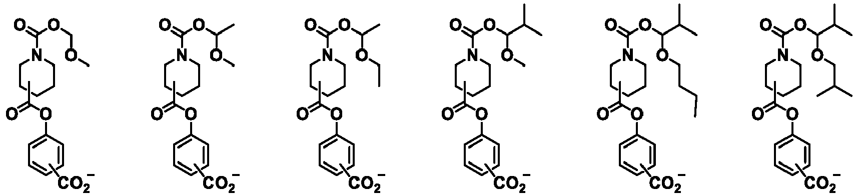

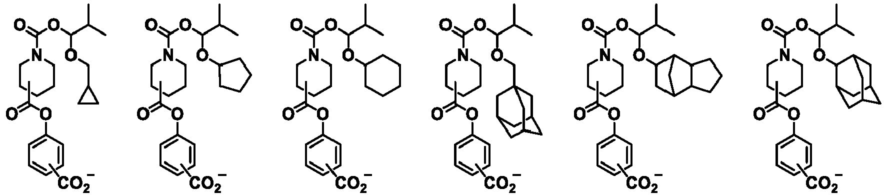

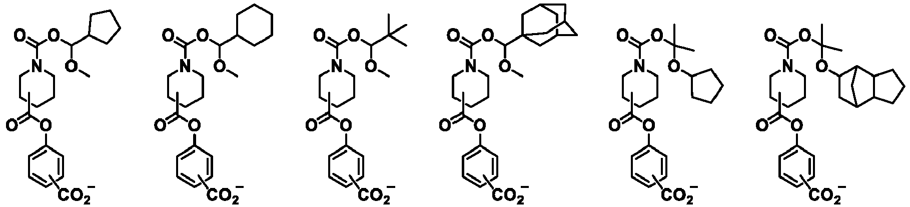

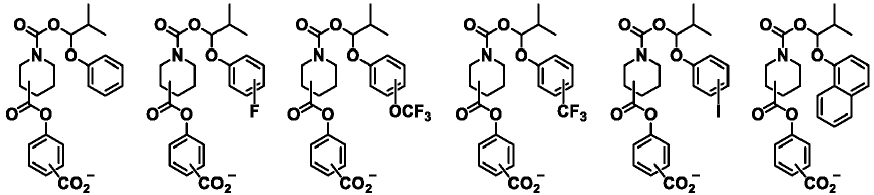

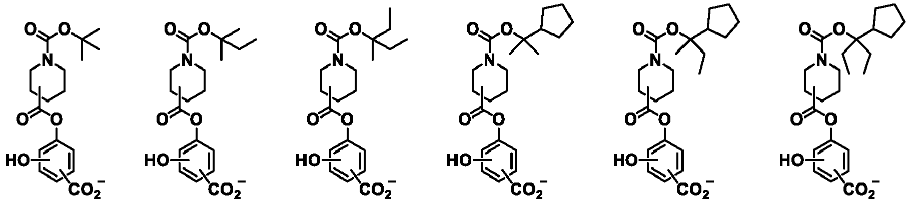

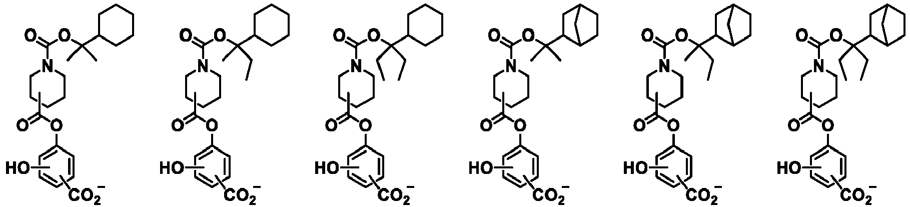

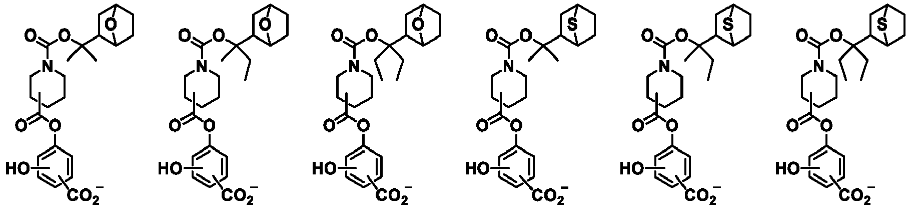

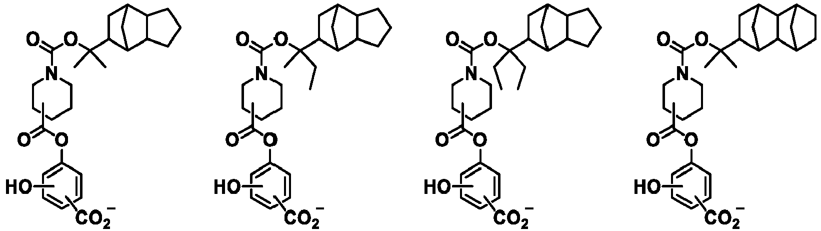

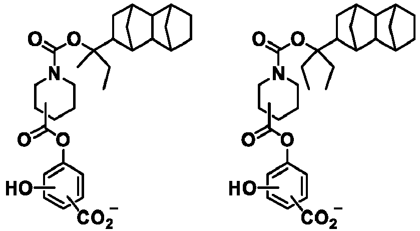

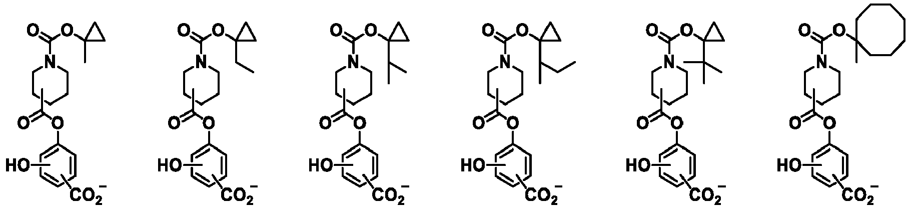

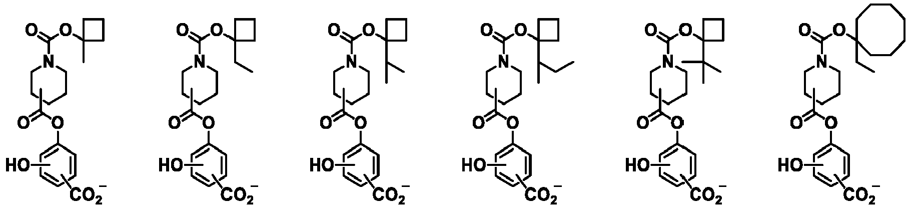

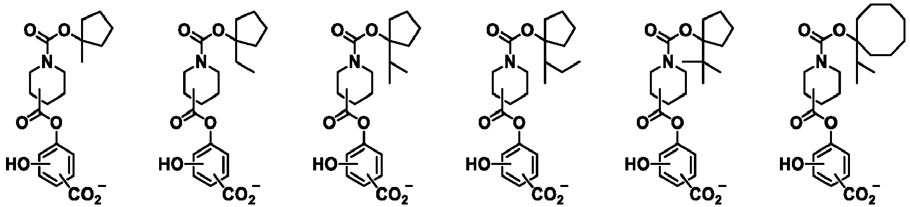

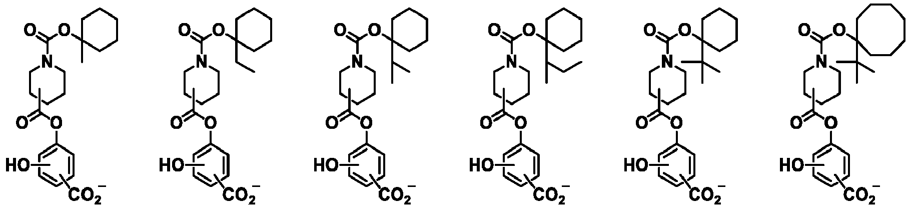

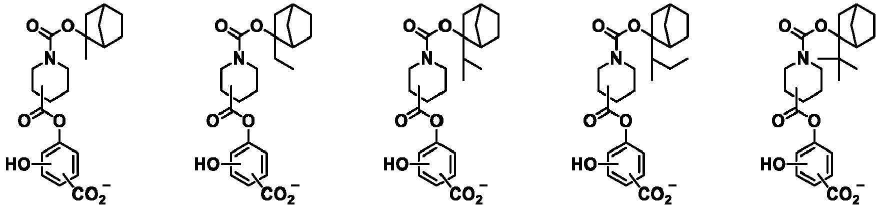

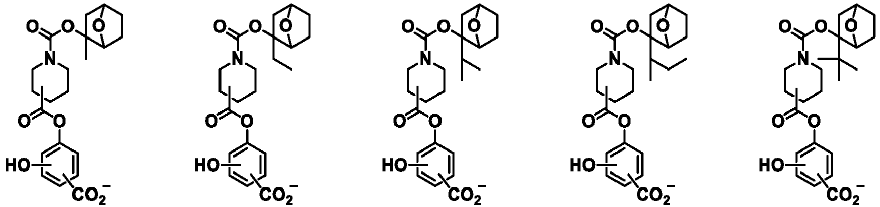

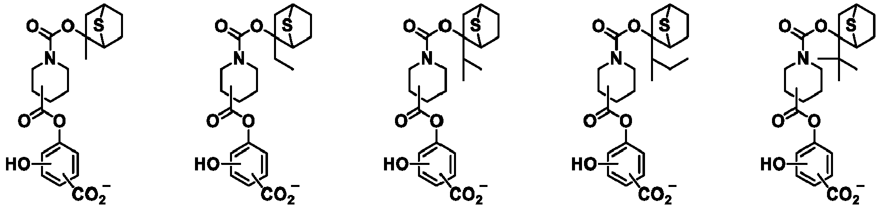

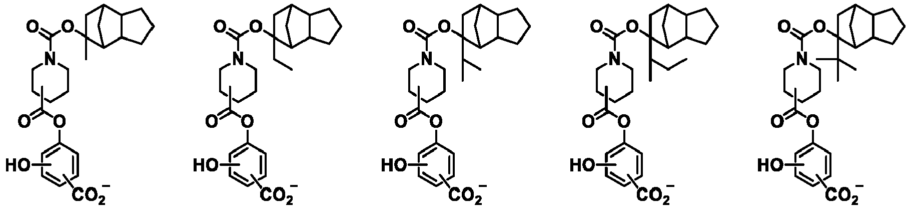

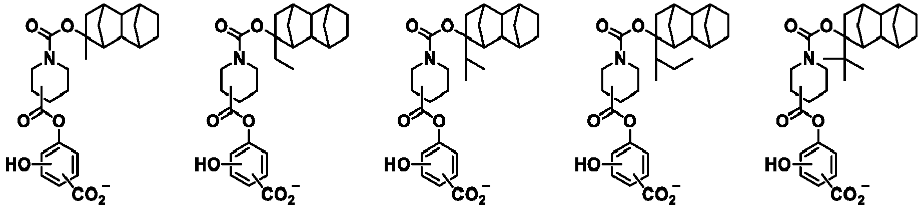

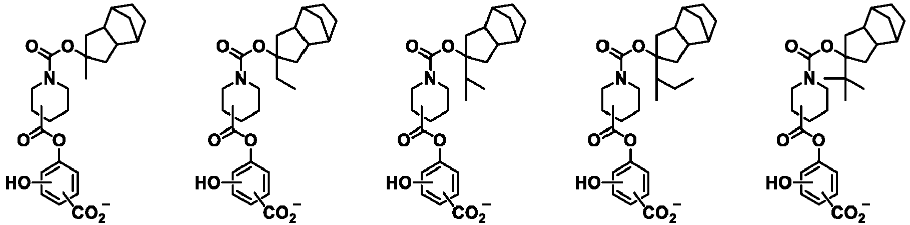

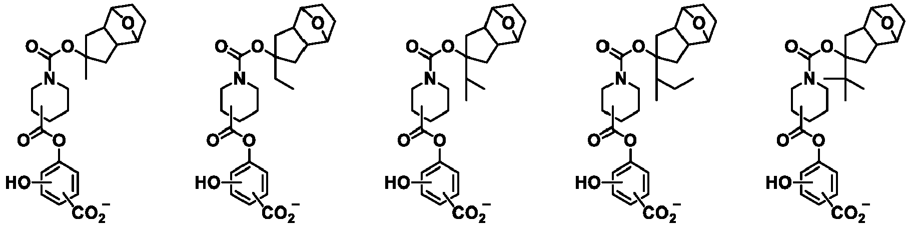

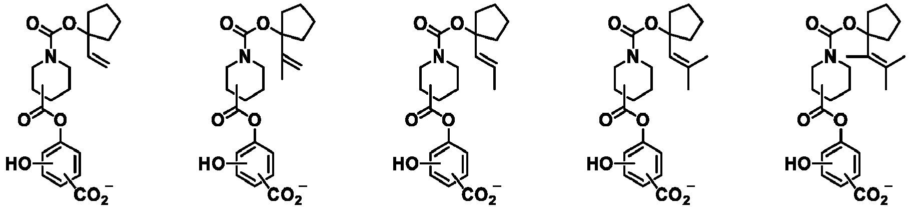

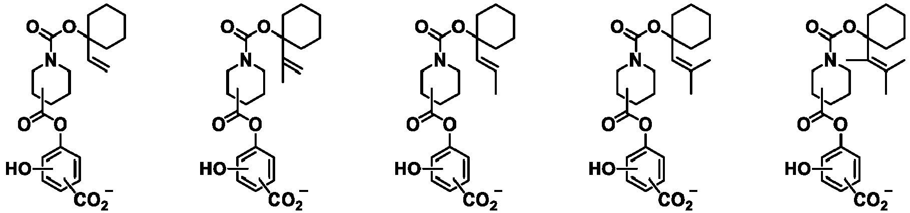

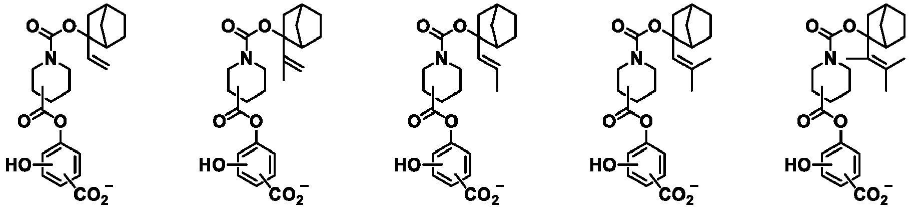

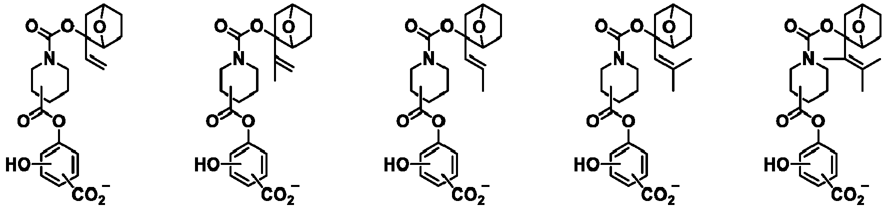

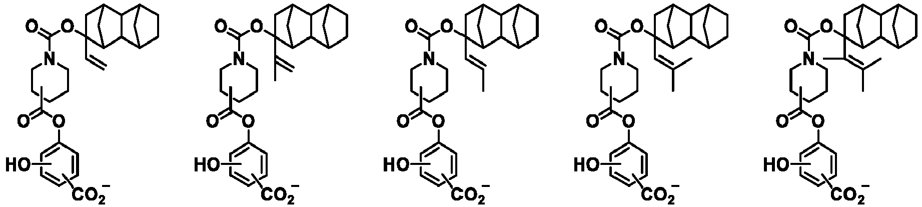

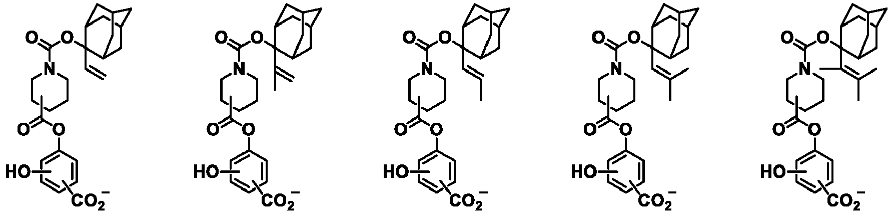

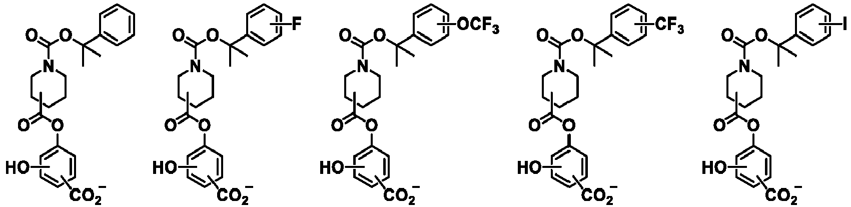

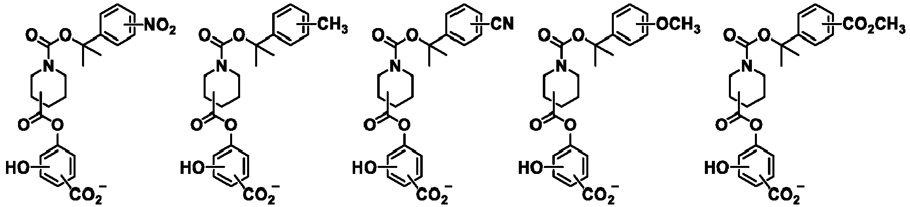

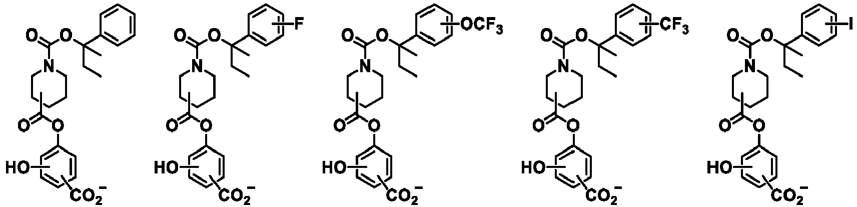

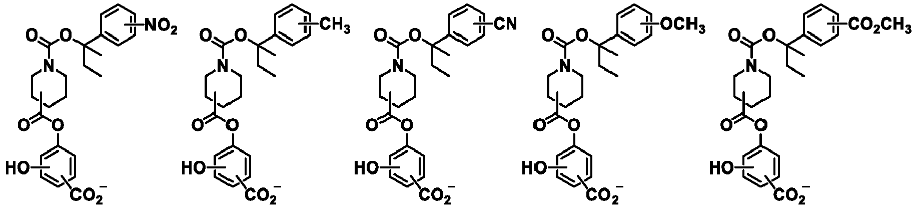

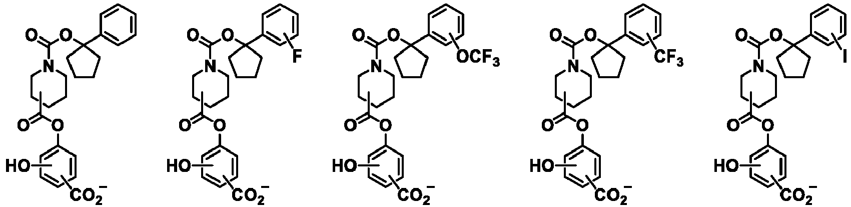

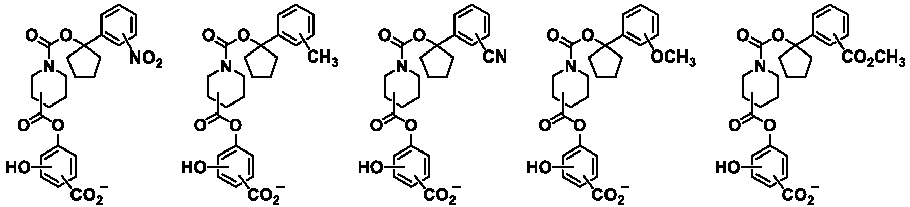

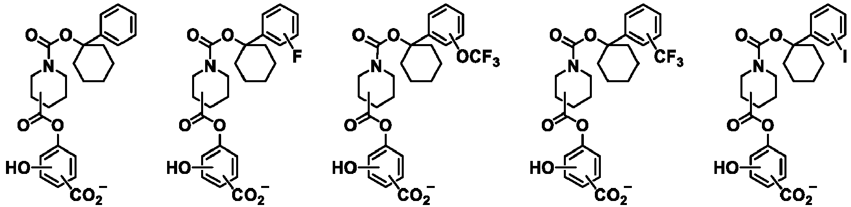

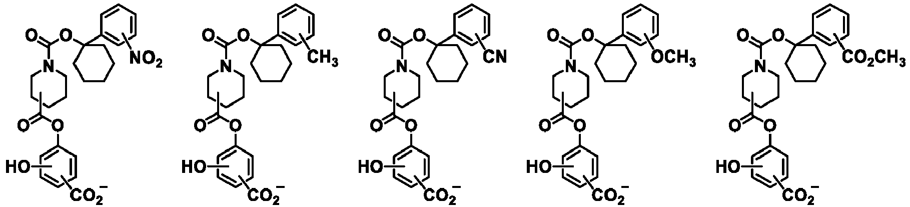

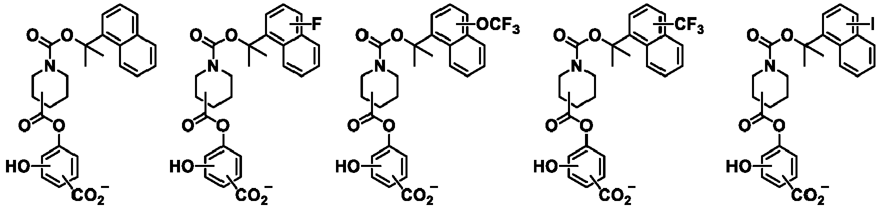

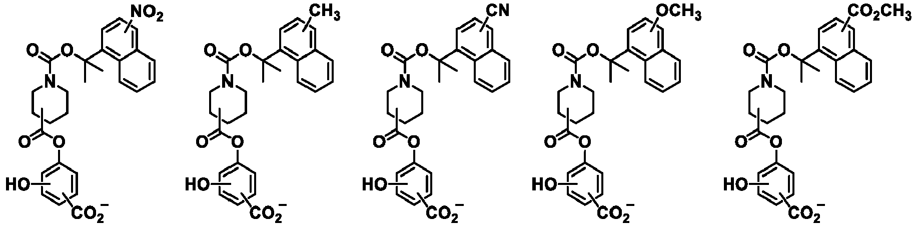

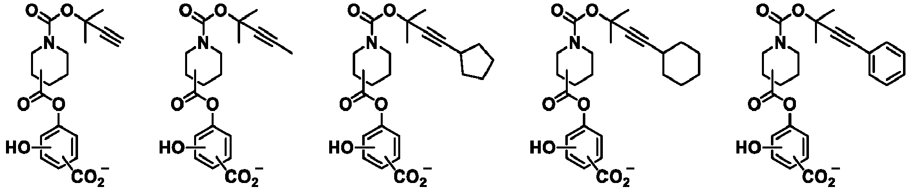

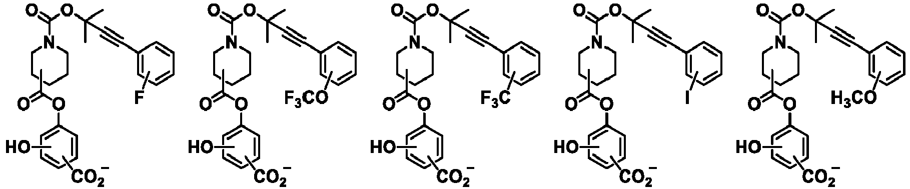

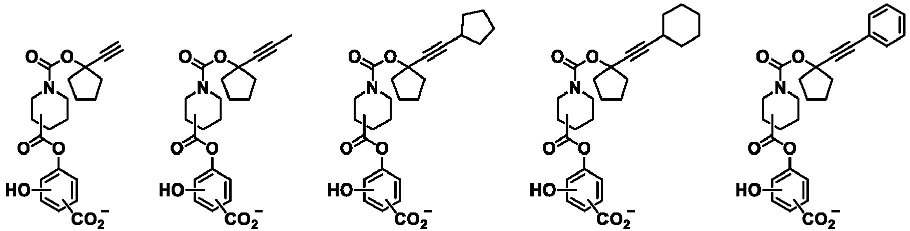

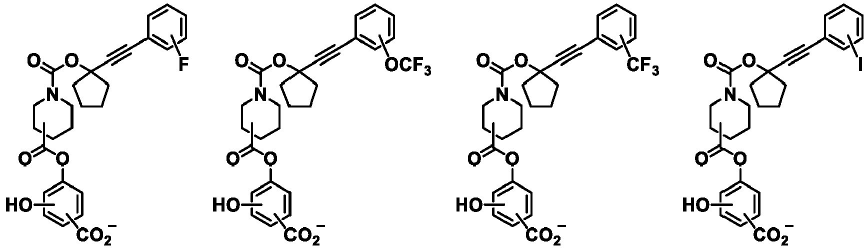

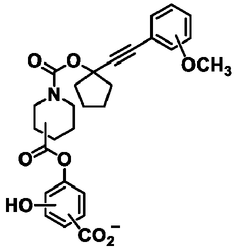

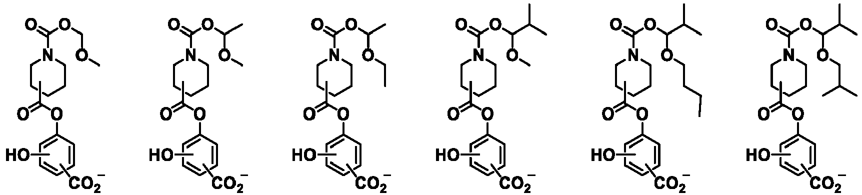

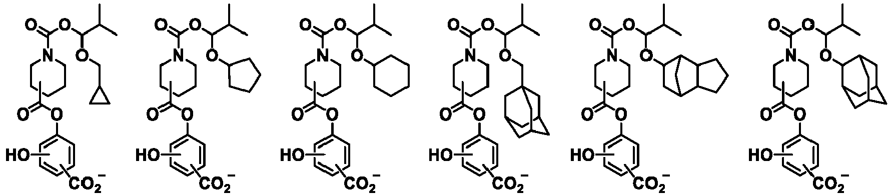

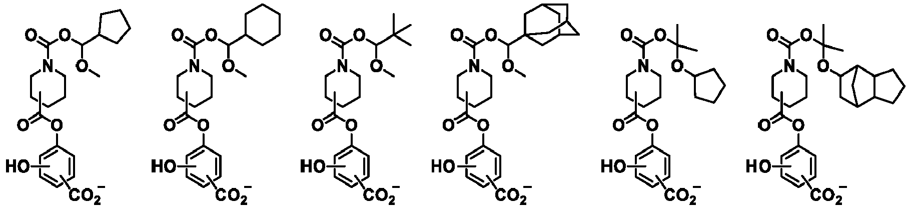

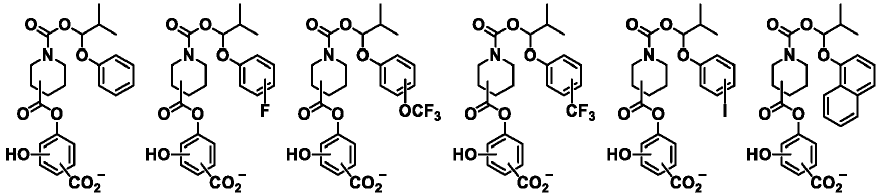

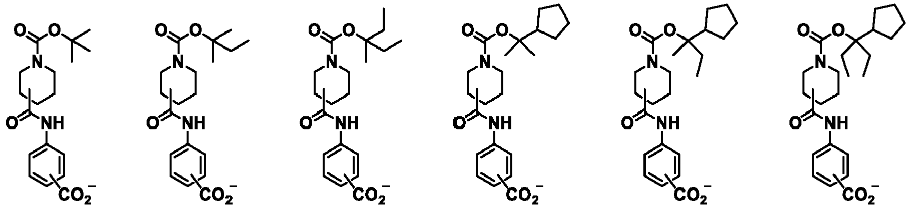

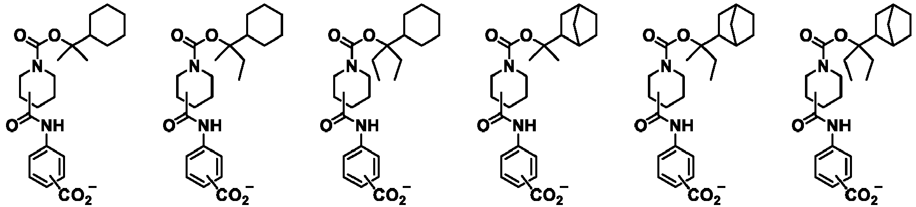

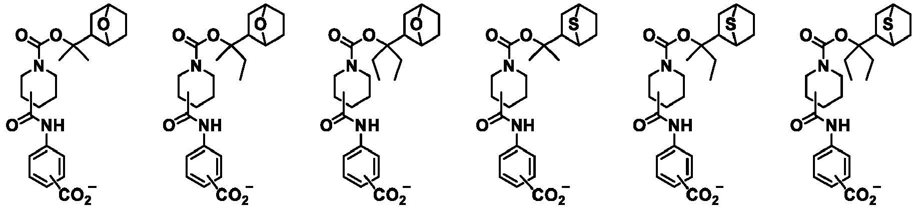

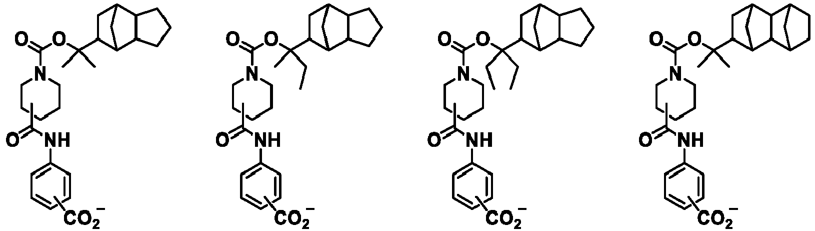

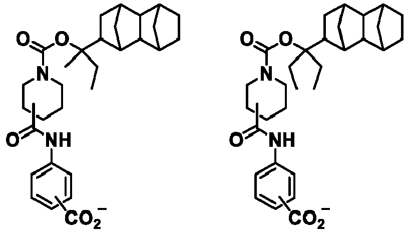

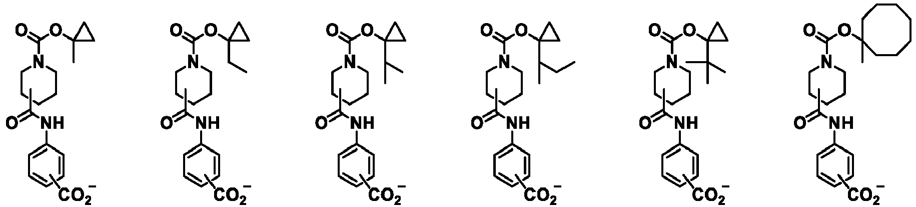

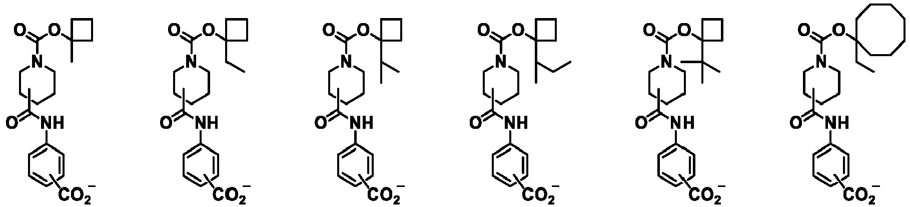

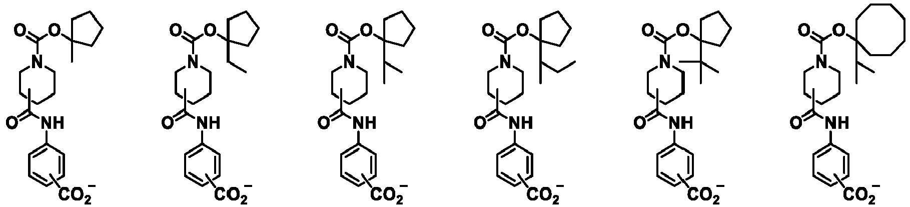

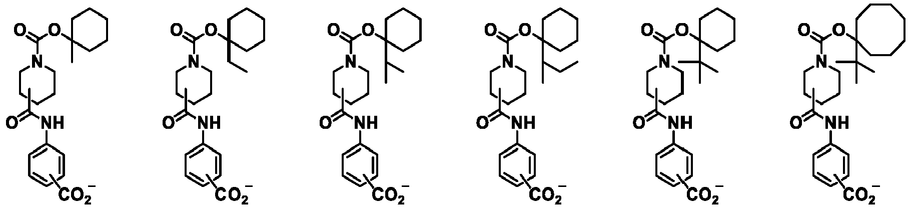

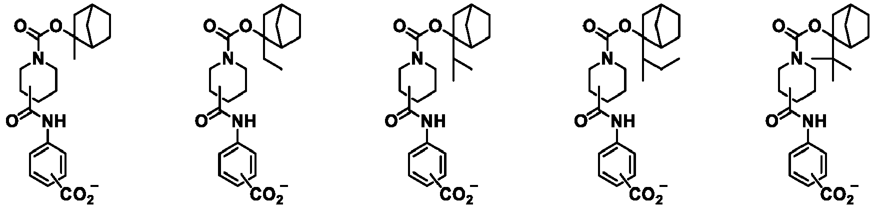

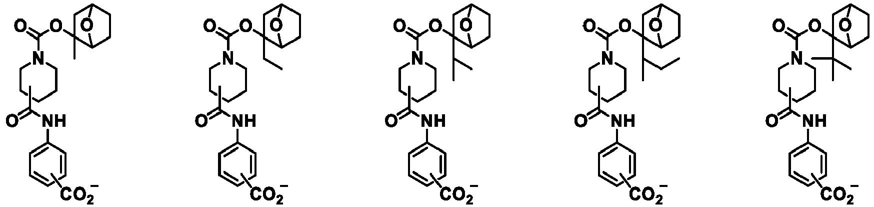

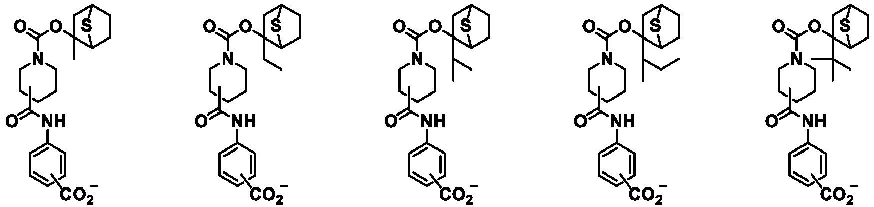

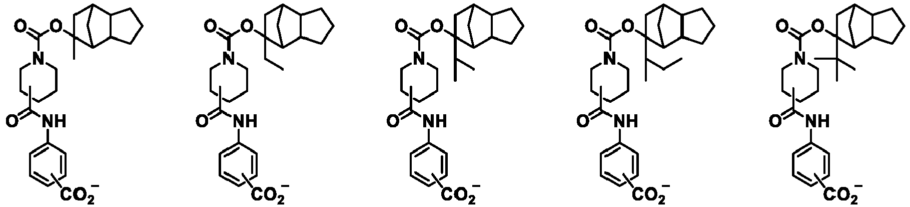

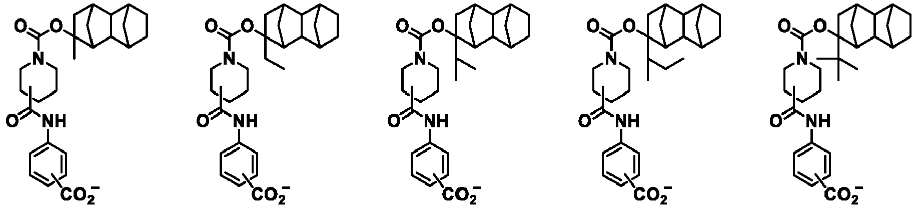

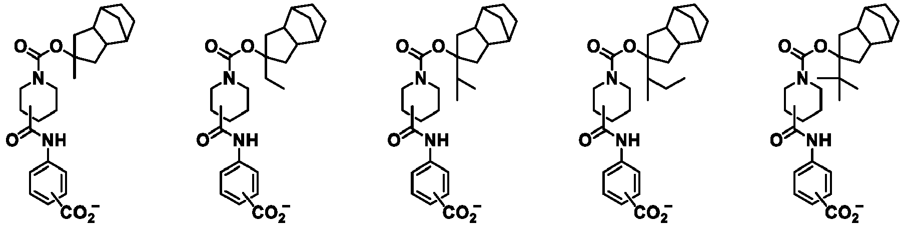

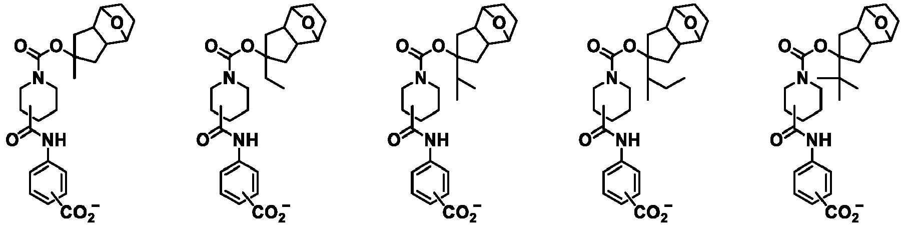

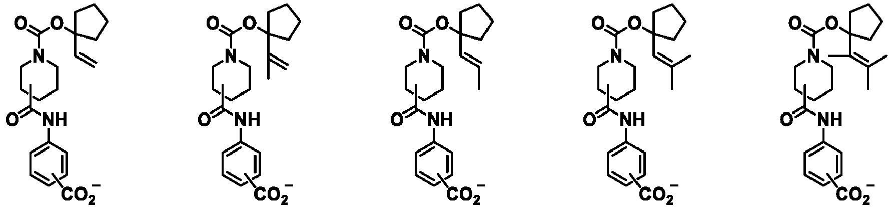

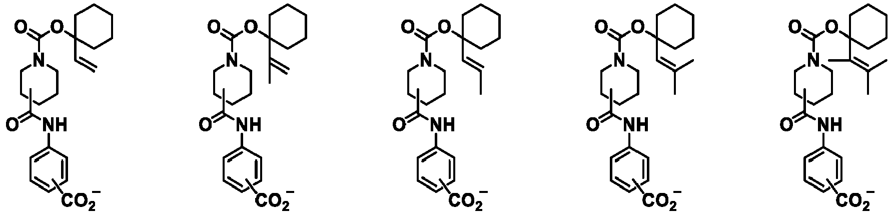

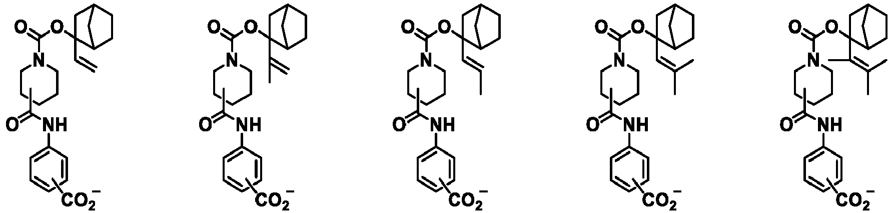

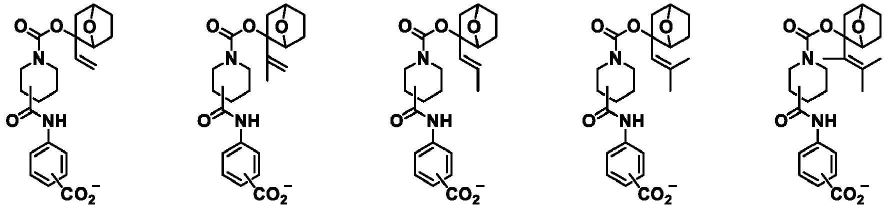

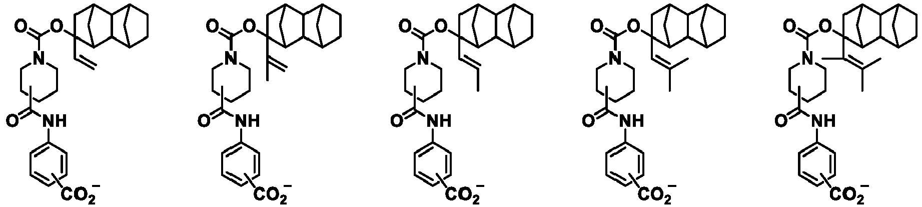

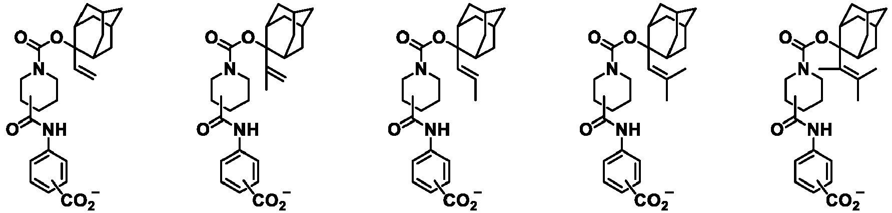

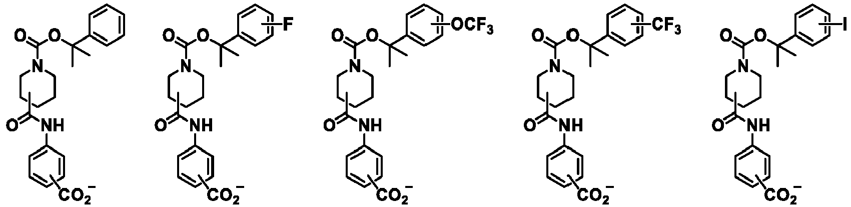

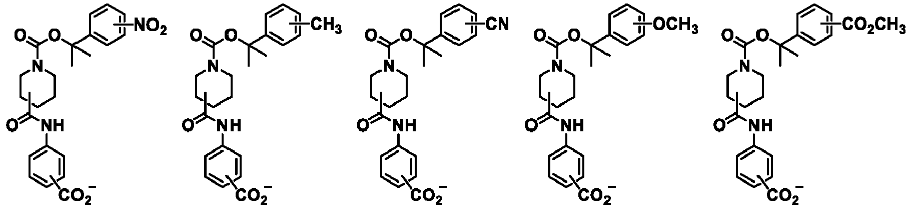

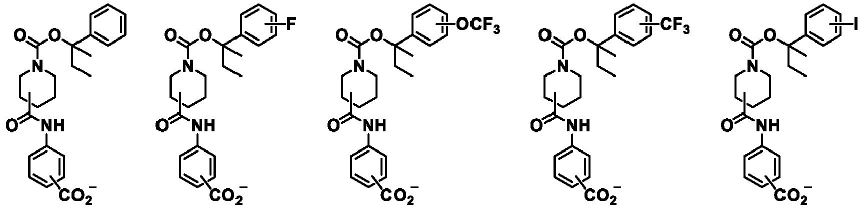

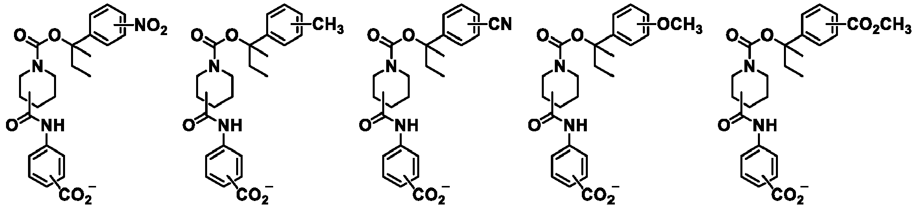

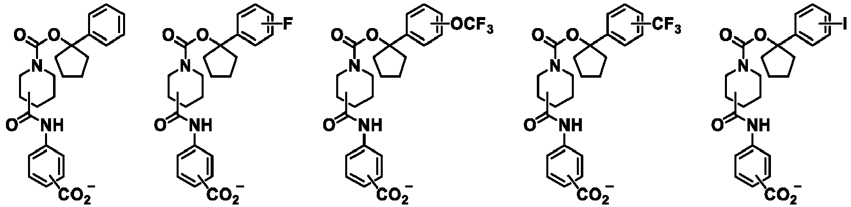

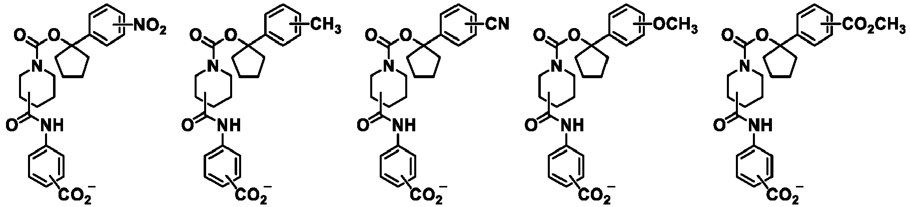

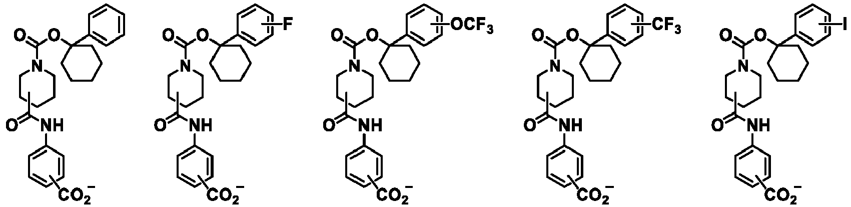

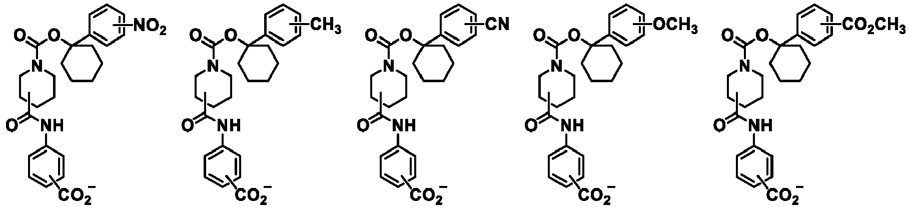

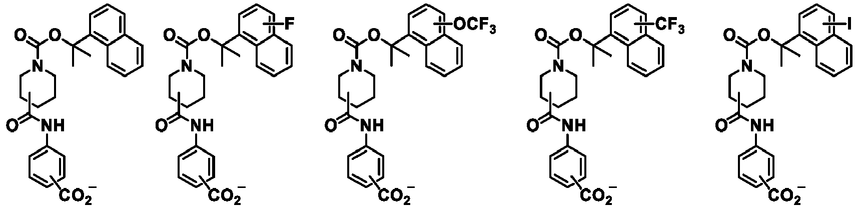

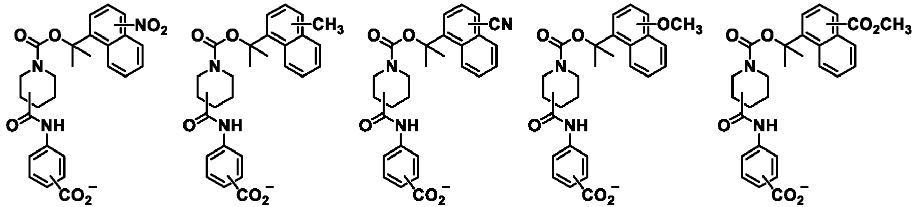

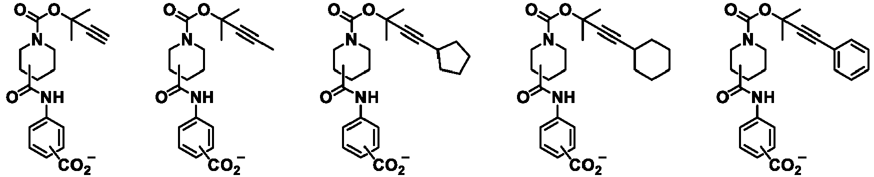

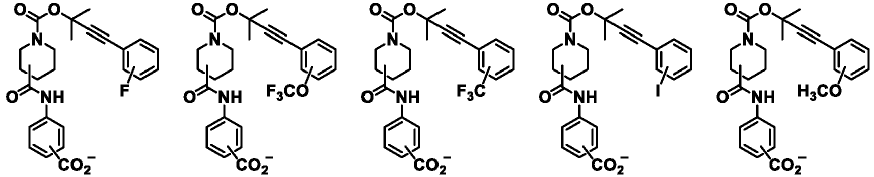

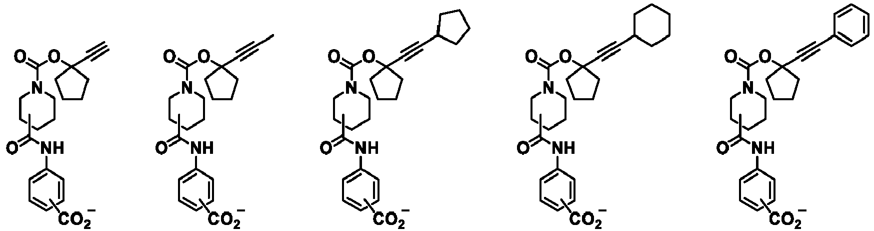

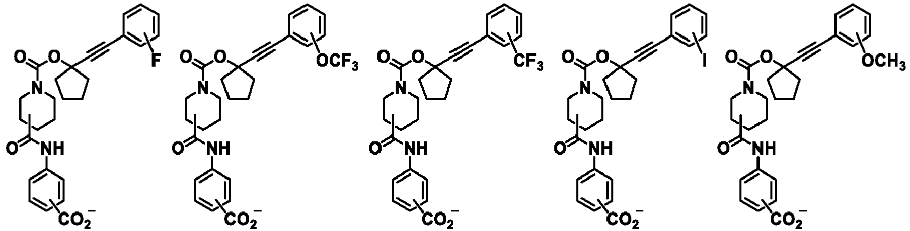

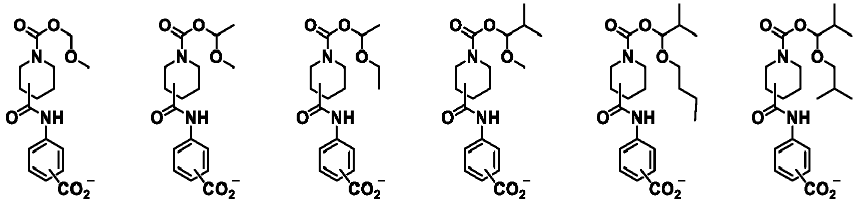

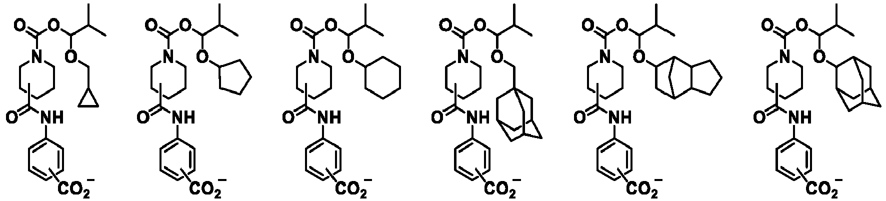

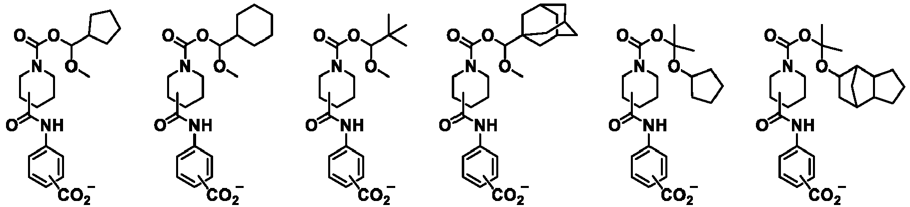

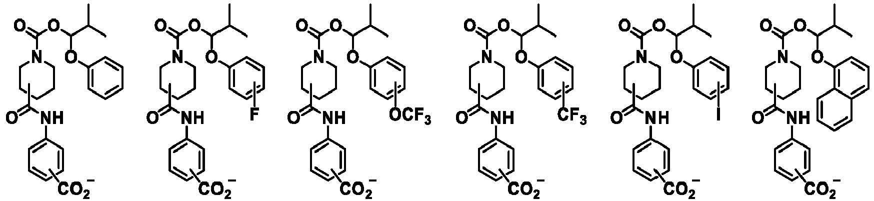

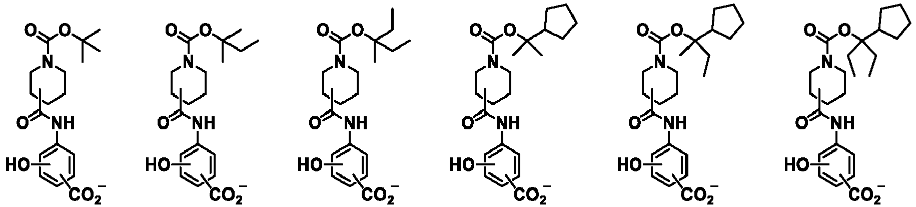

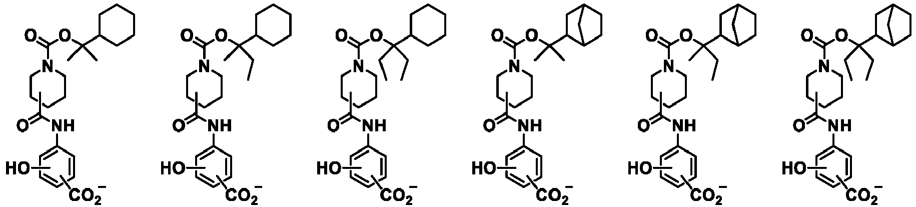

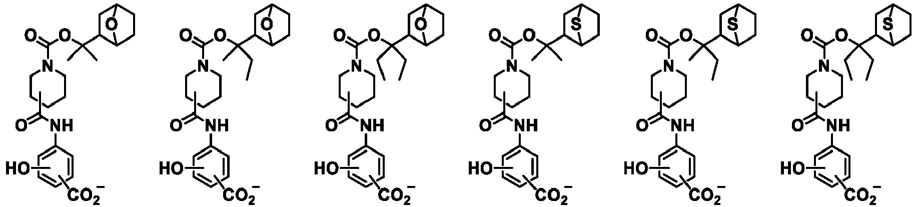

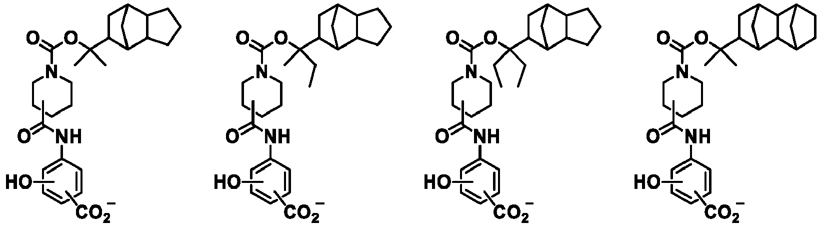

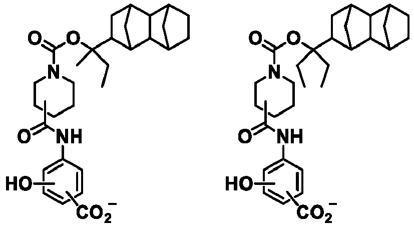

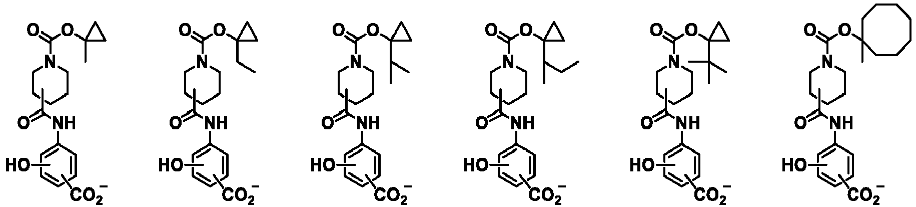

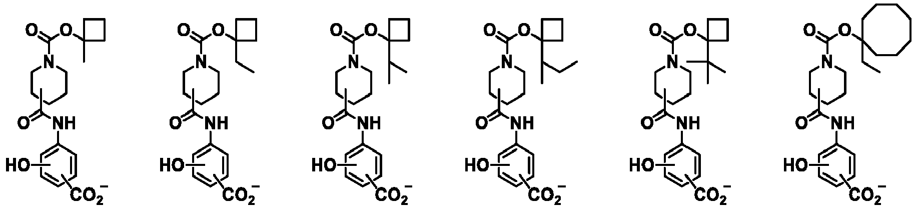

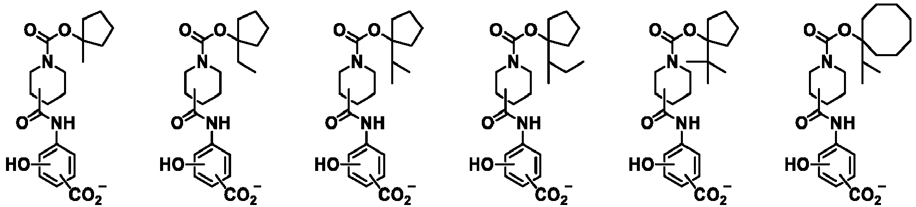

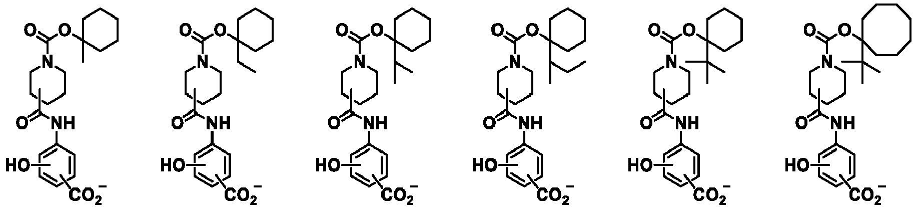

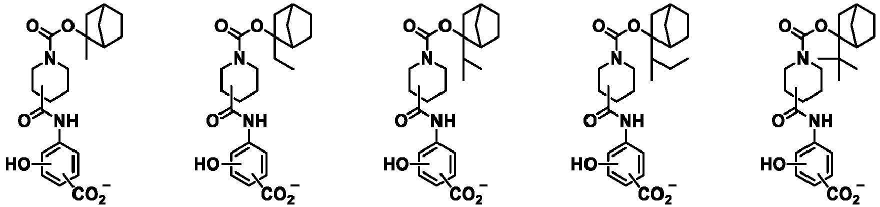

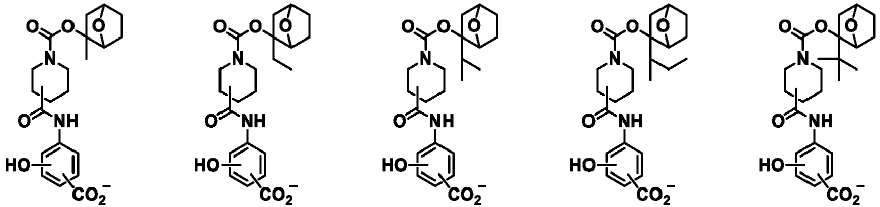

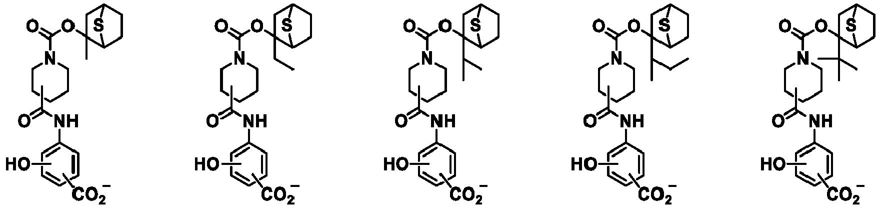

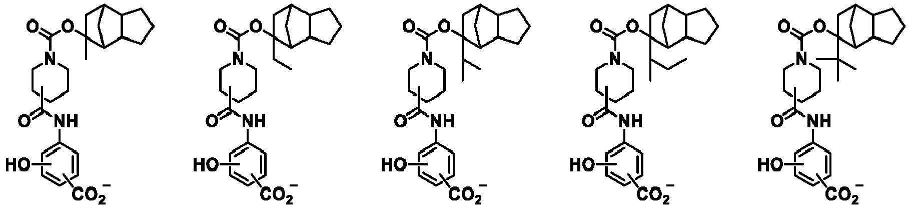

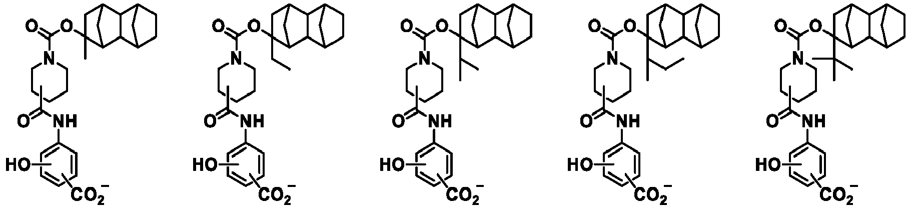

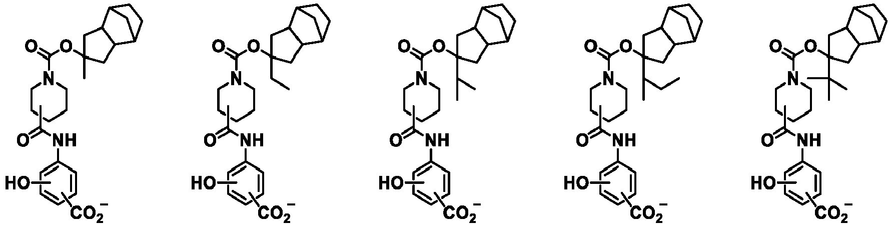

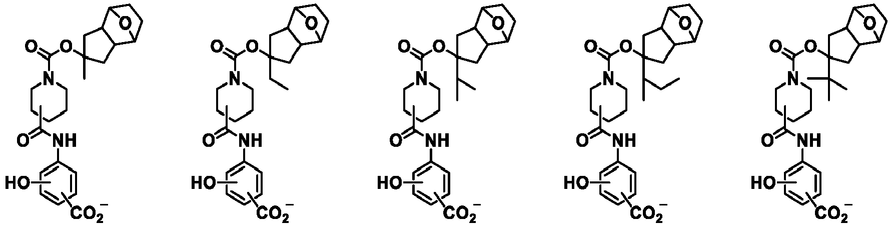

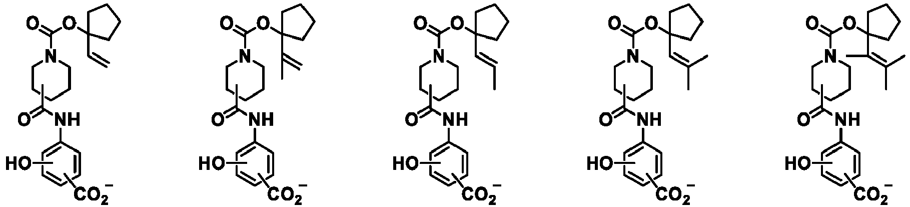

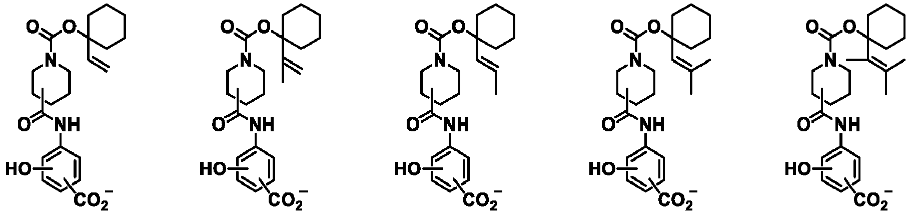

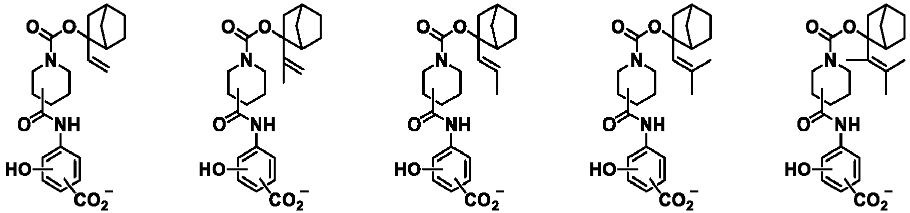

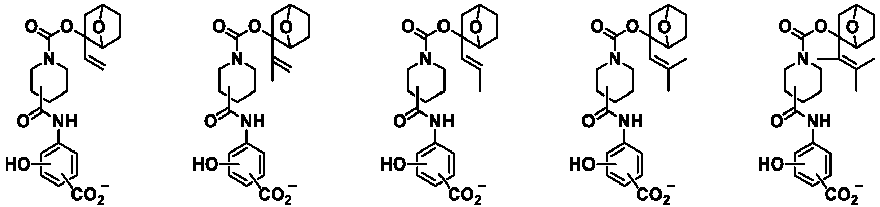

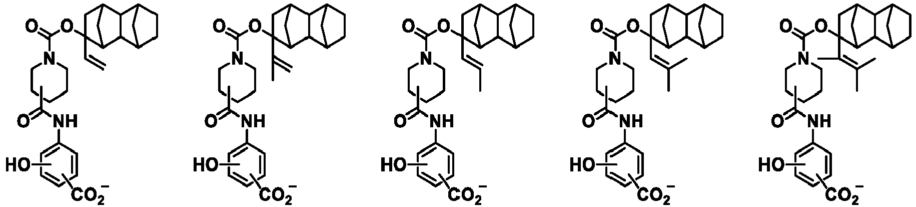

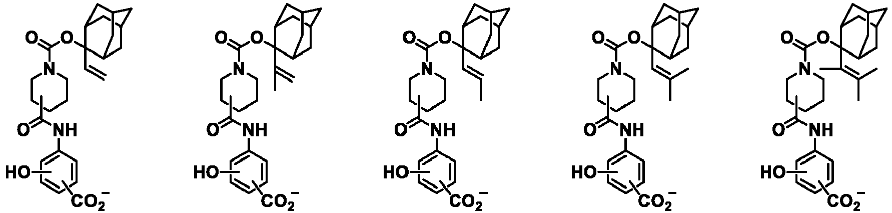

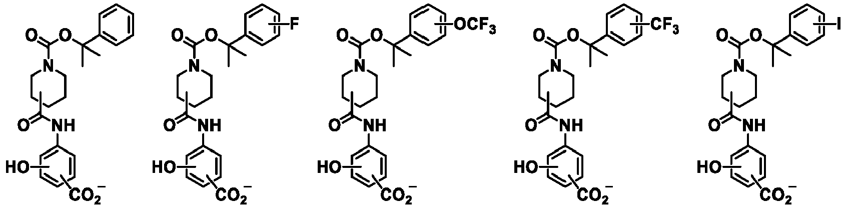

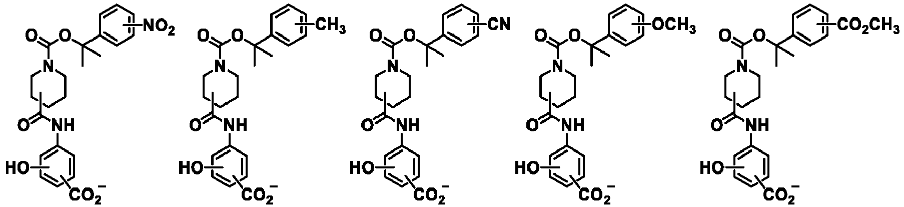

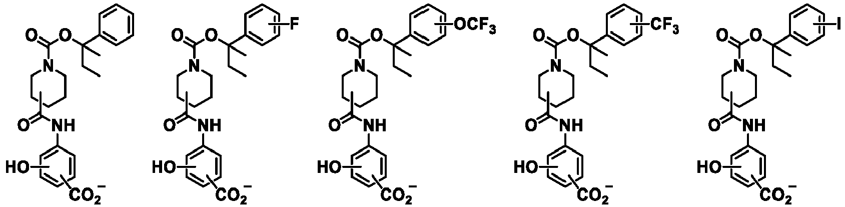

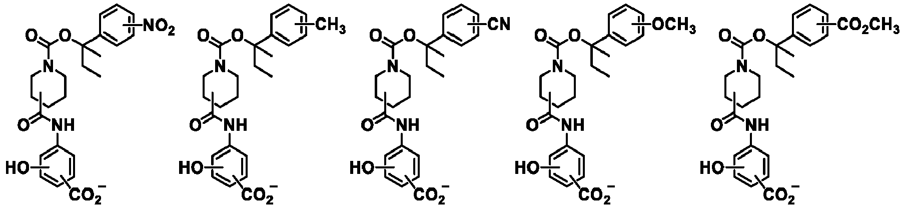

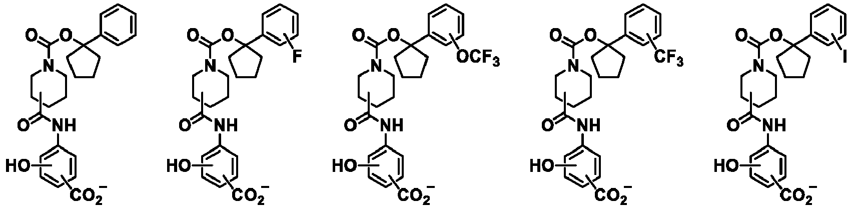

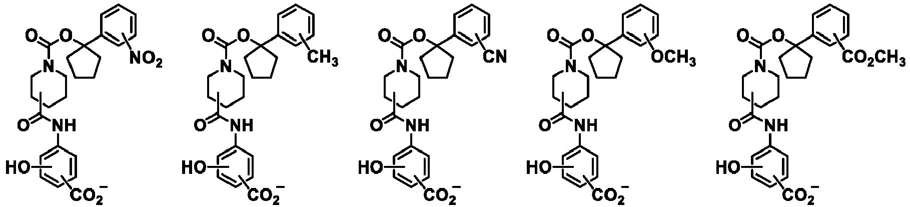

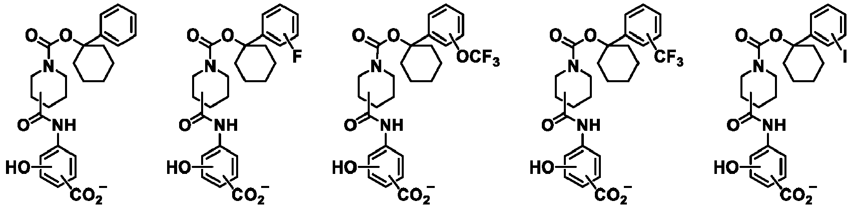

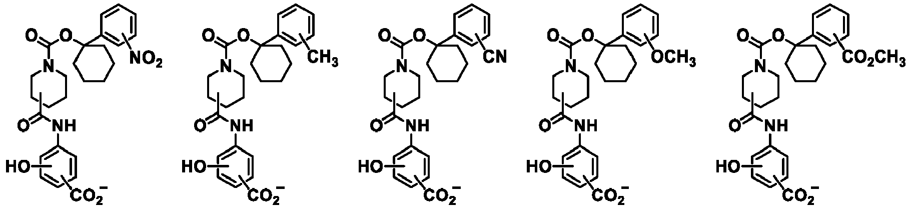

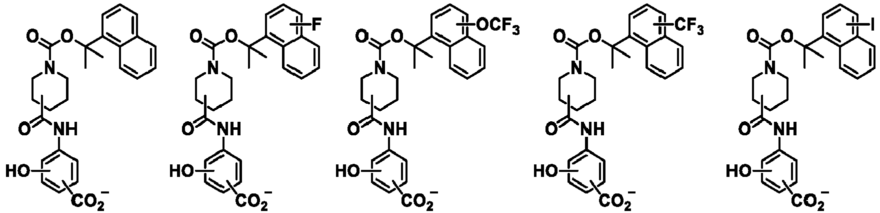

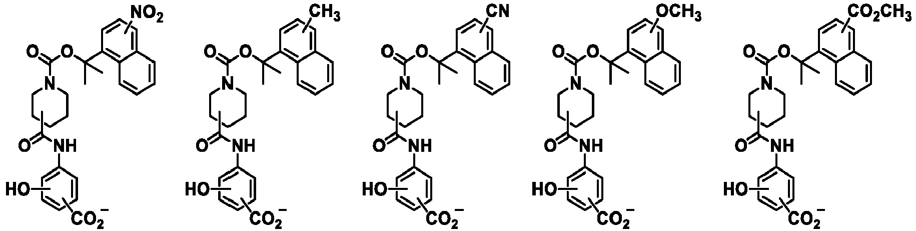

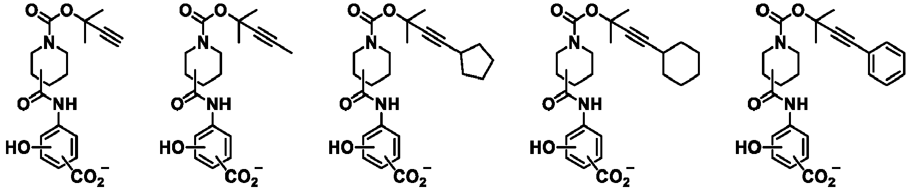

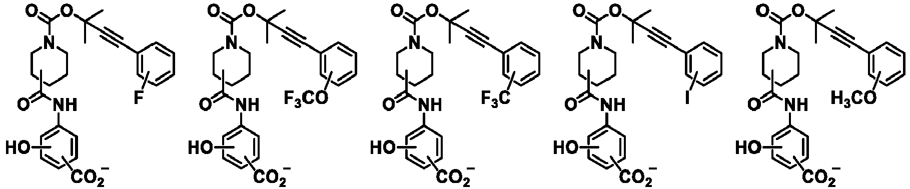

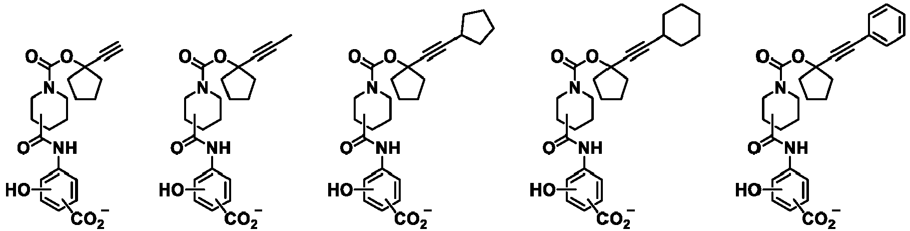

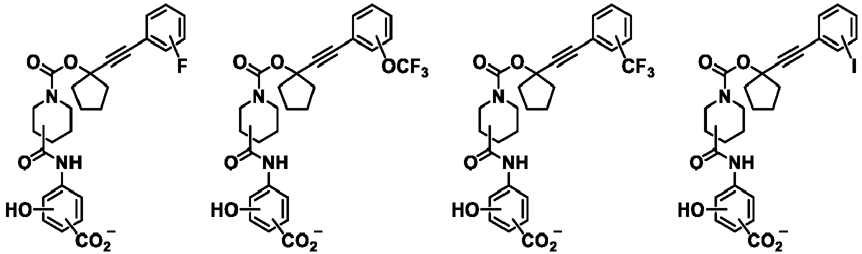

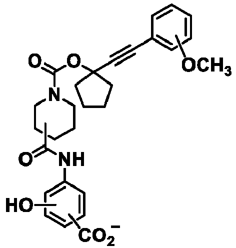

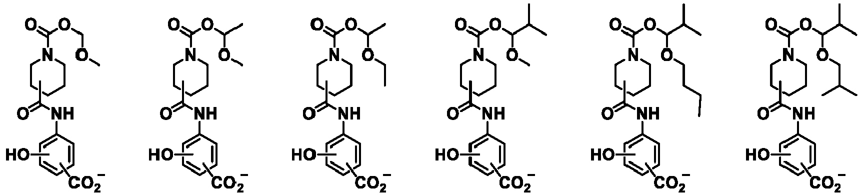

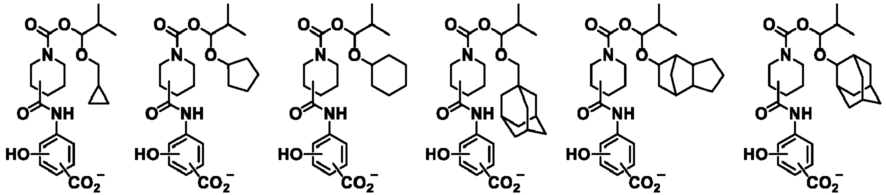

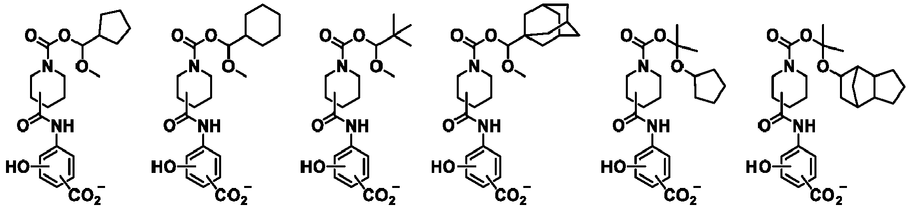

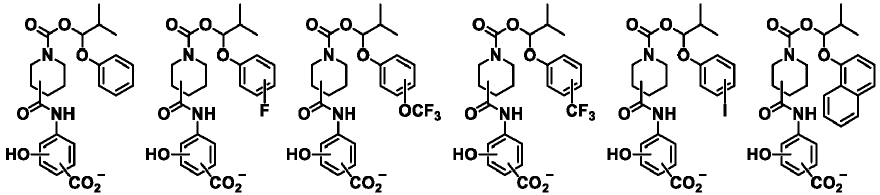

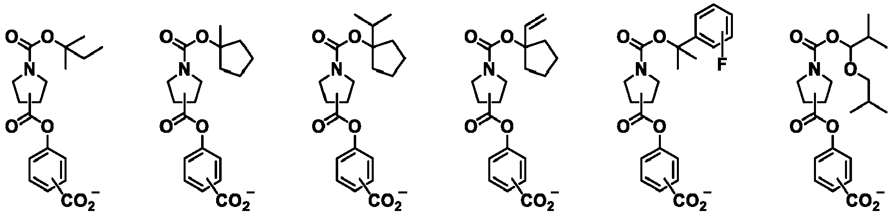

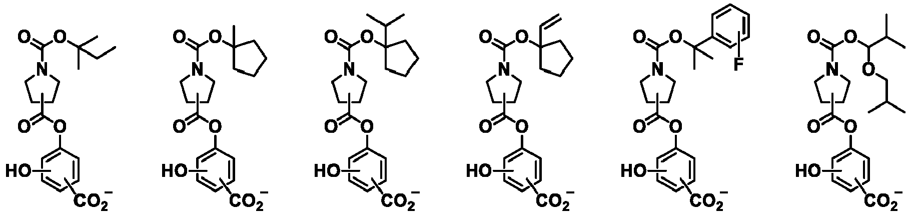

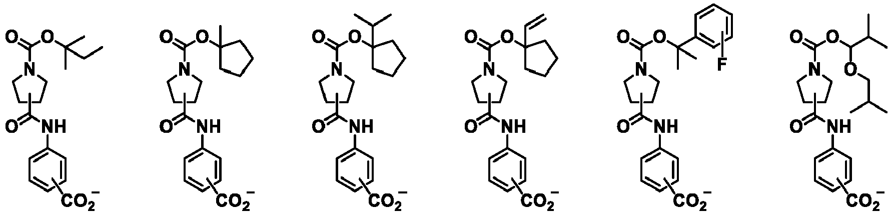

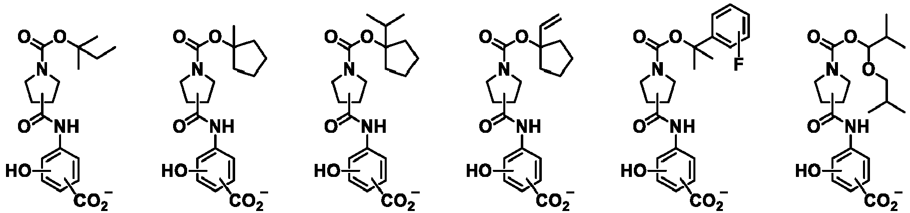

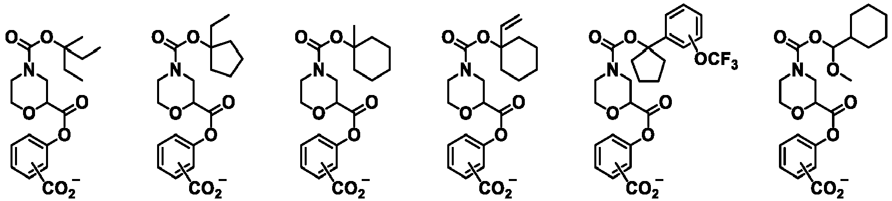

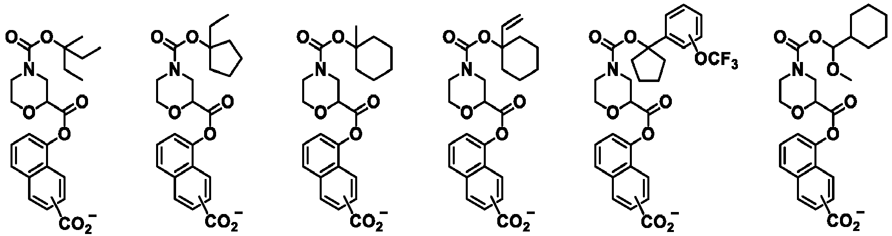

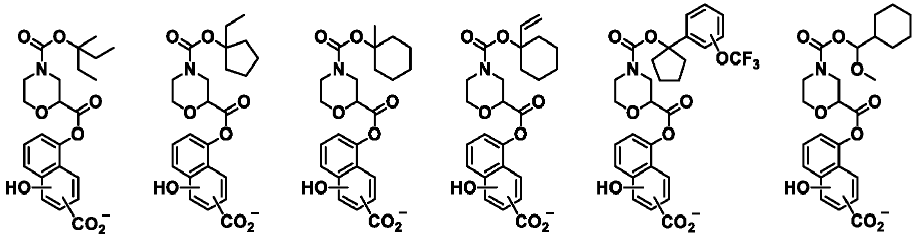

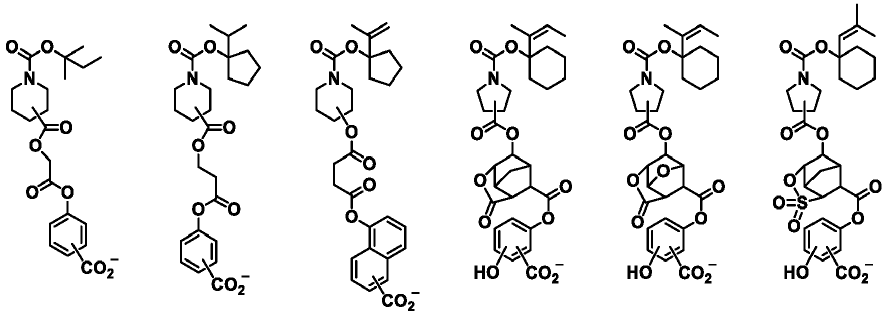

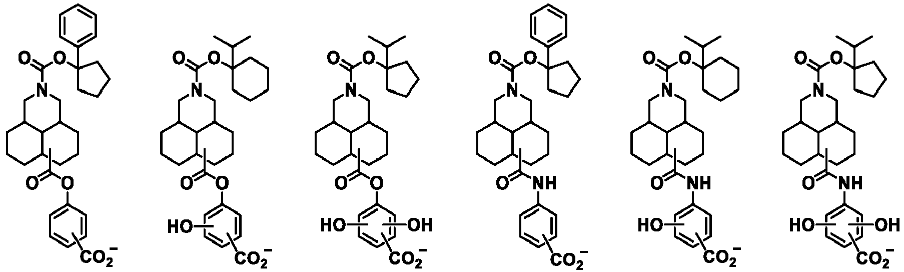

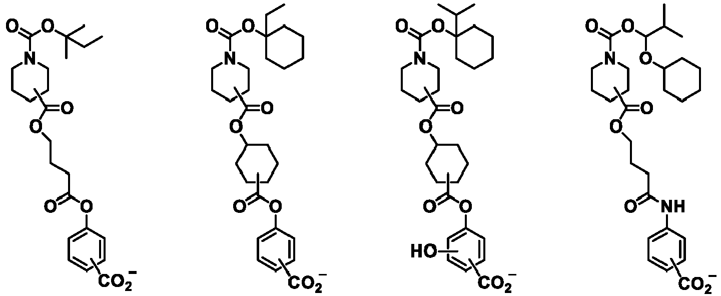

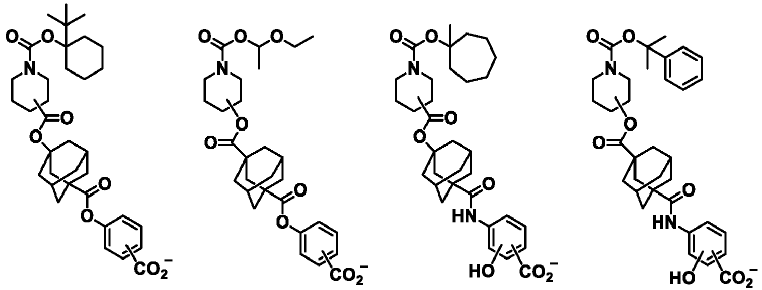

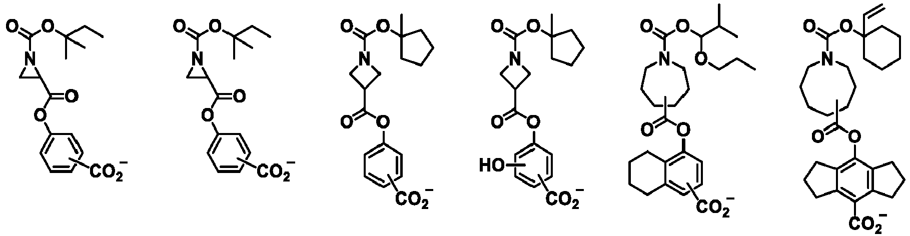

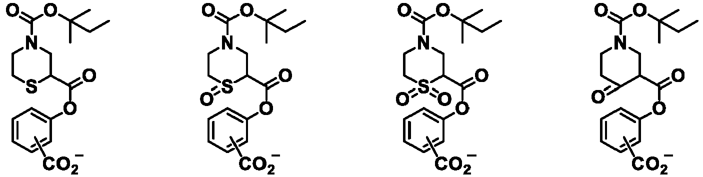

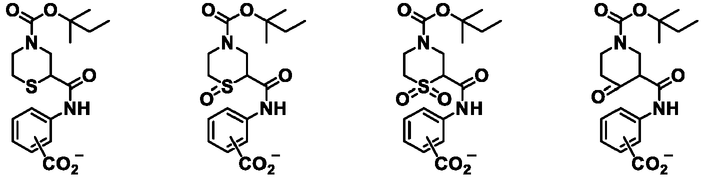

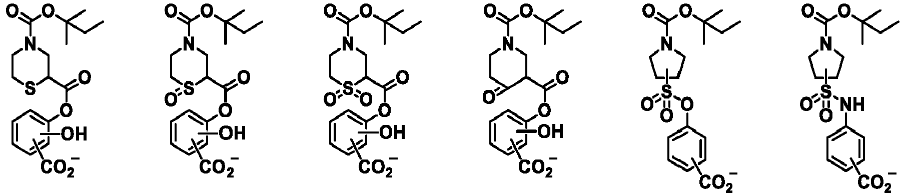

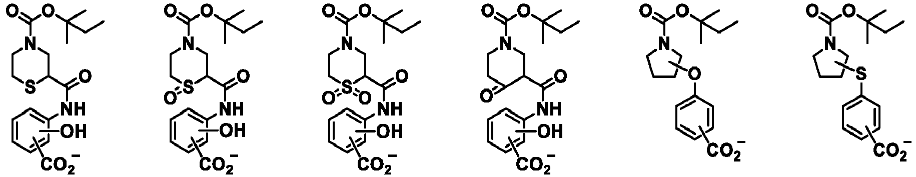

In formula (A), Z⁺ is an onium cation. Preferred are sulfonium cations having the formula (cation-1), iodonium cations having the formula (cation-2), and ammonium cations having the formula (cation-3).

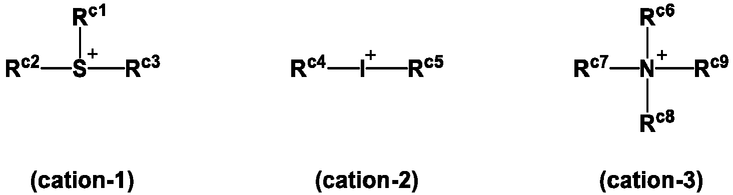

In formulae (cation-1) to (cation-3), R^{c1} to R^{c9} are each independently halogen or a C₁-C₃₀ hydrocarbyl group which may contain a heteroatom.

Suitable halogen atoms include fluorine, chlorine, bromine and iodine.

The hydrocarbyl group represented by R^{c1} to R^{c9} may be saturated or unsaturated and straight, branched or cyclic. Examples thereof include C₁-C₃₀ alkyl groups such as methyl, ethyl, n-propyl, isopropyl, n-butyl, isobutyl, sec-butyl, and tert-butyl; C₃-C₃₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₃₀ alkenyl groups such as vinyl, allyl, propenyl, butenyl, and hexenyl; C₃-C₃₀ cyclic unsaturated hydrocarbyl groups such as cyclohexenyl; C₆-C₃₀ aryl groups such as phenyl, naphthyl and thienyl; C₇-C₃₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

Also, R^{c1} and R^{c2} may bond together to form a ring with the sulfur atom to which they are attached. Examples of the sulfonium cation having formula (cation-1) wherein R^{c1} and R^{c2} form a ring are shown below.

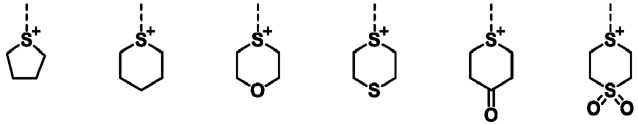

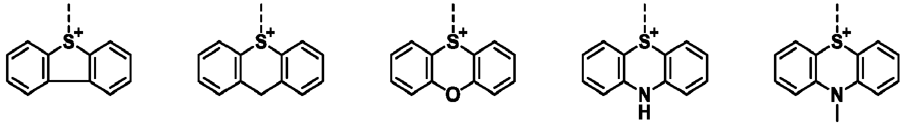

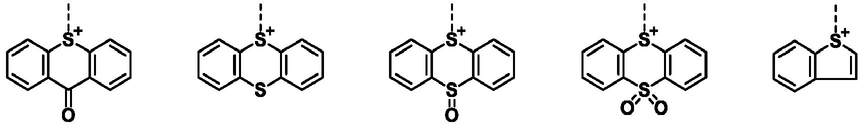

Herein the broken line designates a point of attachment to R^{c3}.

Examples of the sulfonium cation having formula (cation-1) are shown below, but not limited thereto.

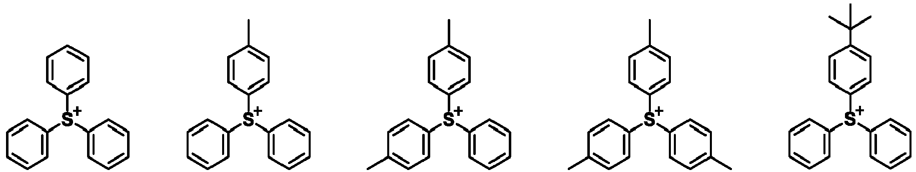

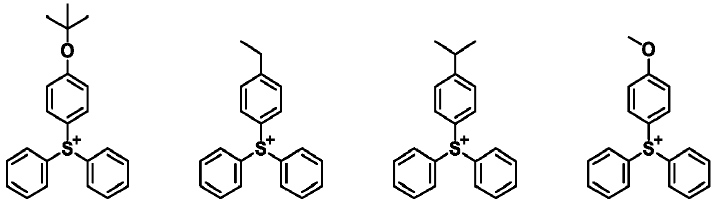

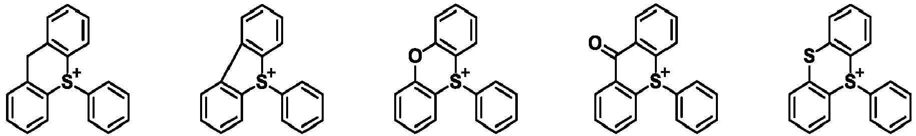

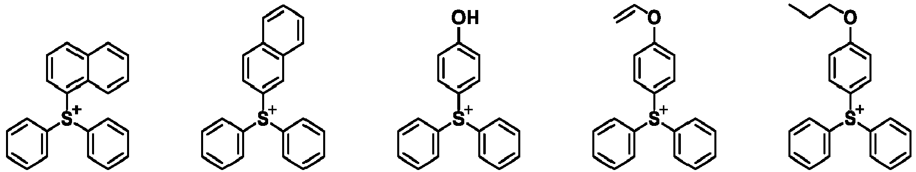

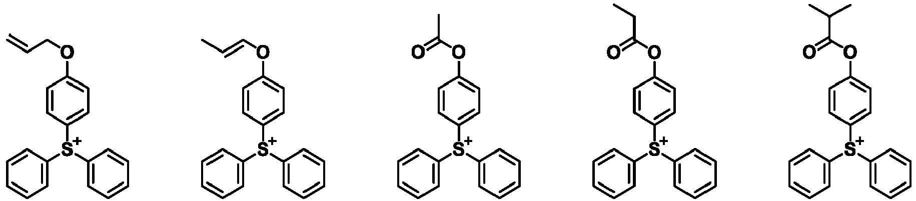

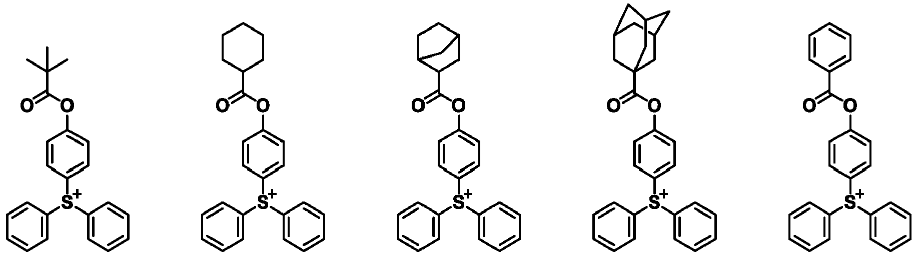

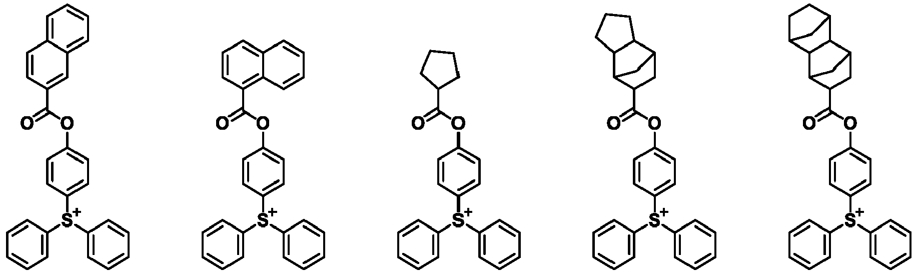

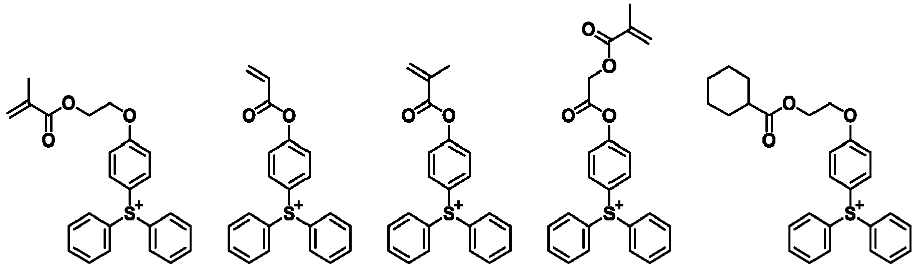

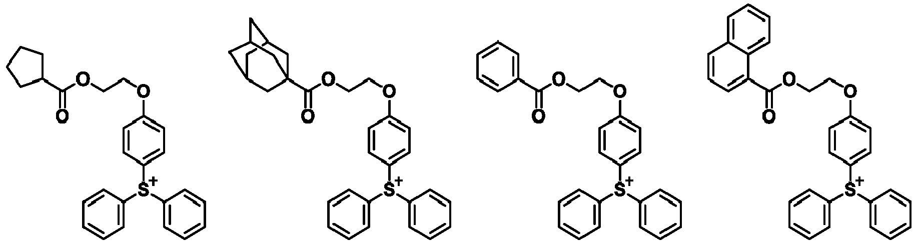

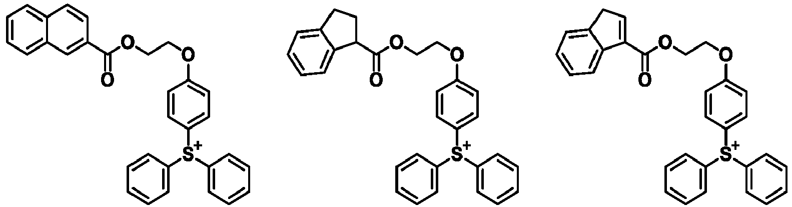

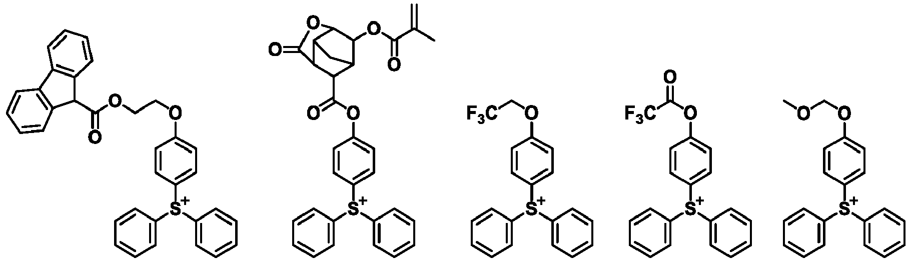

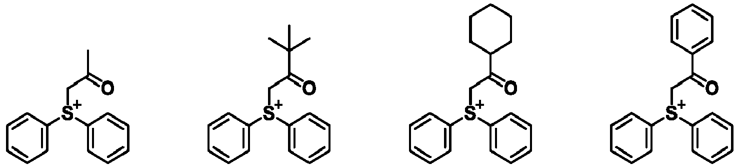

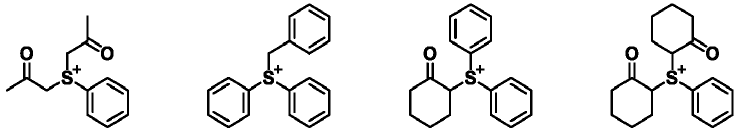

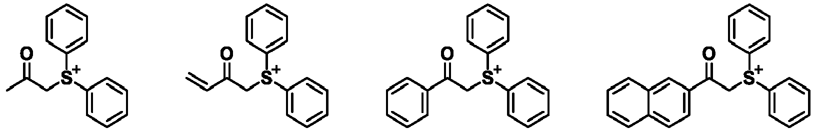

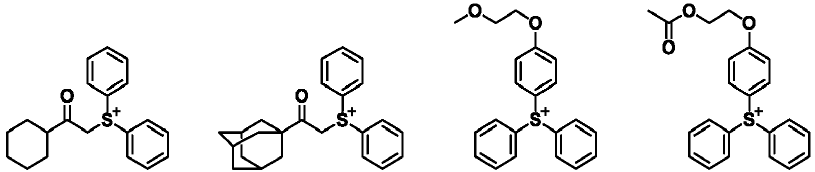

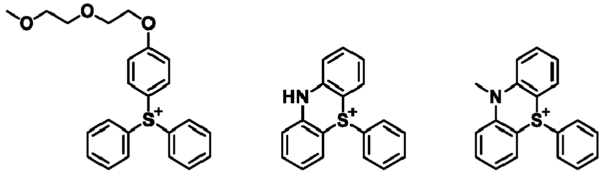

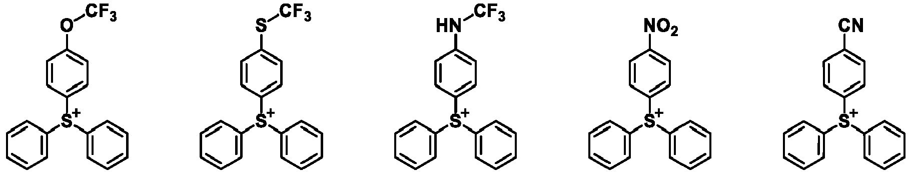

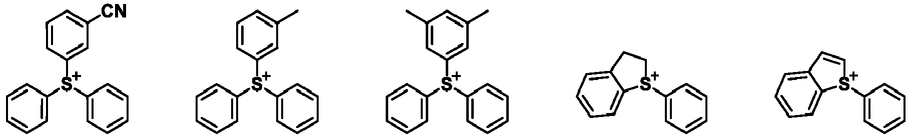

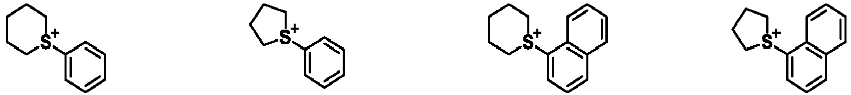

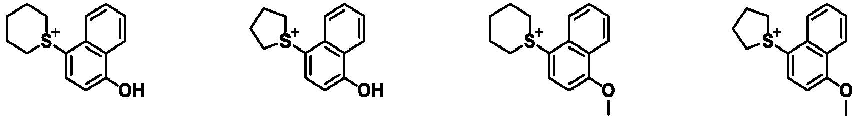

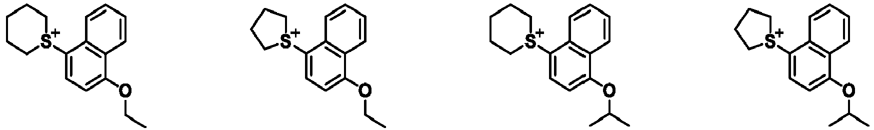

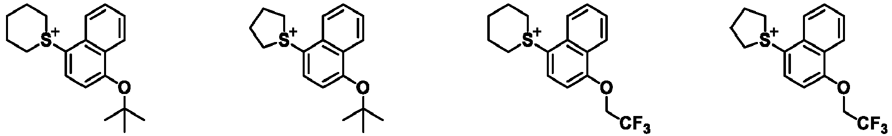

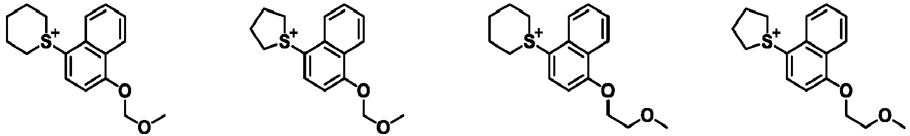

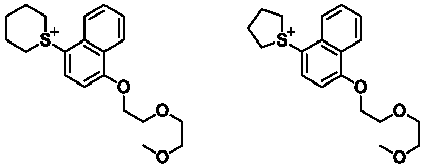

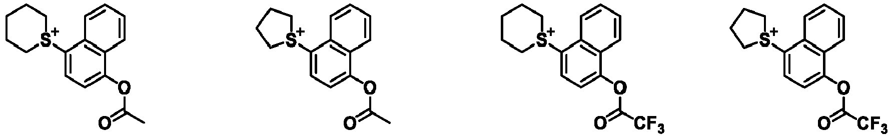

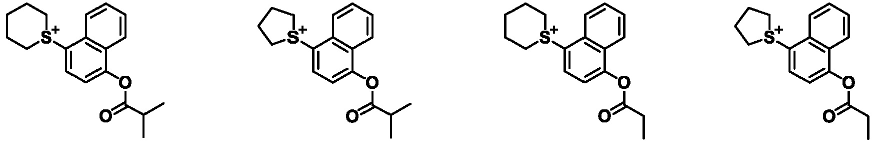

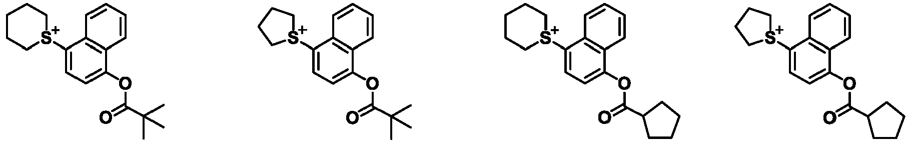

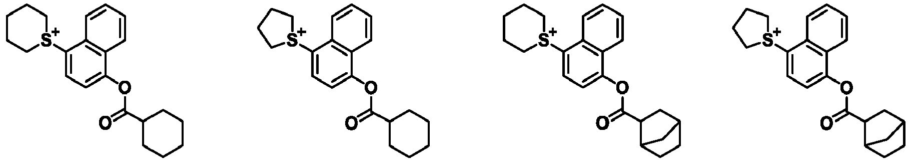

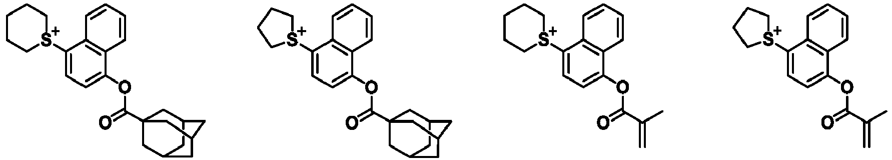

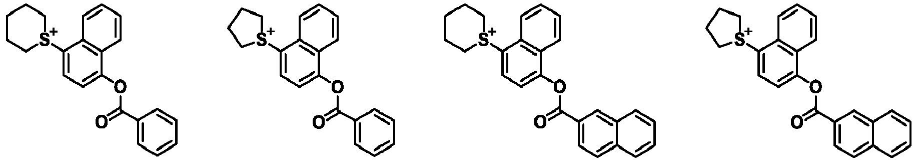

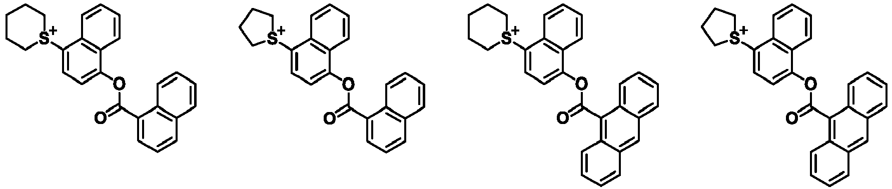

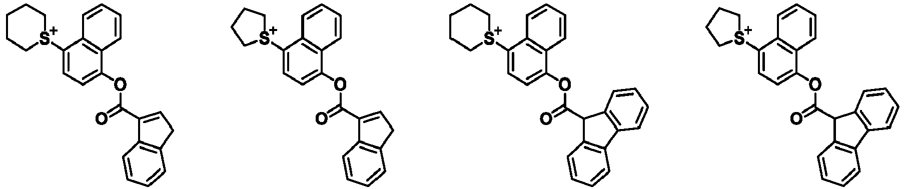

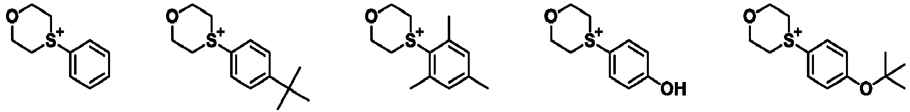

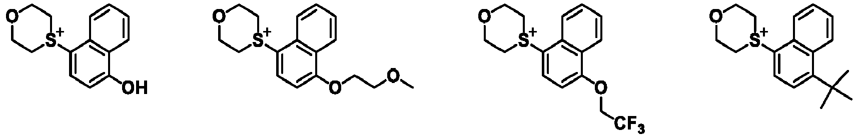

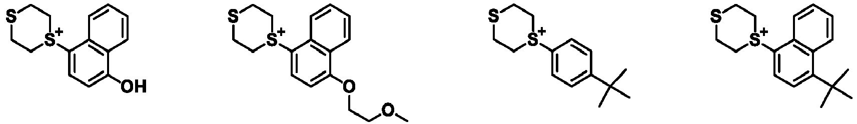

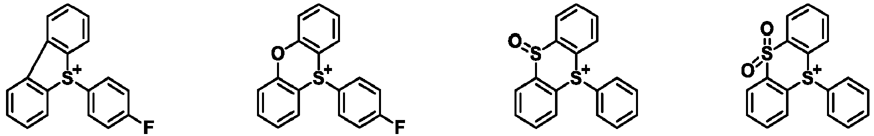

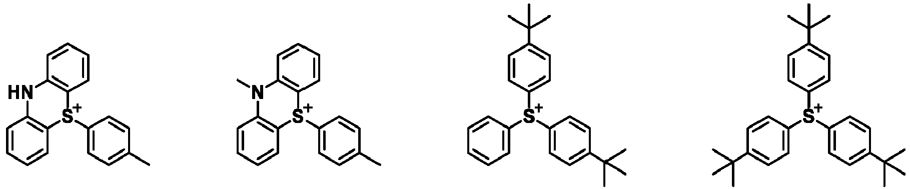

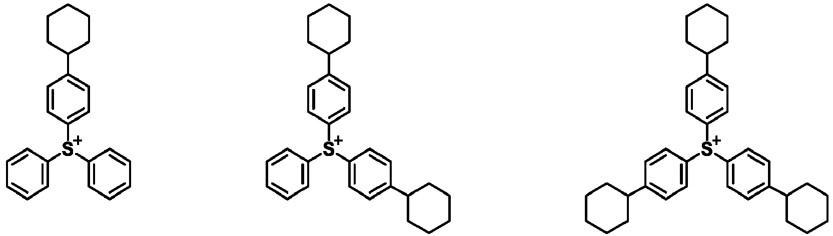

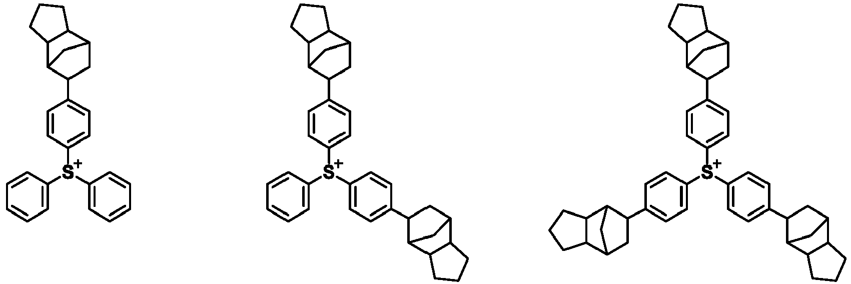

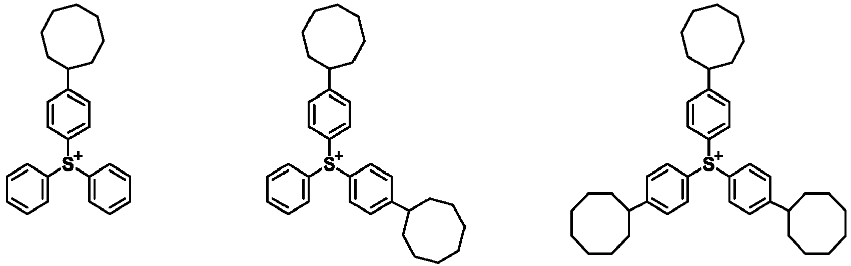

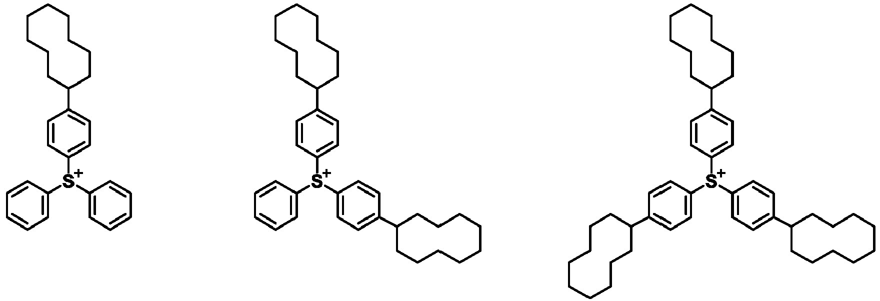

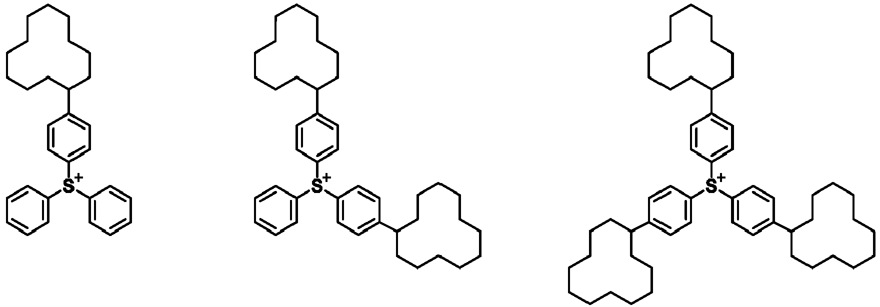

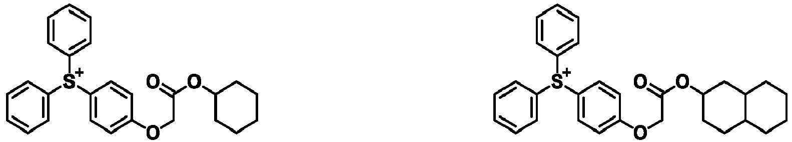

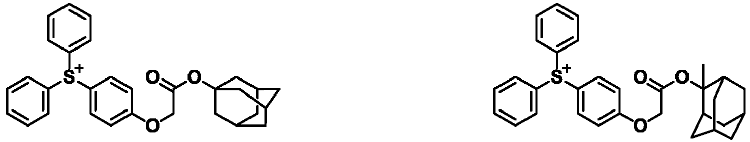

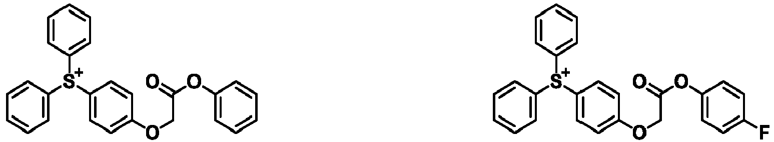

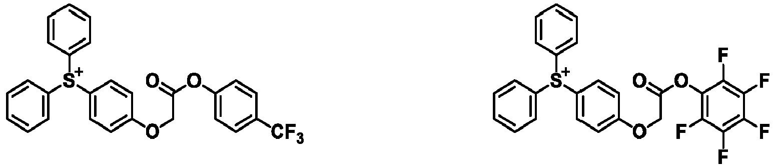

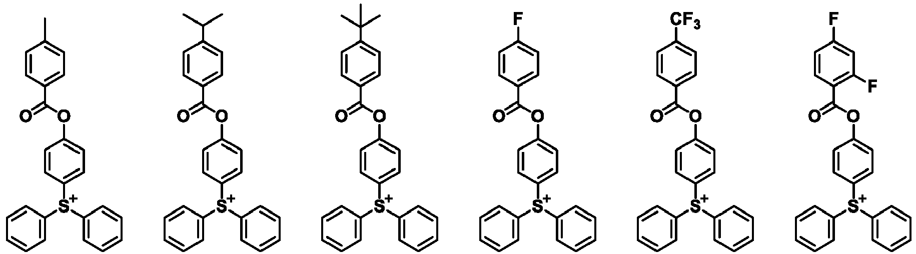

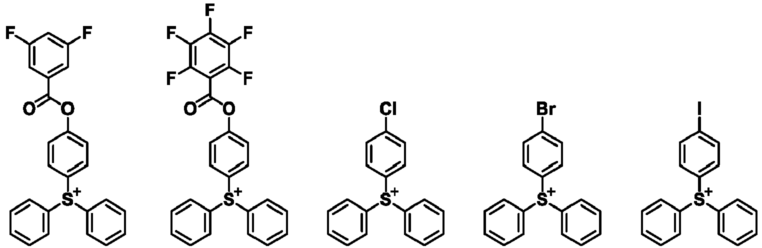

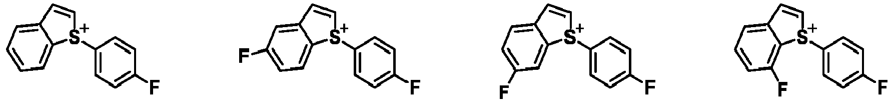

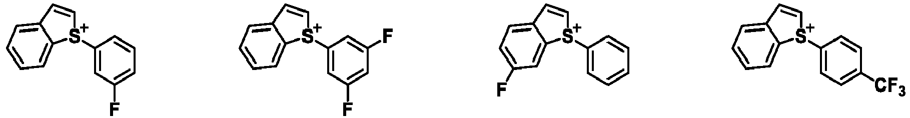

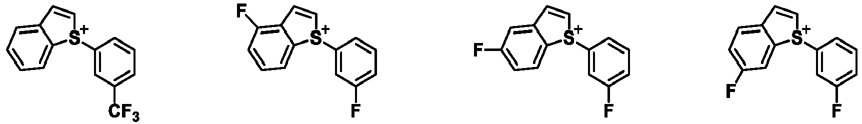

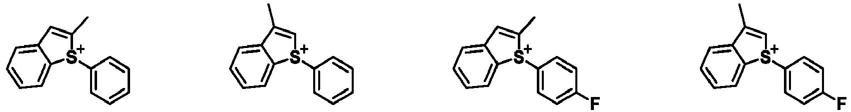

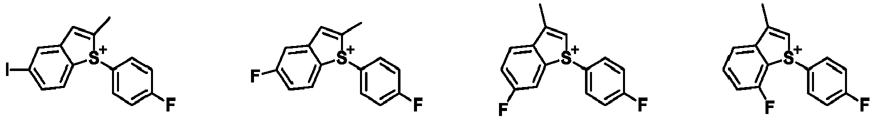

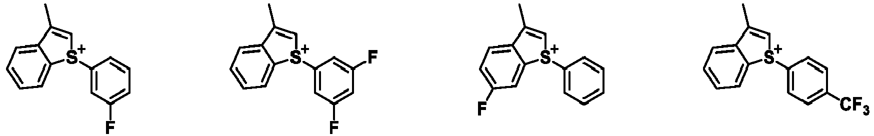

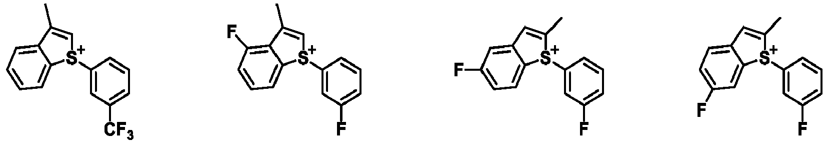

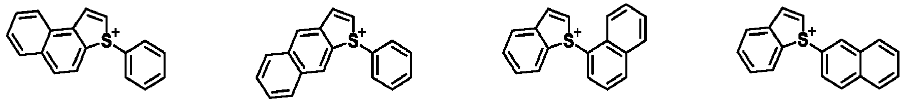

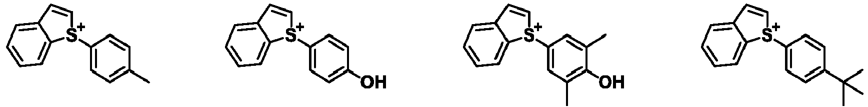

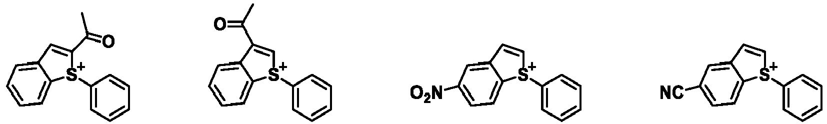

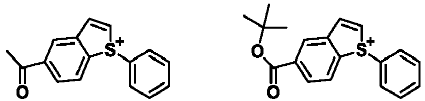

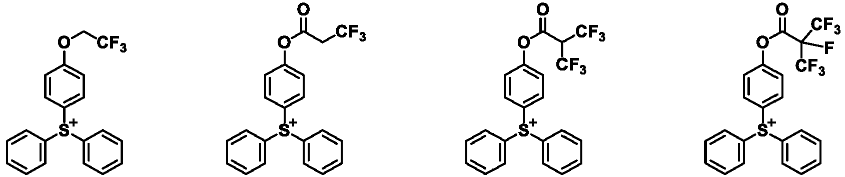

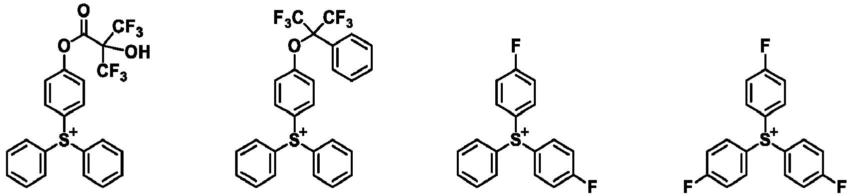

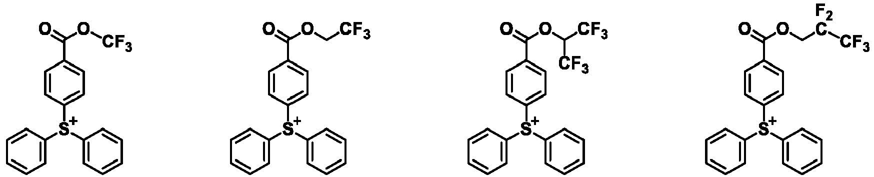

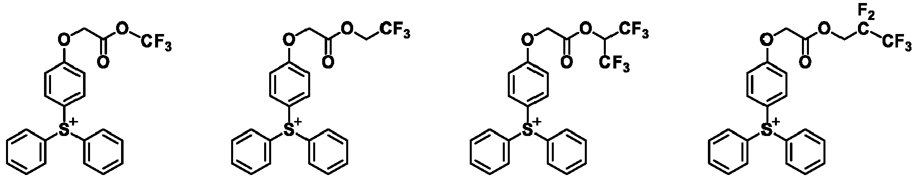

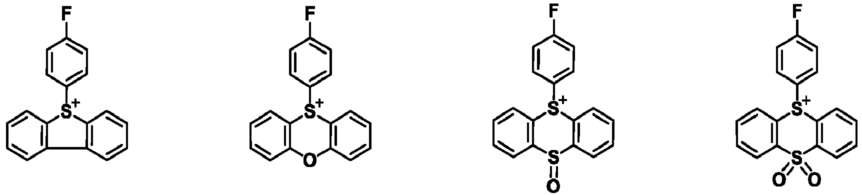

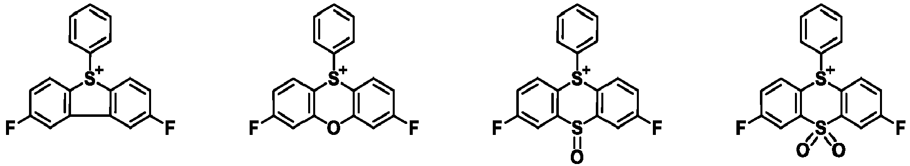

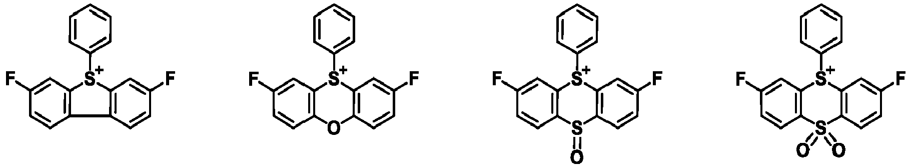

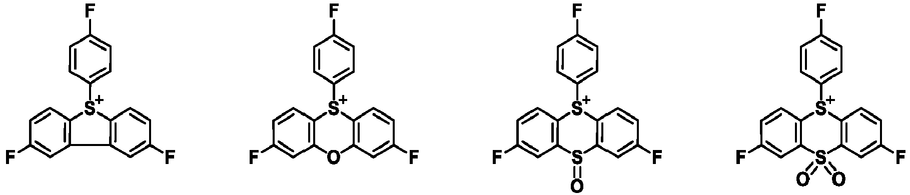

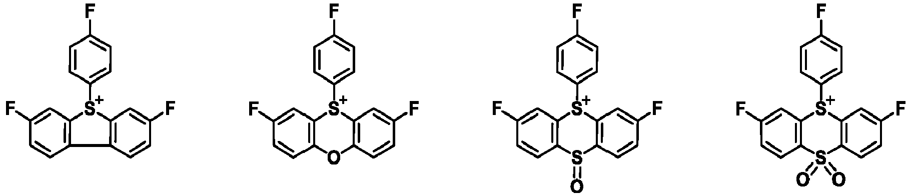

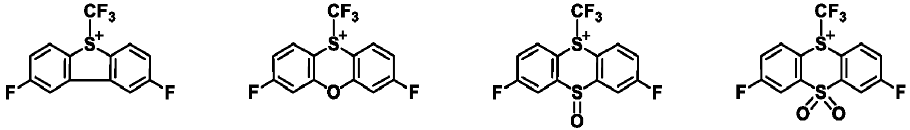

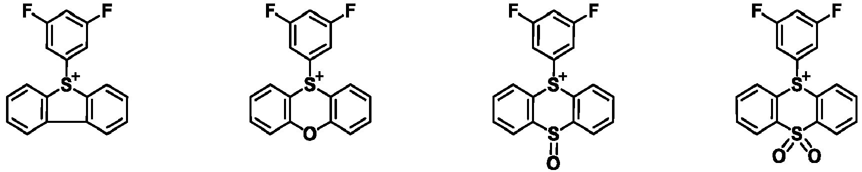

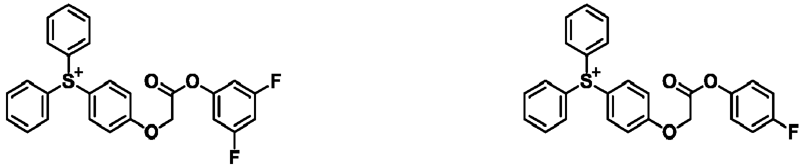

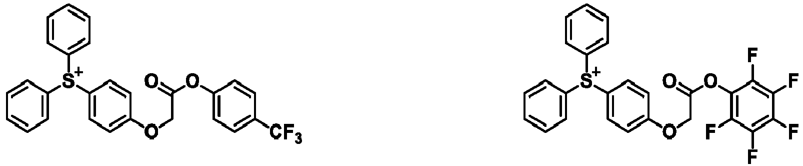

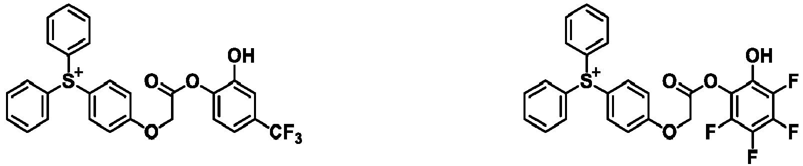

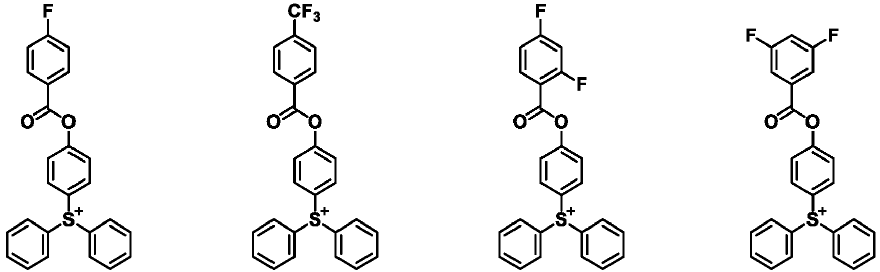

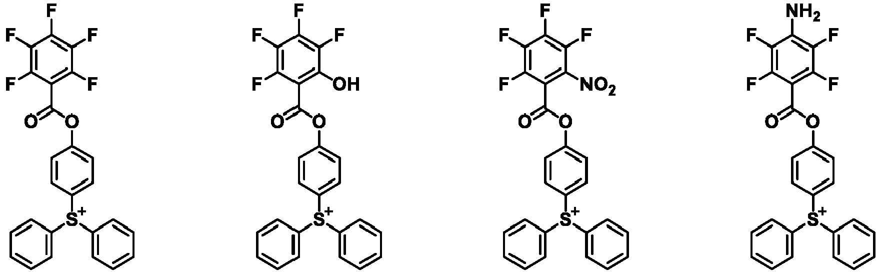

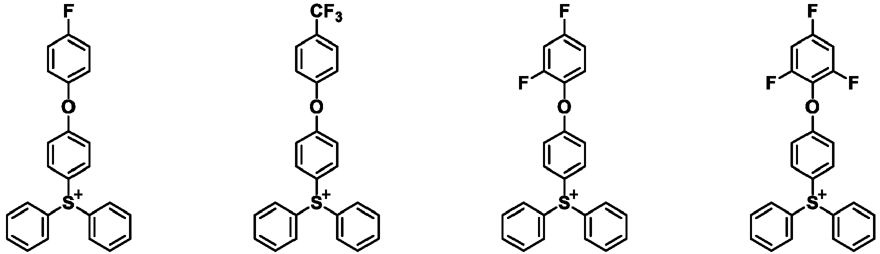

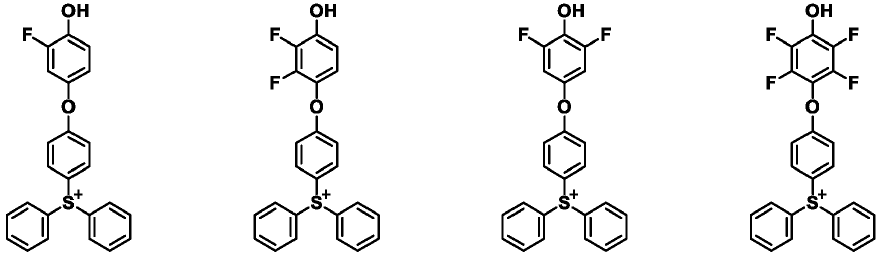

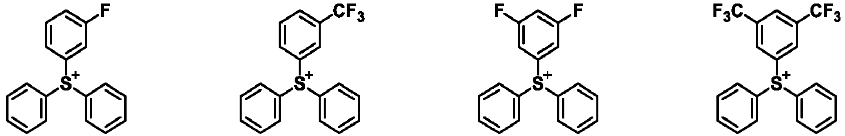

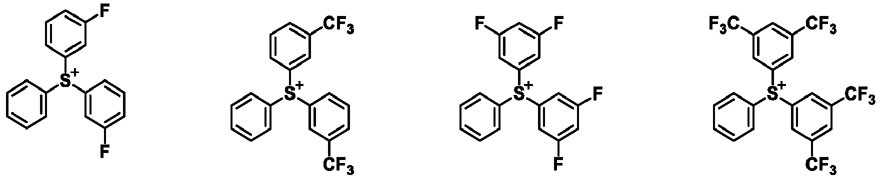

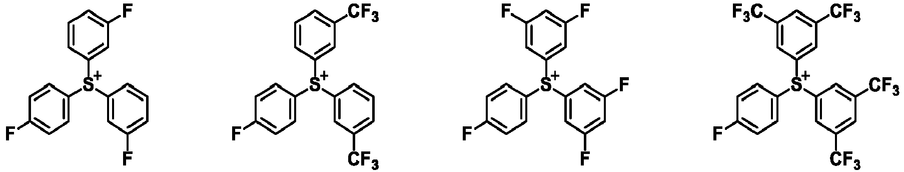

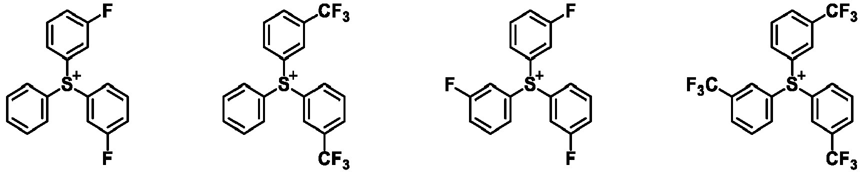

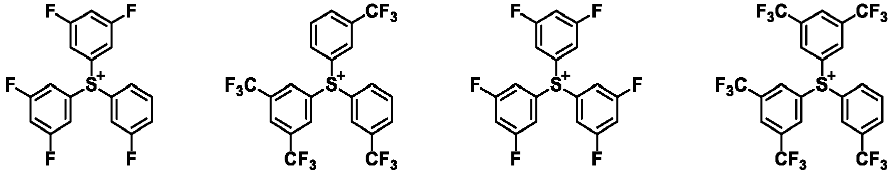

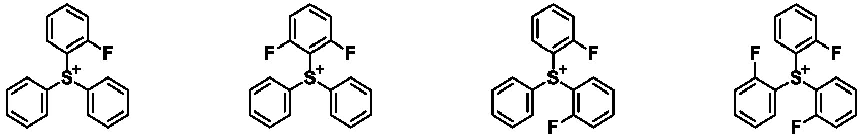

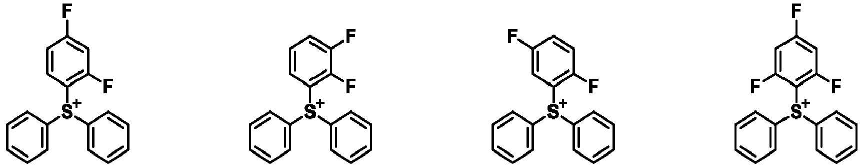

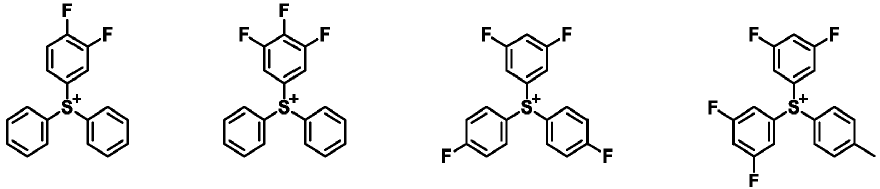

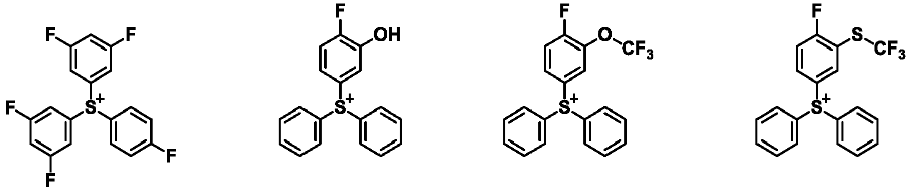

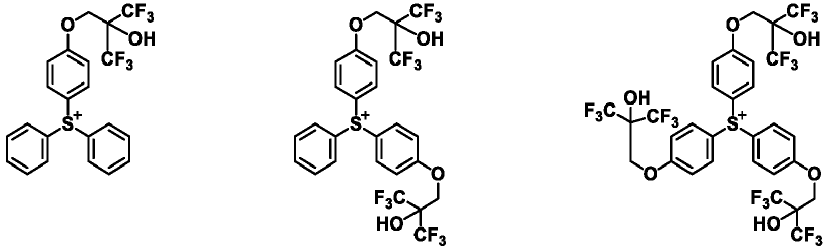

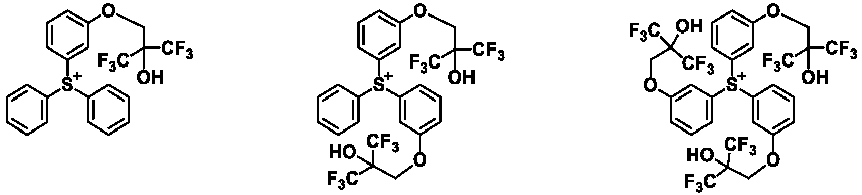

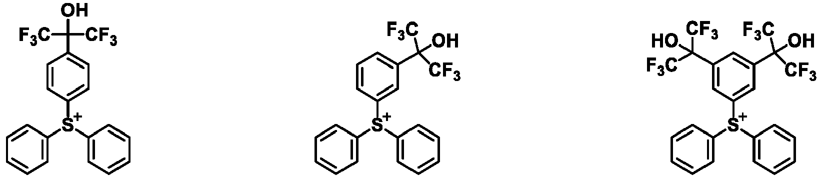

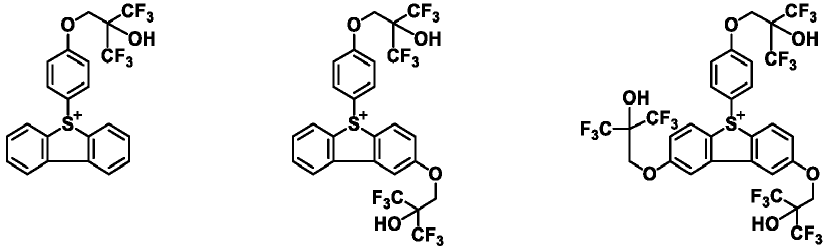

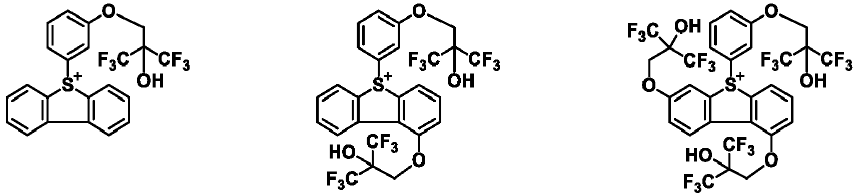

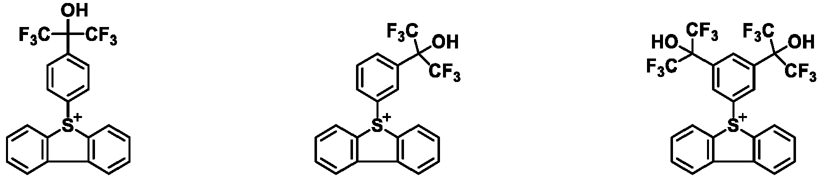

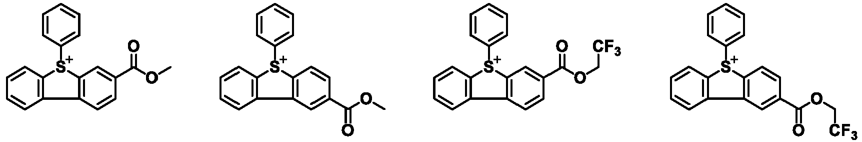

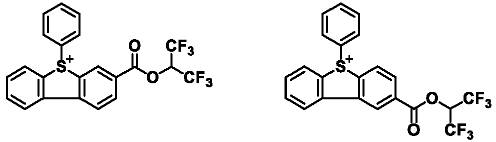

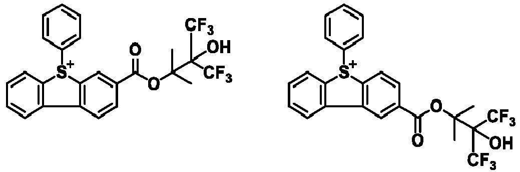

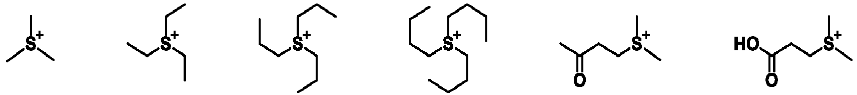

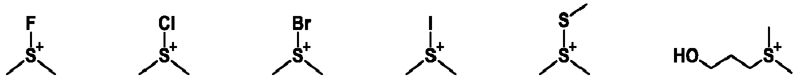

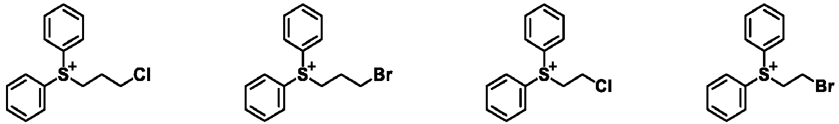

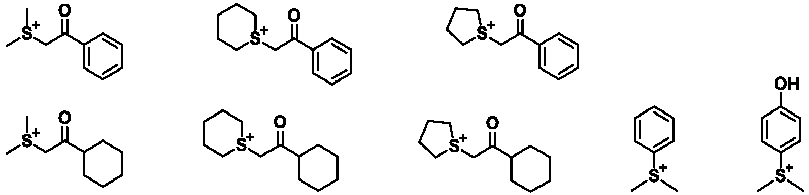

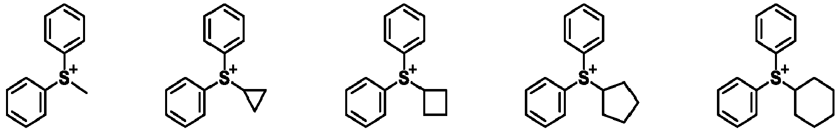

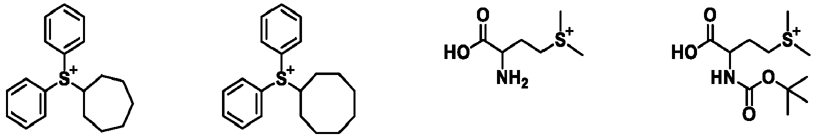

Examples of the iodonium cation having formula (cation-2) are shown below, but not limited thereto.

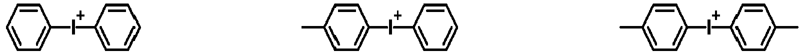

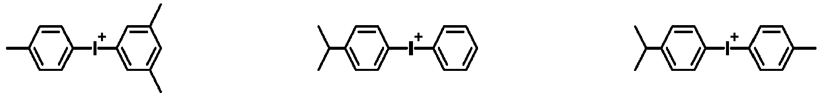

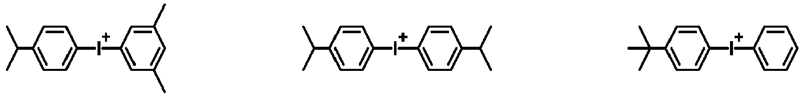

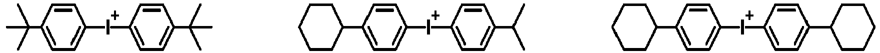

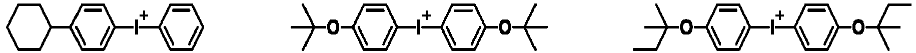

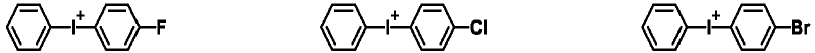

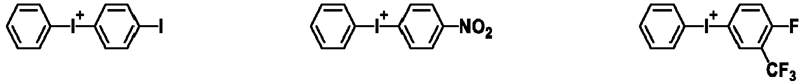

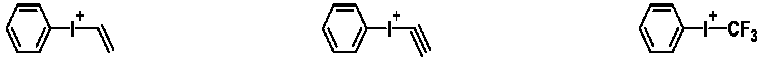

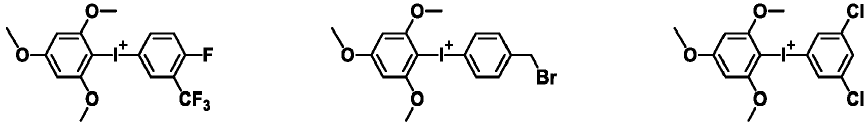

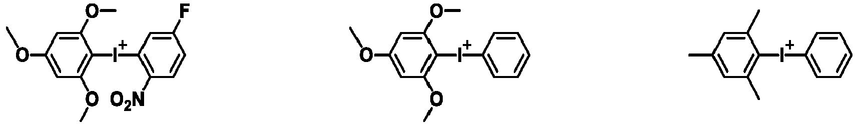

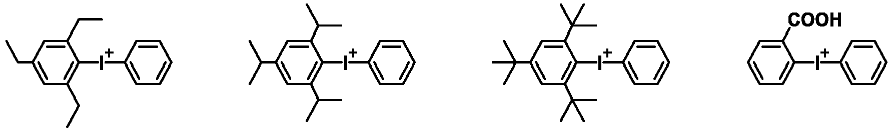

Examples of the ammonium cation having formula (cation-3) are shown below, but not limited thereto.

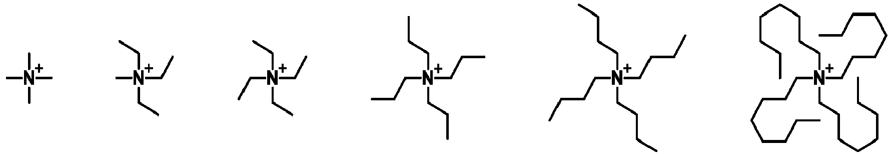

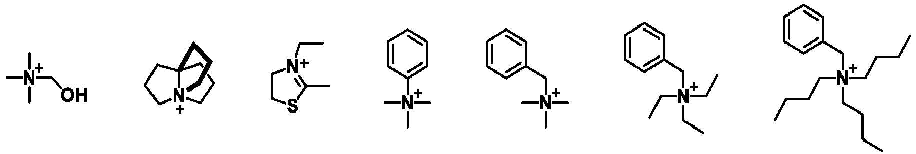

Specific structures of the inventive onium salt include arbitrary combinations of the anion with the cation, both as exemplified above.

The onium salt having formula (A) may be synthesized by any well-known method, for example, according to the following scheme. Reference is now made to the synthesis of an onium salt having the formula (Q-1-ex).

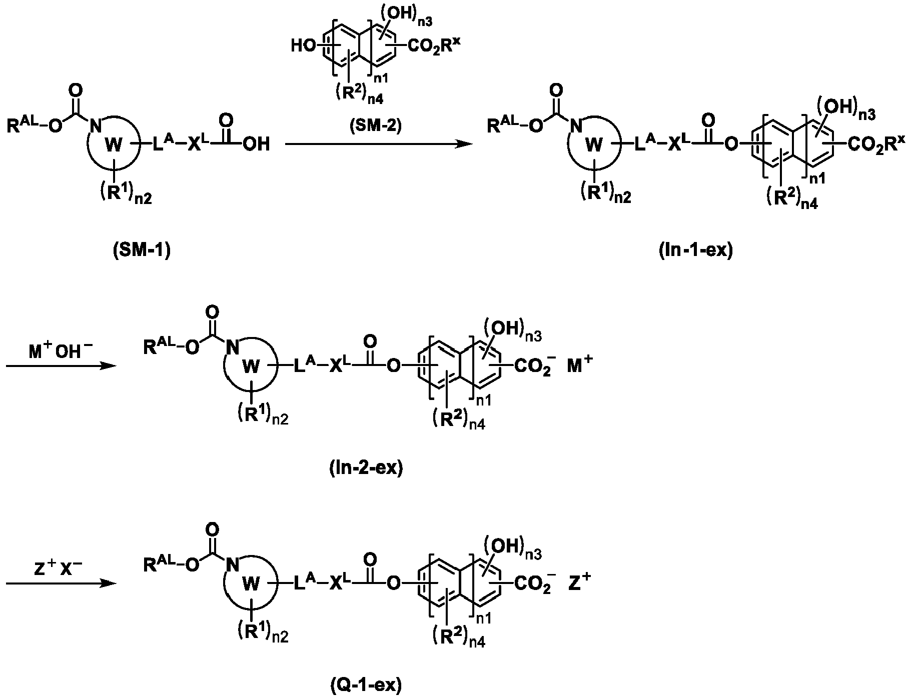

Herein, n1 to n4, W, L^{A}, X^{L}, R¹, R², R^{AL} and Z⁺ are as defined above. R^{X} is a group which forms a primary or secondary ester with the adjacent -CO₂-. M⁺ is a counter cation. X⁻ is a counter anion.

The first step is to react reactant SM-1 with reactant SM-2, which are commercially available or can be synthesized by the standard method, to form an intermediate In-1-ex. Any condensing agents may be used when an ester bond is formed directly from the carboxy group on reactant SM-1 and the hydroxy group on reactant SM-2. Examples of the condensing agent include N,N'-dicyclohexylcarbodiimide, N,N'-diisopropylcarbodiimide, 1-[3-(dimethylamino)propyl]-3-ethylcarbodiimide, and 1-ethyl-3-(3-dimethylaminopropyl)carbodiimide hydrochloride. From the standpoint of ease of removal of urea compounds formed as by-products after reaction, it is desirable to use 1-ethyl-3-(3-dimethylaminopropyl)carbodiimide hydrochloride. The reaction is carried out by dissolving reactants SM-1 and SM-2 in a halogenated solvent such as methylene chloride and adding a condensing agent. The reaction rate can be increased by adding 4-dimethylaminopyridine as a catalyst. While it is desirable in view of yield to monitor the reaction by silica gel thin layer chromatography (TLC) until the reaction is complete, the reaction time is typically about 12 to 24 hours. After the reaction is terminated, urea compounds formed by side reactions are removed by filtration or water-washing if necessary. The reaction solution is subjected to standard aqueous work-up, obtaining Intermediate In-1-ex. If necessary, the intermediate is purified by a standard technique such as distillation, chromatography or recrystallization.

The second step is alkaline hydrolysis of Intermediate In-1-ex to Intermediate In-2-ex. Specifically, the carboxylic ester in Intermediate In-1-ex is subjected to alkaline hydrolysis using an alkali metal hydroxide salt or a hydroxide salt of organic cation, obtaining Intermediate In-2-ex or carboxylic acid salt. Examples of the alkali metal hydroxide salt used herein include lithium hydroxide, sodium hydroxide, and potassium hydroxide. Examples of the hydroxide salt of organic cation include tetramethylammonium hydroxide and benzyltrimethylammonium hydroxide. The reaction is carried out by dissolving Intermediate In-1-ex in an ether solvent such as tetrahydrofuran or 1,4-dioxane and adding an aqueous solution of the hydroxide salt. While it is desirable in view of yield to monitor the reaction by TLC until the reaction is complete, the reaction time is typically about 12 to 24 hours. The reaction mixture is subjected to standard aqueous work-up, obtaining Intermediate In-2-ex. If necessary, the intermediate is purified by a standard technique such as chromatography or recrystallization.

The third step is a salt exchange between Intermediate In-2-ex and an onium salt: Z⁺X⁻ to synthesize an onium salt Q-1-ex. X⁻ is preferably a chloride ion, bromide ion, iodide ion or methylsulfate anion because the exchange reaction readily takes place in a quantitative way. It is desirable in view of yield to monitor the reaction process by TLC. The reaction mixture is subjected to standard aqueous work-up, obtaining an onium salt Q-1-ex. If necessary, the onium salt is purified by a standard technique such as chromatography or recrystallization.

In the above-illustrated scheme, the third step of ion exchange may be readily carried out by any well-known procedure, for example, with reference to JP-A 2007-145797.

It is noted that the preparation method according to the above scheme is merely exemplary and the method of preparing the inventive onium salt is not limited thereto.

The onium salt having a nitrogen-containing aliphatic heterocycle and aromatic carboxylic acid structure in the anion, represented by formula (A), functions as a quencher. That is, the aromatic carboxylic acid anion site is effective for trapping the strong acid generated from the acid generator in exposed areas. The acid labile group with which the nitrogen-containing aliphatic heterocycle site is protected undergoes deprotection reaction under the action of the strong acid, whereupon a nitrogen-containing aliphatic heterocyclic compound which is highly basic is formed. The highly basic nitrogen-containing aliphatic heterocycle site restrains excessive diffusion of acid to unexposed areas while the carboxylic acid anion site continuously repeats proton exchange with the strong acid. Due to the synergy of these effects, the dissolution contrast between exposed and unexposed areas is enhanced, and the diffusion of strong acid is adequately controlled. Thus satisfactory lithographic performance is achievable in the formation of small-size patterns. The aromatic carboxylic acid structure and the acid labile group with which the nitrogen-containing aliphatic heterocycle site is protected have an adequate number of carbon atoms, which leads to an improvement in organic solvent solubility. This effectively restrains the penetration of an alkaline developer into a resist film in unexposed areas and hence, the collapse or stripping of resist patterns. The onium salt quite effectively functions as a quencher when applied to chemically amplified positive resist compositions.

In the resist composition, the quencher (A) is preferably used in an amount of 0.1 to 100 parts by weight, more preferably 1 to 50 parts by weight, even more preferably 1 to 10 parts by weight per 80 parts by weight of the base polymer (B) described below. An amount of the quencher in the range ensures a satisfactory quenching function, eliminating the risk of lowering sensitivity or leaving foreign particles due to shortage of solubility. The quencher may be used alone or in admixture of two or more.

### (B) Base polymer

The resist composition also comprises (B) a base polymer. The base polymer contains a polymer which is decomposed under the action of acid to increase its solubility in alkaline developer, the polymer comprising repeat units having the formula (B1), which are also referred to as repeat units B1.

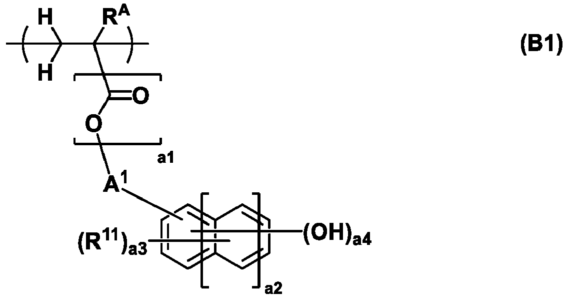

In formula (B1), a1 is 0 or 1. The subscript a2 is an integer of 0 to 2. The structure represents a benzene skeleton when a2=0, a naphthalene skeleton when a2=1, and an anthracene skeleton when a2=2. The subscript a3 is an integer satisfying 0 ≤ a3 ≤ 5+2(a2)-a4, and a4 is an integer of 1 to 3. In case of a2=0, preferably a3 is an integer of 0 to 3, and a4 is an integer of 1 to 3. In case of a2=1 or 2, preferably a3 is an integer of 0 to 4, and a4 is an integer of 1 to 3.

In formula (B1), R^{A} is hydrogen, fluorine, methyl or trifluoromethyl.

In formula (B1), R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, n-propyl, isopropyl, butyl, pentyl, hexyl, and structural isomers thereof, cycloalkyl groups such as cyclopropyl, cyclobutyl, cyclopentyl and cyclohexyl, and combinations thereof. A carbon count within the upper limit ensures good solubility in alkaline developer. A plurality of R¹¹ may be identical or different when a3 is 2 or more.

In formula (B1), A¹ is a single bond or C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a 1 = 1 in formula (B1), the ether bond may be incorporated at any position excluding the position between the α-carbon and β-carbon relative to the ester oxygen. In case of a1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the main chain of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. Repeat units having the formula (B 1-1) are especially preferred. 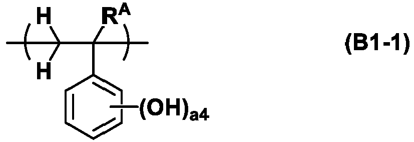 Herein R^{A} and a4 are as defined above.

Preferred examples of the repeat units B1 wherein a1=1, that is, having a linker: -C(=O)-O-A¹- are shown below, but not limited thereto. Herein R^{A} is as defined above.

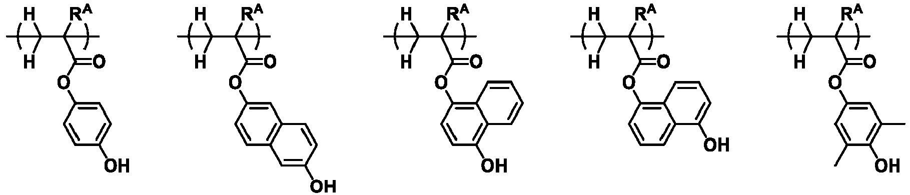

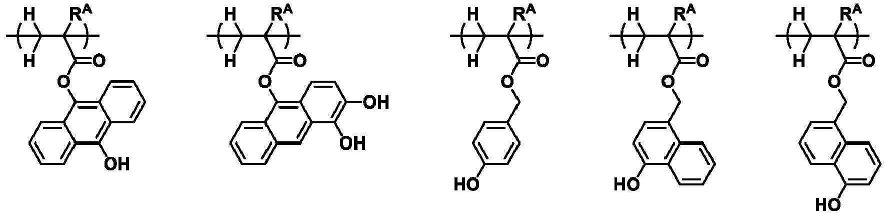

The content of repeat units B 1 is preferably 10 to 95 mol%, more preferably 40 to 90 mol% of the overall repeat units of the polymer. When the polymer further contains repeat units having formula (B3) and/or repeat units having formula (B4), which provide the polymer with higher etch resistance, the repeat units having a phenolic hydroxy group as a substituent, the total content of repeat units B 1 and repeat units B3 and/or B4 is preferably in the range. The repeat units B 1 may be used alone or in admixture of two or more.

In a preferred embodiment, the polymer further contains repeat units B2 having an acidic functional group protected with an acid labile group (i.e., repeat units protected with an acid labile group and adapted to turn alkali soluble under the action of acid) so that the positive resist composition in exposed areas may be dissolved in alkaline developer. In this embodiment wherein the acid labile group (or protective group) in the repeat unit undergoes deprotection reaction under the action of acid, the polymer turns more soluble in alkaline developer.

Typical of the repeat unit B2 is a unit having the formula (B2-1), also referred to as repeat unit B2-1.

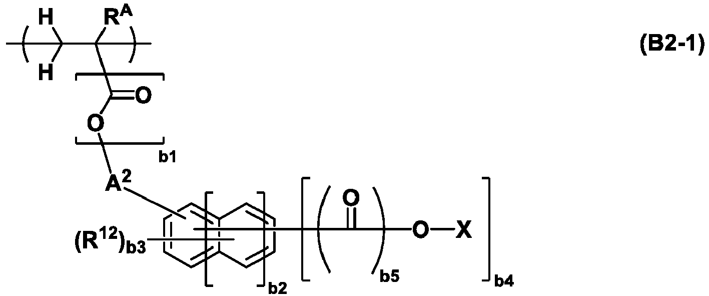

In formula (B2-1), b1 is 0 or 1. The subscript b2 is an integer of 0 to 2. The structure represents a benzene skeleton when b2=0, a naphthalene skeleton when b2=1, and an anthracene skeleton when b2=2. The subscript b3 is an integer meeting 0 ≤ b3 ≤ 5+2(b2)-b4. The subscript b4 is an integer of 1 to 3, and b5 is 0 or 1. When b2=0, preferably b3 is an integer of 0 to 3 and b4 is an integer of 1 to 3. When b2=1 or 2, preferably b3 is an integer of 0 to 4 and b4 is an integer of 1 to 3.

In formula (B2-1), R^{A} is hydrogen, fluorine, methyl or trifluoromethyl.

In formula (B2-1), R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic, and examples thereof include alkyl groups such as methyl, ethyl, n-propyl, isopropyl, butyl, pentyl, hexyl, and structural isomers thereof, cycloalkyl groups such as cyclopropyl, cyclobutyl, cyclopentyl and cyclohexyl, and combinations thereof. A carbon count within the upper limit ensures good solubility in alkaline developer. A plurality of R¹² may be identical or different when b3 is 2 or more.

In formula (B2-1), A² is a single bond or a C₁-C₁₀ saturated hydrocarbylene group in which some constituent -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b 1 = 1 in formula (B2-1), the ether bond may be incorporated at any position excluding the position between the α-carbon and β-carbon relative to the ester oxygen. In case of b1=0, the atom that bonds with the main chain becomes an ethereal oxygen, and a second ether bond may be incorporated at any position excluding the position between the α-carbon and β-carbon relative to that ethereal oxygen. Saturated hydrocarbylene groups having no more than 10 carbon atoms are desirable because of a sufficient solubility in alkaline developer.

In formula (B2-1), X is an acid labile group when b4=1, and hydrogen or an acid labile group, at least one X being an acid labile group, when b4=2 or 3. That is, repeat units B2-1 have phenolic hydroxy groups bonded to an aromatic ring, at least one of which is protected with an acid labile group, or repeat units B2-1 have a carboxy group bonded to an aromatic ring, which is protected with an acid labile group. The acid labile group used herein is not particularly limited as long as it is commonly used in a number of well-known chemically amplified resist compositions and eliminated under the action of acid to provide an acidic group. Examples of the acid labile group are as exemplified above for the acid labile group represented by R^{AL} in formula (A). Another acid labile group which can be used herein is a phenolic hydroxy group whose hydrogen is substituted by -CH₂COO-(tertiary saturated hydrocarbyl group). The tertiary saturated hydrocarbyl group may be the same as the foregoing tertiary saturated hydrocarbyl group used for the protection of a phenolic hydroxy group.

Another example of repeat unit B2 is a repeat unit having the following formula (B2-2), referred to as repeat unit B2-2. The repeat unit B2-2 which enables to increase the dissolution rate in the exposed region is a useful choice of the acid labile group-containing unit which affords satisfactory performance against line width variations during develop loading.

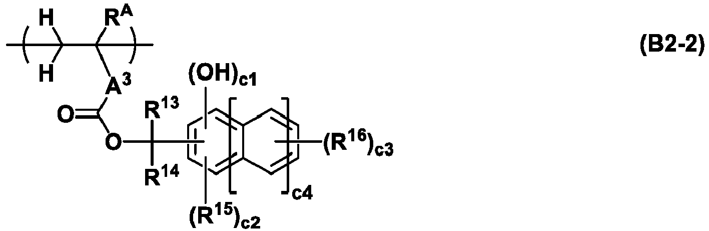

In formula (B2-2), c1 is an integer of 0 to 2, c2 is an integer of 0 to 2, c3 is an integer of 0 to 5, and c4 is an integer of 0 to 2.

In formula (B2-2), R^{A} is hydrogen, fluorine, methyl or trifluoromethyl.

In formula (B2-2), R¹³ and R¹⁴ are each independently a C₁-C₁₀ hydrocarbyl group which may contain a heteroatom. R¹³ and R¹⁴ may bond together to form a ring with the carbon atom to which they are attached.

In formula (B2-2), R¹⁵ is each independently fluorine, C₁-C₅ fluorinated alkyl group or C₁-C₅ fluorinated alkoxy group.

In formula (B2-2), R¹⁶ is each independently a C₁-C₁₀ hydrocarbyl group which may contain a heteroatom.

In formula (B2-2), A³ is a single bond, phenylene group, naphthylene group, or *-C(=O)-O-A³¹-. A³¹ is a C₁-C₂₀ aliphatic hydrocarbylene group which may contain hydroxy, ether bond, ester bond or lactone ring, or a phenylene or naphthylene group, and * is a point of attachment to the carbon atom in the backbone.

Preferred examples of the repeat unit B2-2 are shown below, but not limited thereto. Herein R^{A} is as defined above.

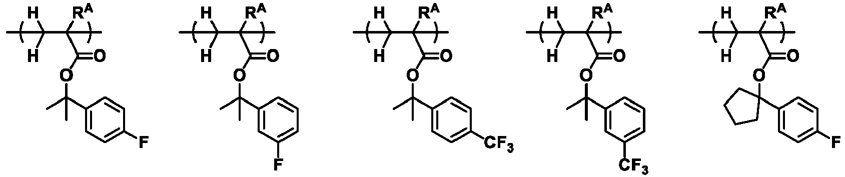

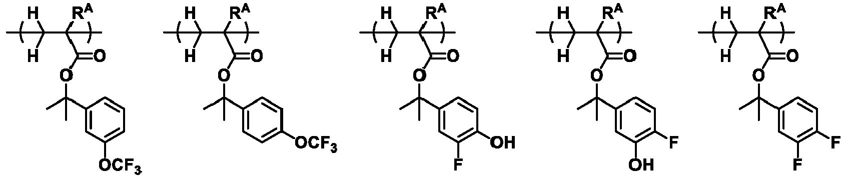

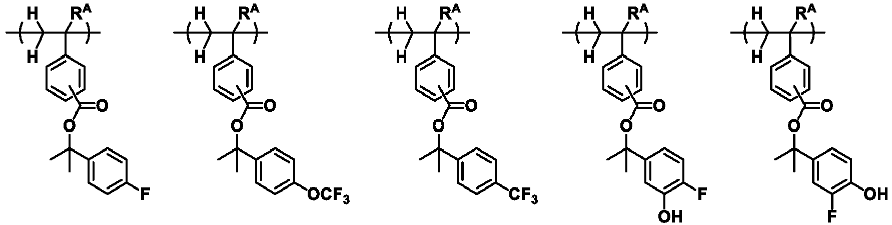

The content of repeat units B2 is preferably 5 to 50 mol% based on the overall repeat units of the polymer. Each of repeat units B2 may be of one type or a mixture of two or more types.

In a preferred embodiment, the polymer further comprises repeat units of at least one type selected from units having the formulae (B3), (B4) and (B5). These repeat units are simply referred to as repeat units B3, B4 and B5, respectively.

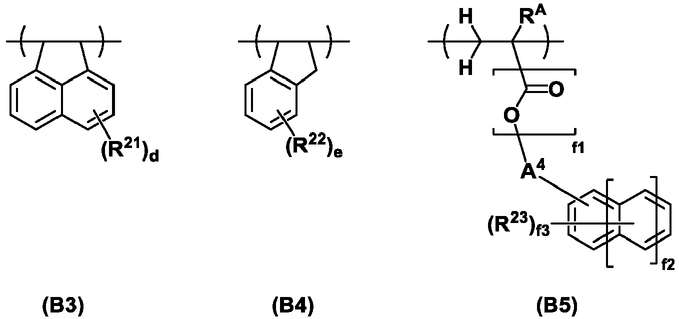

In formulae (B3) and (B4), d and e are each independently an integer of 0 to 4.

In formulae (B3) and (B4), R²¹ and R²² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group and saturated hydrocarbylcarbonyloxy group may be straight, branched or cyclic. When d is 2 or more, a plurality of groups R²¹ may be identical or different. When e is 2 or more, a plurality of groups R²² may be identical or different.

In formula (B5), f1 is 0 or 1. The subscript f2 is an integer of 0 to 2, and the corresponding structure represents a benzene skeleton when f2=0, a naphthalene skeleton when f2=1, and an anthracene skeleton when f2=2. The subscript f3 is an integer of 0 to 5. In case of f2=0, preferably f3 is an integer of 0 to 3. In case of f2=1 or 2, preferably f3 is an integer of 0 to 4.

In formula (B5), R^{A} is hydrogen, fluorine, methyl or trifluoromethyl.

In formula (B5), R²³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group and saturated hydrocarbylsulfonyl group may be straight, branched or cyclic. When f3 is 2 or more, a plurality of groups R²³ may be identical or different.

R²³ is preferably selected from halogen atoms such as fluorine, chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methyl, ethyl, methoxy and ethoxy are most useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B5), A⁴ is a single bond or C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of f1=1 in formula (B5), the ether bond may be incorporated at any position excluding the position between the α- and β-carbons relative to the ester oxygen. In case of f1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B5 wherein f1 is 0 and A⁴ is a single bond (meaning that the aromatic ring is directly bonded to the main chain of the polymer), that is, repeat units free of the linker: -C(=O)-O-A⁴- include units derived from styrene, 4-chlorostyrene, 4-bromostyrene, 4-methylstyrene, 4-methoxystyrene, 4-acetoxystyrene, 2-hydroxypropylstyrene, 2-vinylnaphthalene, and 3-vinylnaphthalene.

Preferred examples of the repeat units B5 wherein f1 is 1, that is, having the linker: -C(=O)-O-A⁴- are shown below, but not limited thereto. R^{A} is as defined above.

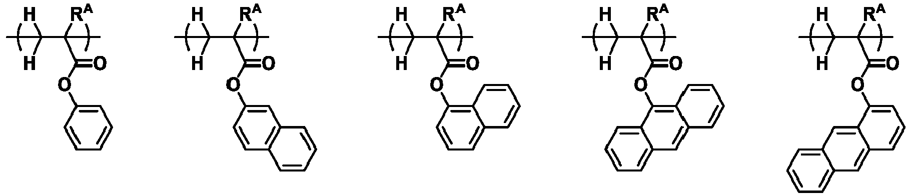

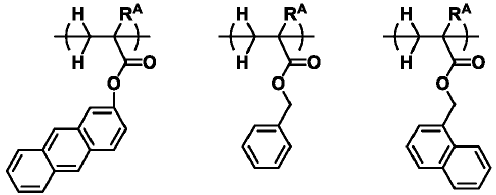

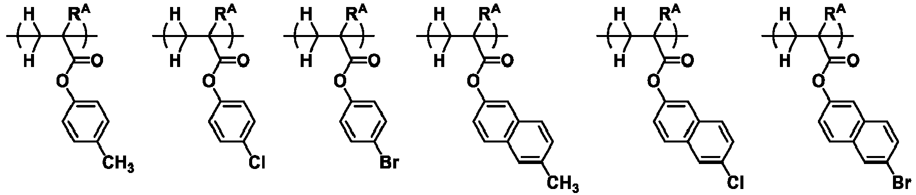

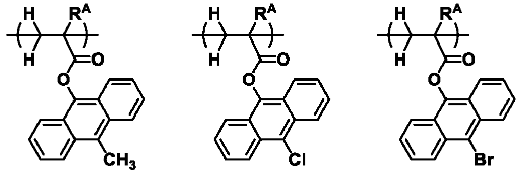

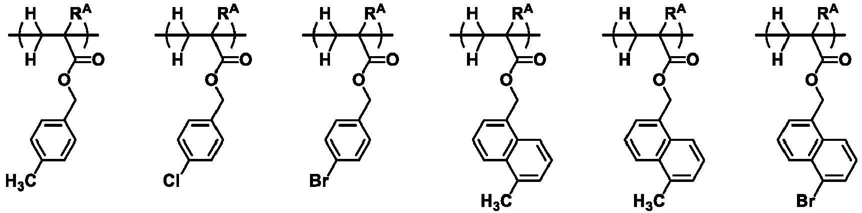

When repeat units of at least one type selected from repeat units B3 to B5 are incorporated, better performance is obtained because not only the aromatic ring possesses etch resistance, but the cyclic structure incorporated into the main chain also exerts the effect of improving etch resistance and resistance to EB irradiation during pattern inspection step.

The content of repeat units B3 to B5 is preferably at least 5 mol% based on the overall repeat units of the polymer for obtaining the effect of improving etch resistance. Also, the content of repeat units B3 to B5 is preferably up to 35 mol%, more preferably up to 30 mol% based on the overall repeat units of the polymer. When the relevant units are free of functional groups or have a functional group other than hydroxy, their content of up to 35 mol% is preferred because the risk of forming development defects is eliminated. Each of the repeat units B3 to B5 may be of one type or a combination of plural types.

It is preferred that the polymer comprise repeat units B1, repeat units B2, and repeat units of at least one type selected from repeat units B3 to B5, because both etch resistance and high resolution are achievable. The total content of these repeat units is preferably at least 60 mol%, more preferably at least 70 mol%, even more preferably at least 80 mol% based on the overall repeat units of the polymer.

In another preferred embodiment, the polymer further comprises repeat units of at least one type selected from repeat units having the formula (B6), repeat units having the formula (B7), repeat units having the formula (B8), repeat units having the formula (B9), repeat units having the formula (B10), repeat units having the formula (B11), repeat units having the formula (B12), and repeat units having the formula (B 13), shown below. Notably these repeat units are also referred to as repeat units B6 to B13. The repeat units B6 to B13 are effective for suppressing acid diffusion and forming patterns with improved resolution and reduced LER.

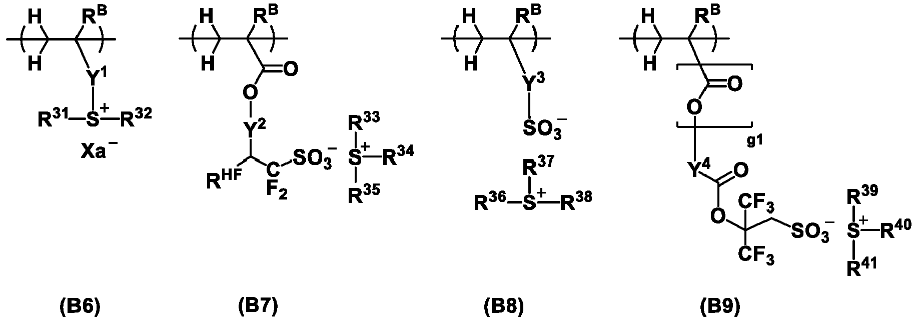

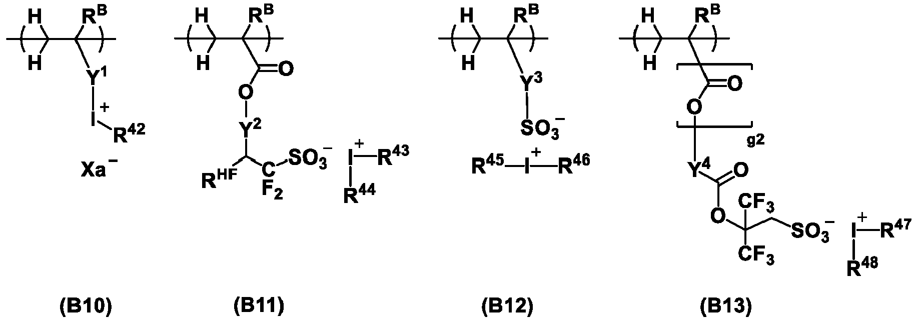

In formulae (B6) to (B13), R^{B} is each independently hydrogen or methyl. Y¹ is a single bond, a C₁-C₆ aliphatic hydrocarbylene group, phenylene group, naphthylene group, or C₇-C₁₈ group obtained by combining the foregoing, *-O-Y¹¹-, *-C(=O)-O-Y¹¹-, or *-C(=O)-NH-Y¹¹-, wherein Y¹¹ is a C₁-C₆ aliphatic hydrocarbylene group, phenylene group, naphthylene group, or C₇-C₁₈ group obtained by combining the foregoing, which may contain a carbonyl moiety, ester bond, ether bond or hydroxy moiety. Y² is a single bond or **-Z²¹-C(=O)-O-, wherein Y²¹ is a C₁-C₂₀ hydrocarbylene group which may contain a heteroatom. Y³ is a single bond, methylene, ethylene, phenylene, fluorinated phenylene, trifluoromethyl-substituted phenylene group, *-O-Y³¹-, *-C(=O)-O-Y³¹-, or *-C(=O)-NH-Y³¹-, wherein Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety. The asterisk (*) is a point of attachment to the carbon atom in the backbone and the double asterisk (**) is a point of attachment to the oxygen atom in the formula. Y⁴ is a single bond or a C₁-C₃₀ hydrocarbylene group which may contain a heteroatom. The subscripts g1 and g2 are each independently 0 or 1. When Y⁴ is a single bond, g1 and g2 are 0.

In formulae (B6) and (B10), Xa⁻ is a non-nucleophilic counter ion, examples of which include those described in JP-A 2010-113209 and JP-A 2007-145797.

In formulae (B7) and (B11) wherein Y² is -Y²¹-C(=O)-O-, Y²¹ is a C₁-C₂₀ hydrocarbylene group which may contain a heteroatom, examples of which are shown below, but not limited thereto.

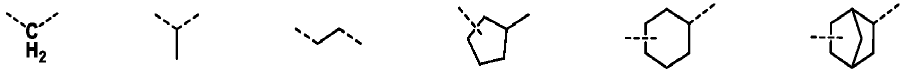

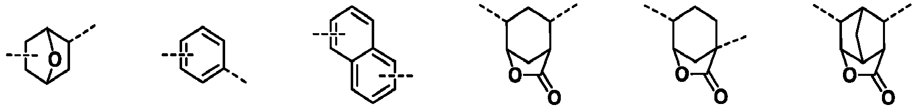

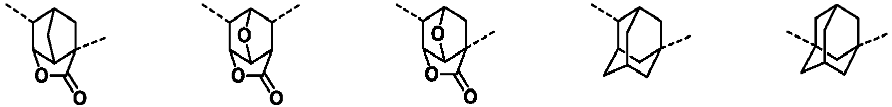

In formulae (B7) and (B11), R^{HF} is hydrogen or trifluoromethyl. Examples of the repeat units B7 and B11 wherein R^{HF} is hydrogen include those described in JP-A 2010-116550. Examples of the repeat units B7 and B11 wherein R^{HF} is trifluoromethyl include those described in JP-A 2010-077404. Examples of the repeat units B8 and B12 include those described in JP-A 2012-246265 and JP-A 2012-246426.

Preferred examples of the anion in the monomers from which repeat units B9 and B 13 are derived are shown below, but not limited thereto.

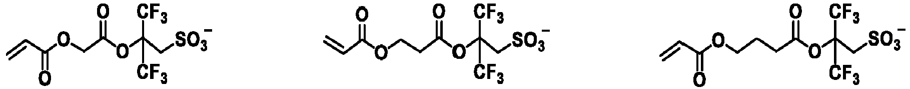

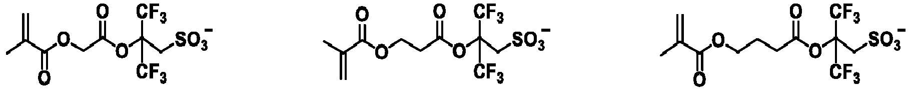

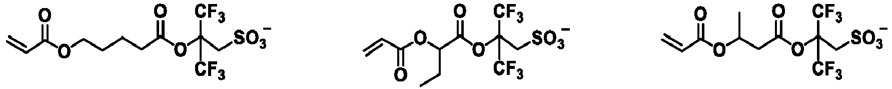

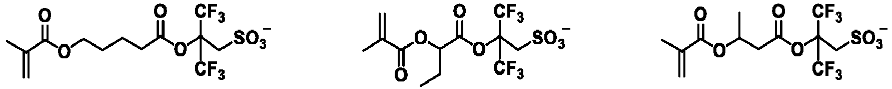

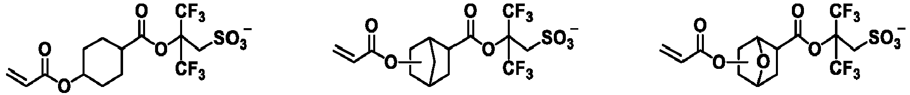

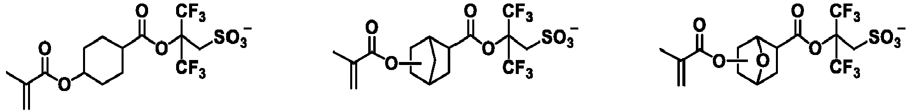

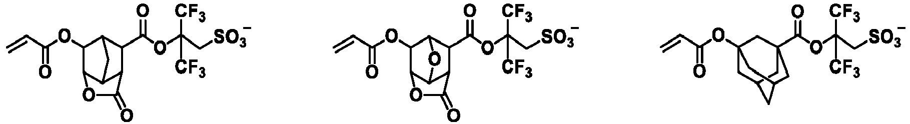

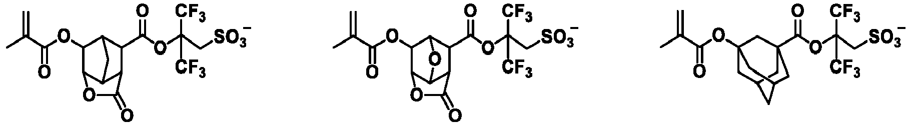

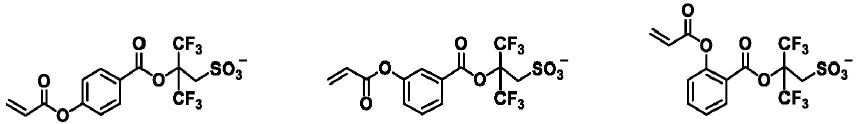

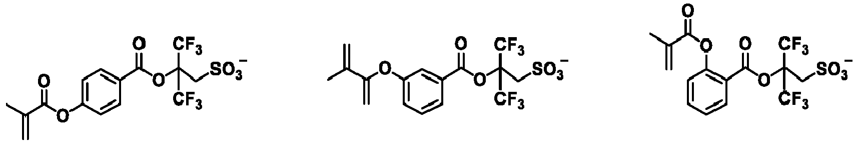

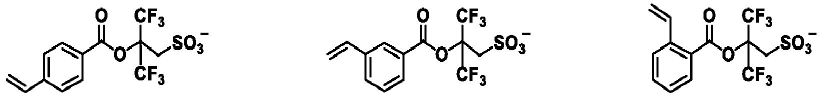

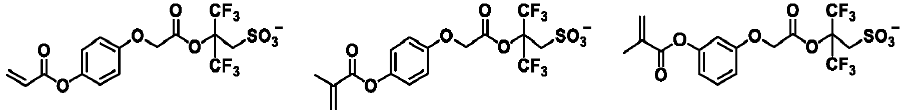

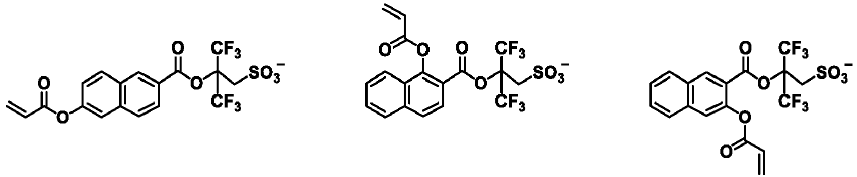

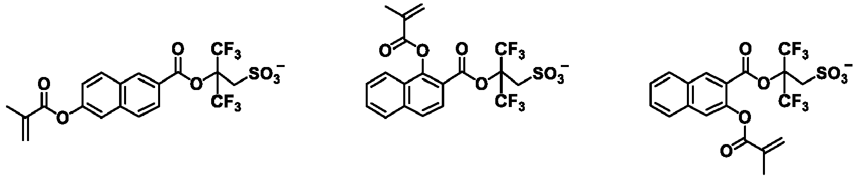

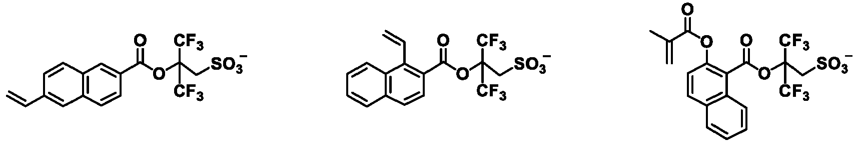

In formulae (B6) to (B13), R³¹ to R⁴⁸ are each independently halogen or a C₁-C₂₀ hydrocarbyl group which may contain a heteroatom. The hydrocarbyl group may be saturated or unsaturated and straight, branched or cyclic. Examples of the halogen and hydrocarbyl group are as exemplified above for the halogen and hydrocarbyl groups represented by R^{c1} to R^{c9} in formulae (cation-1) to (cation-3). In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, fluorine, chlorine, bromine, iodine, cyano moiety, nitro moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

A pair of R³¹ and R³² may bond together to form a ring with the sulfur atom to which they are attached. Also, R³³ and R³⁴, R³⁶ and R³⁷, or R³⁹ and R⁴⁰ may bond together to form a ring with the sulfur atom to which they are attached. Examples of the ring are as exemplified for the ring that R^{c1} and R^{c2} in formula (cation-1), taken together, form with the sulfur atom to which they are attached.

Examples of the sulfonium cation in repeat units B7 to B9 are as exemplified for the sulfonium cation having formula (cation-1). Examples of the iodonium cation in repeat units B11 to B 13 are as exemplified for the iodonium cation having formula (cation-2).

The repeat units B6 to B13 are capable of generating an acid upon receipt of high-energy radiation. The binding of these units into a polymer enables appropriate control of acid diffusion and formation of a pattern with reduced LER and improved CDU. Since the acid-generating unit is bound to a polymer, the phenomenon that acid volatilizes from the exposed region and re-deposits on the unexposed region during bake in vacuum is suppressed. This is effective for improving LER and CDU and for suppressing unwanted deprotection reaction in the unexposed region for thereby reducing pattern defects.

When the polymer contains repeat units B6 to B 13, their content is preferably 0.5 to 30 mol% based on the overall repeat units of the polymer. Each of repeat units B6 to B13 may be of one type or a combination of plural types.

The base polymer (B) may be a mixture of a polymer comprising repeat units B 1 and repeat units of at least one type selected from repeat units B6 to B13, and a polymer comprising repeat units B1, but free of repeat units B6 to B13. In the mixture, the content of the polymer free of repeat units B6 to B13 is preferably 2 to 5,000 parts by weight, more preferably 10 to 1,000 parts by weight per 100 parts by weight of the polymer containing repeat units B6 to B 13.

The polymer may further comprise (meth)acrylate units protected with an acid labile group or (meth)acrylate units having an adhesive group such as lactone structure or hydroxy group other than phenolic hydroxy as commonly used in the art. These repeat units are effective for fine adjustment of properties of a resist film, but not essential.

Examples of the (meth)acrylate unit having an adhesive group include repeat units having the following formulae (B14) to (B16), which are also referred to as repeat units B14 to B 16. While these units do not exhibit acidity, they may be used as auxiliary units for providing adhesion to substrates or adjusting solubility.

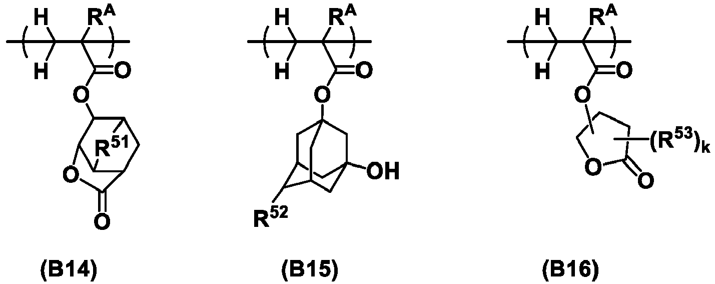

In formulae (B 14) to (B16), R^{A} is each independently hydrogen, fluorine, methyl or trifluoromethyl. R⁵¹ is -O- or methylene. R⁵² is hydrogen or hydroxy. R⁵³ is a C₁-C₄ saturated hydrocarbyl group, and k is an integer of 0 to 3.

When repeat units B14 to B16 are included, their content is preferably 0 to 30 mol%, more preferably 0 to 20 mol% based on the overall repeat units of the polymer. Each of repeat units B14 to B16 may be of one type or a combination of plural types.

It is now considered that the chemically amplified positive resist composition is used in the fabrication of masks. The lithography of advanced generation implies a coating thickness of up to 150 nm, preferably up to 100 nm. The base polymer on which the chemically amplified positive resist composition is based should preferably have a dissolution rate in alkaline developer (typically 2.38 wt% aqueous solution of tetramethylammonium hydroxide (TMAH)) of up to 10 nm/min, more preferably up to 5 nm/min for forming small-size patterns because a strong development process is often employed in order to minimize defects resulting from resist residues. In an example where LSI chips are manufactured from a wafer using the chemically amplified positive resist composition in combination with the EUV lithography, the coating thickness is often up to 100 nm as viewed from the need to form a pattern of narrow lines with a width of up to 50 nm. Since a thin film has a risk that the pattern can be degraded by development, the polymer should preferably have a dissolution rate of up to 10 nm/min, more preferably up to 5 nm/min.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630, for example.

The polymer should preferably have a Mw of 1,000 to 50,000, and more preferably 2,000 to 20,000. A Mw of at least 1,000 eliminates the risk that pattern features are rounded at their top, inviting degradations of resolution, LER and CDU. A Mw of up to 50,000 eliminates the risk that LER and CDU are degraded when a pattern with a line width of up to 100 nm is formed. As used herein, Mw is measured by GPC versus polystyrene standards using tetrahydrofuran (THF) or dimethylformamide (DMF) solvent.

The polymer preferably has a narrow molecular weight distribution or dispersity (Mw/Mn) of 1.0 to 2.0, more preferably 1.0 to 1.8. A polymer with such a narrow dispersity eliminates the risk that foreign particles are left on the pattern after development and the pattern profile is aggravated.

### (C) Photoacid generator

The chemically amplified positive resist composition may further comprise a photoacid generator (PAG) as component (C). The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in repeat unit B2.

In order to obtain the effect of improving LER and CDU when the PAG is combined with the quencher (A), the PAG generates an acid having a pKa value of preferably -3.0 or larger, more preferably -3.0 to 2.0, even more preferably -2.0 to 1.5.

The preferred PAGs are salt compounds having a sulfonium anion of the structure shown below.

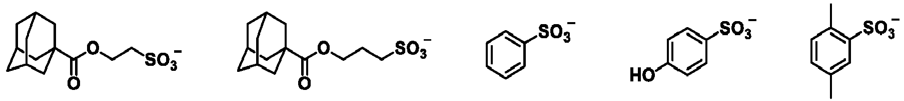

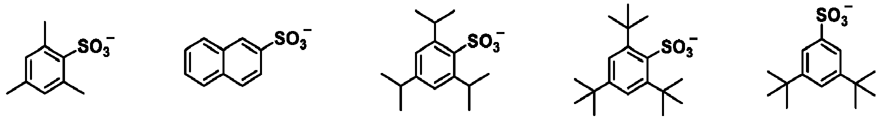

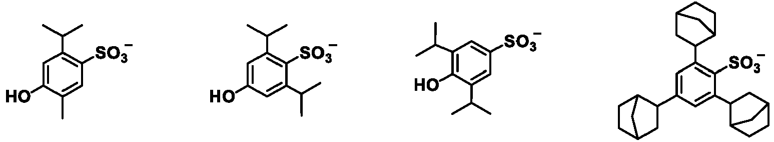

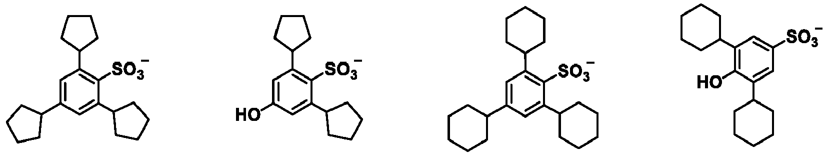

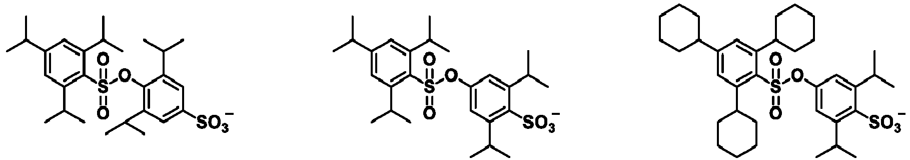

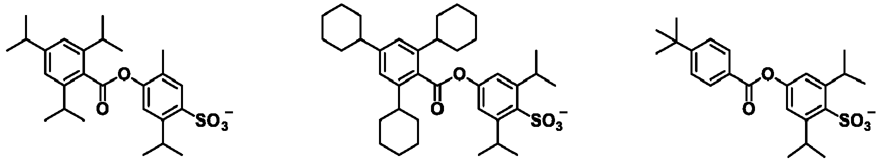

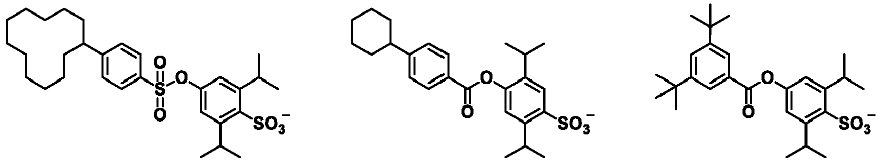

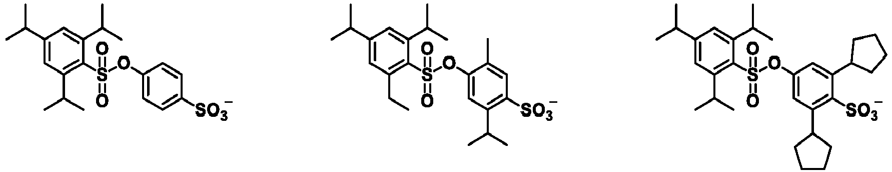

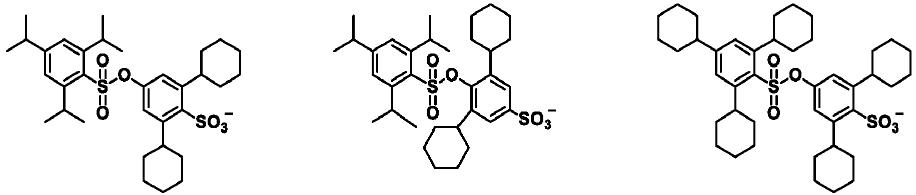

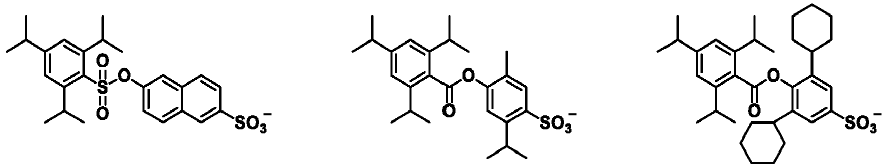

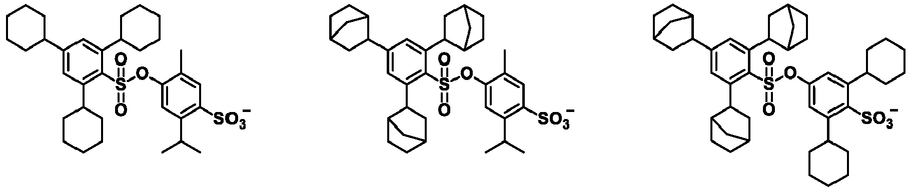

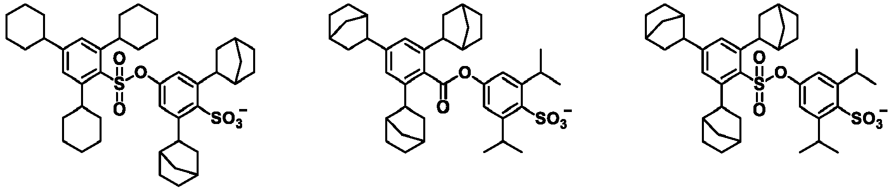

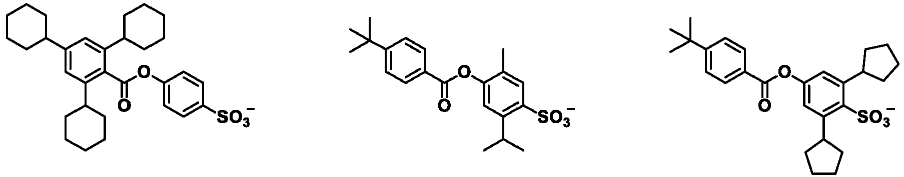

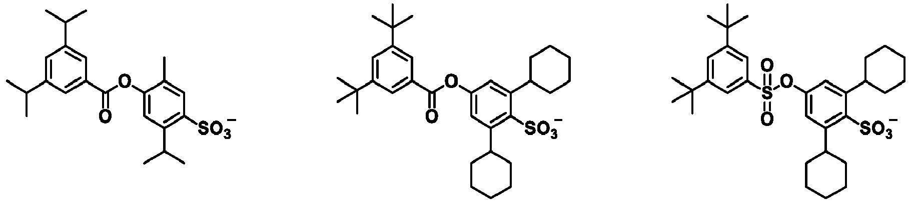

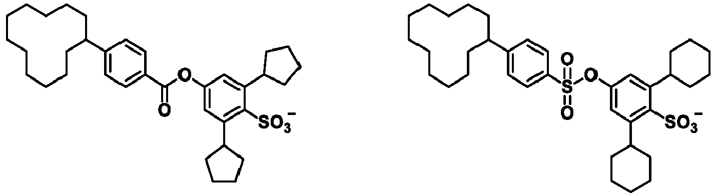

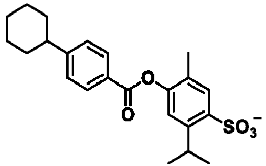

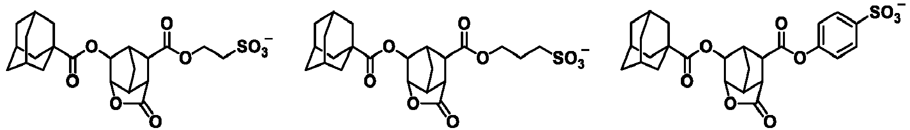

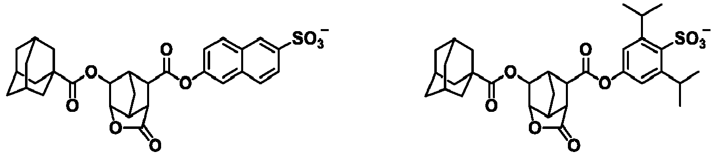

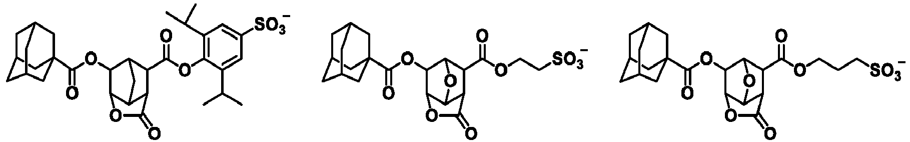

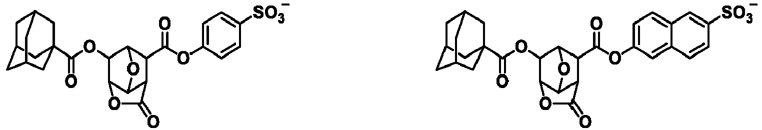

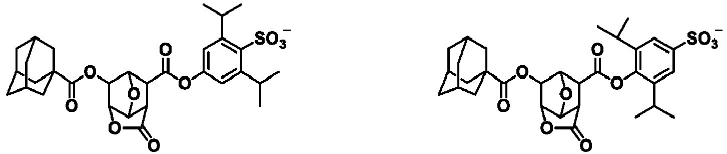

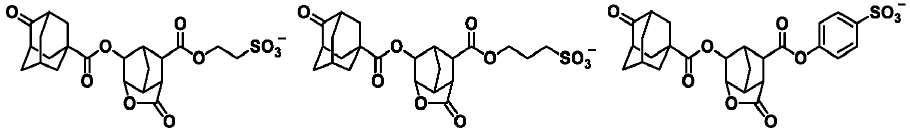

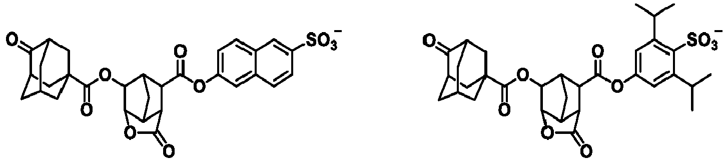

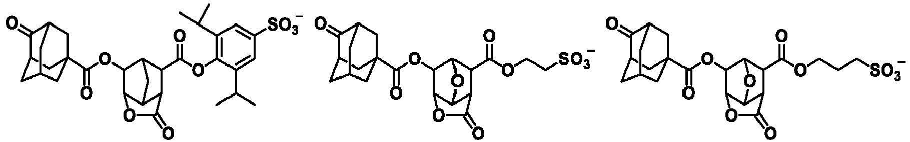

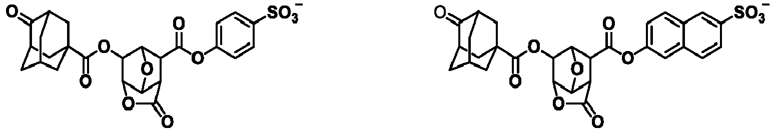

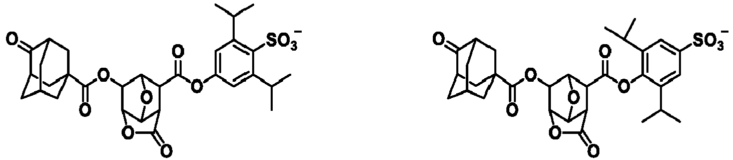

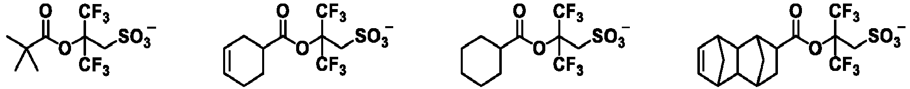

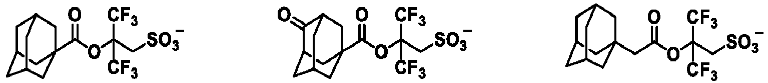

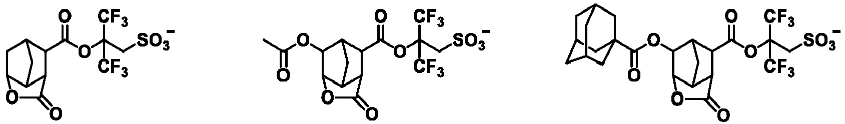

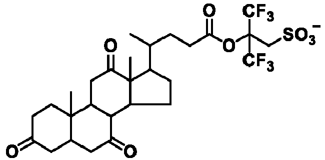

Preferred examples of the cation that pairs with the anion include examples of the sulfonium cation having formula (cation-1) and examples of the iodonium cation having formula (cation-2).

When the resist composition contains the PAG (C), the amount of the PAG (C) used is preferably 1 to 30 parts, more preferably 2 to 20 parts by weight per 80 parts by weight of the base polymer (B). The PAG (C) may be omitted when the base polymer contains repeat units B6 to B13, that is, in case of polymer-bound acid generator. The PAG may be used alone or in admixture.

When the chemically amplified positive resist composition contains both the quencher (A) and the PAG (C), the weight ratio (C)/(A) of the PAG to the quencher is preferably less than 6/1, more preferably less than 5/1, even more preferably less than 4/1. As long as the weight ratio of the PAG to the quencher is in the range, the resist composition is able to fully suppress acid diffusion, leading to improved resolution and dimensional uniformity.

### (D) Fluorinated polymer

The chemically amplified positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

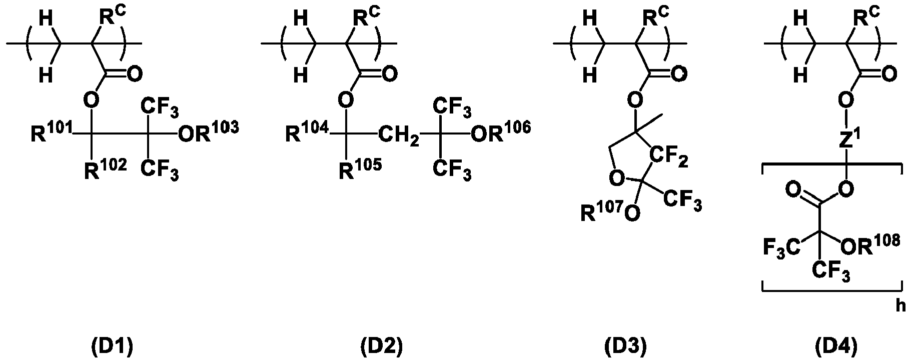

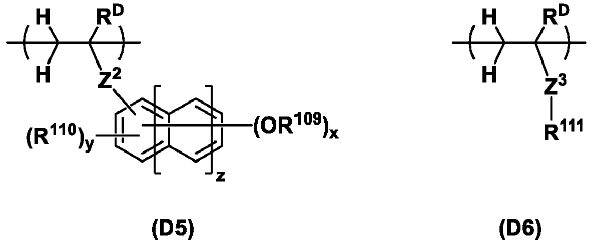

In formulae (D1) to (D6), x is an integer of 1 to 3, y is an integer satisfying: 0 ≤ y ≤ 5+2z-x, z is 0 or 1, and h is an integer of 1 to 3. R^{C} is each independently hydrogen, fluorine, methyl or trifluoromethyl. R^{D} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. Z¹ is a C₁-C₂₀ (h+1)-valent hydrocarbon group or C₁-C₂₀ (h+1)-valent fluorinated hydrocarbon group. Z² is a single bond, *-C(=O)-O- or *-C(=O)-NH- wherein * designates a point of attachment to the carbon atom in the backbone. Z³ is a single bond, -O-, *-C(=O)-O-Z³¹-Z³²- or *-C(=O)-NH-Z³¹-Z³²-, wherein Z³¹ is a single bond or a C₁-C₁₀ saturated hydrocarbylene group, Z³² is a single bond, ester bond, ether bond or sulfonamide bond, and * designates a point of attachment to the carbon atom in the backbone.

In formulae (D1) and (D2), the C₁-C₁₀ saturated hydrocarbyl group represented by R¹⁰¹, R¹⁰², R¹⁰⁴ and R¹⁰⁵ may be straight, branched or cyclic and examples thereof include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (h+1)-valent hydrocarbon group Z¹ include the foregoing C₁-C₂₀ alkyl groups and C₃-C₂₀ cyclic saturated hydrocarbyl groups, with h number of hydrogen atoms being eliminated. Examples of the C₁-C₂₀ (h+1)-valent fluorinated hydrocarbon group Z¹ include the foregoing (h+1)-valent hydrocarbon groups in which at least one hydrogen atom is substituted by fluorine.

Examples of the repeat units D1 to D4 are given below, but not limited thereto. Herein R^{C} is as defined above.

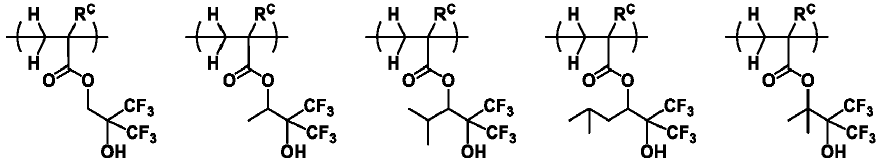

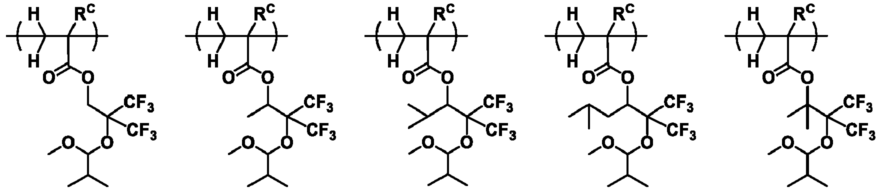

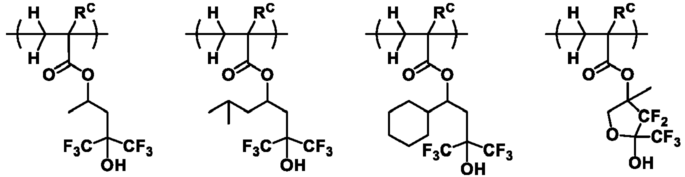

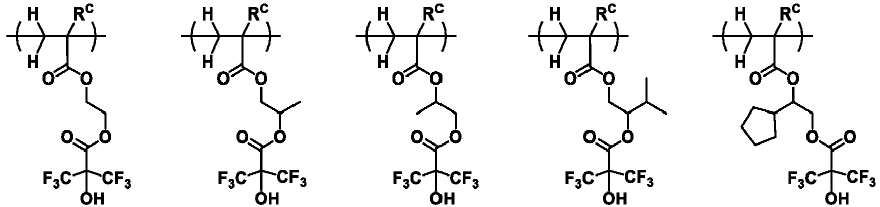

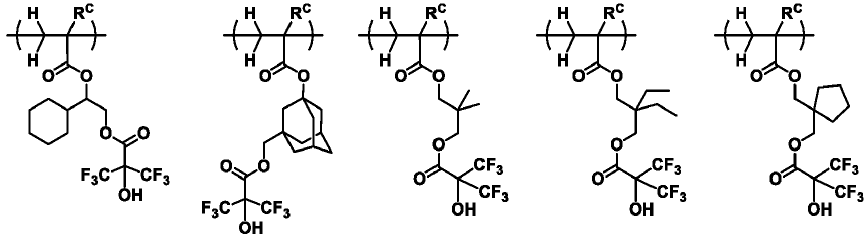

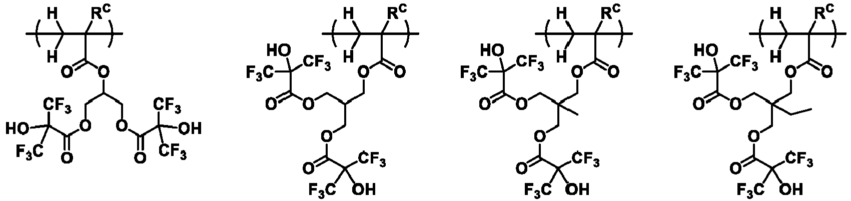

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{D} is methyl. The inclusion of carbonyl in Z² enhances the ability to trap the acid originating from the anti-charging film. A polymer wherein R^{D} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{D} is as defined above.

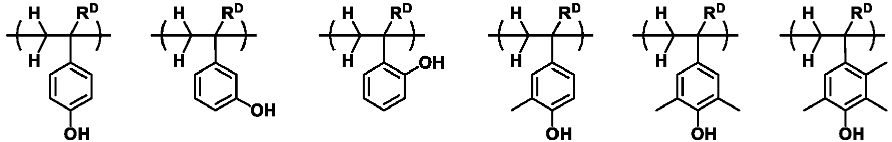

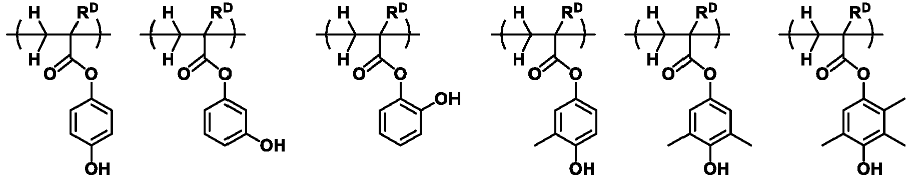

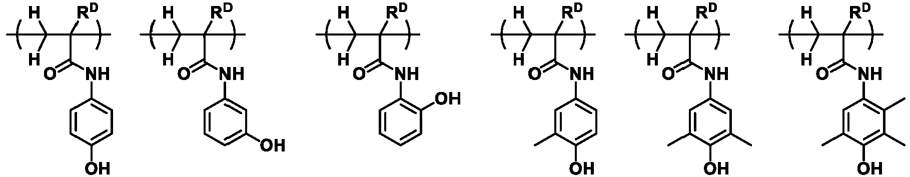

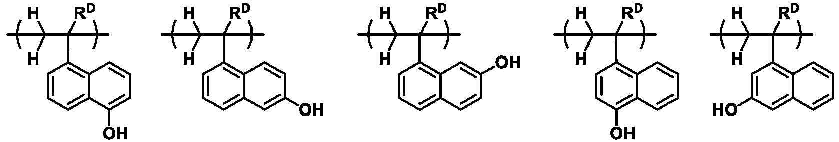

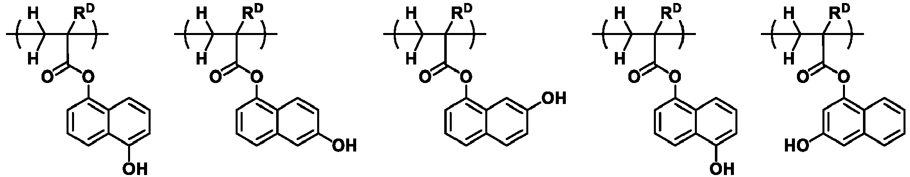

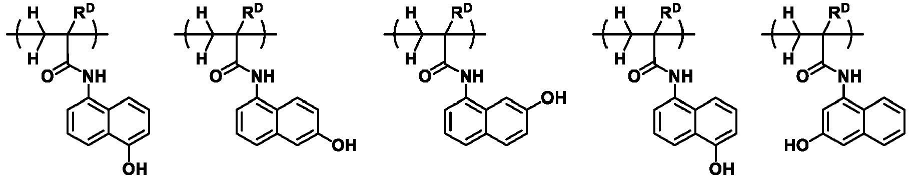

In formula (D6), the C₁-C₁₀ saturated hydrocarbylene group Z³ may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1 -dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{D} is as defined above.

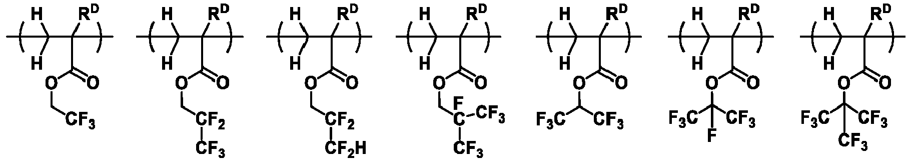

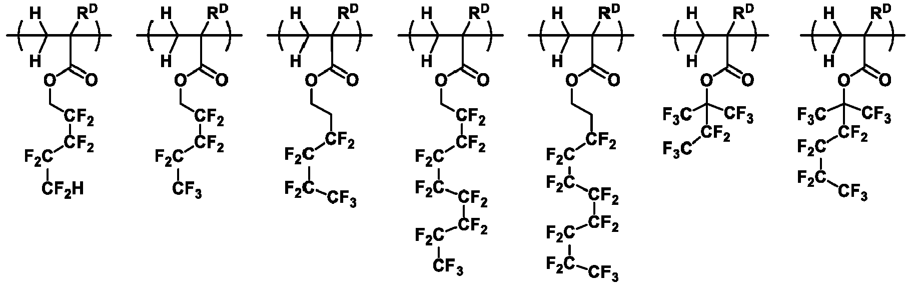

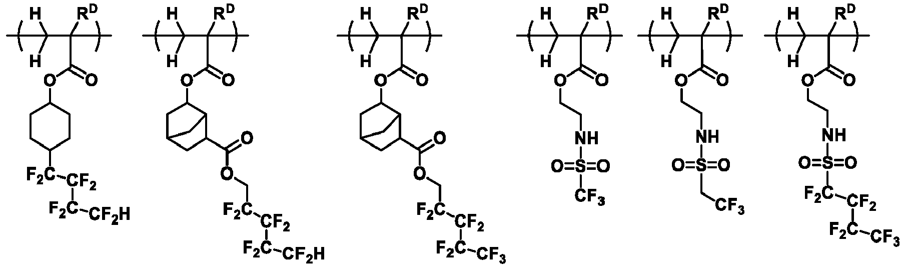

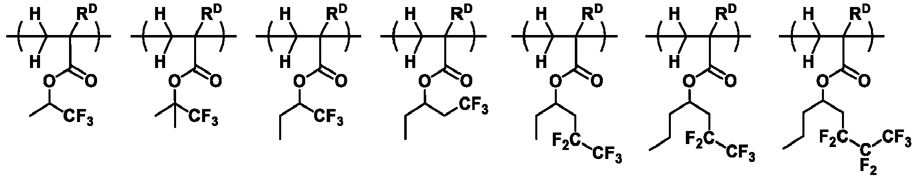

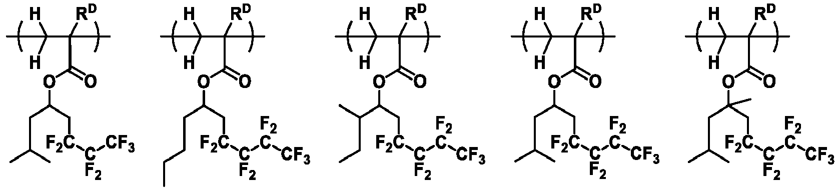

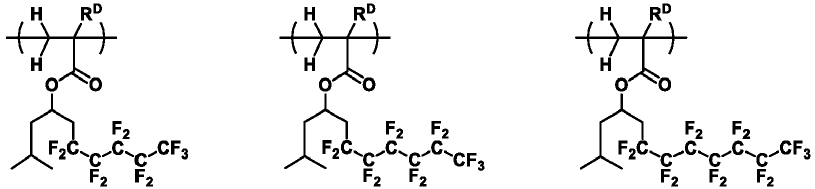

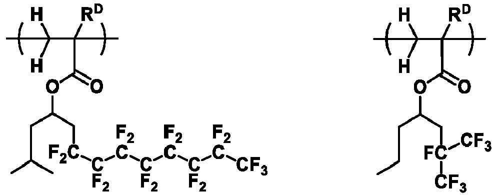

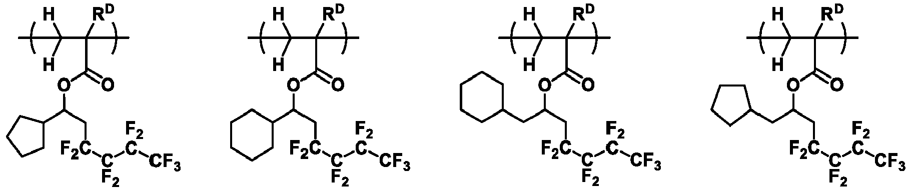

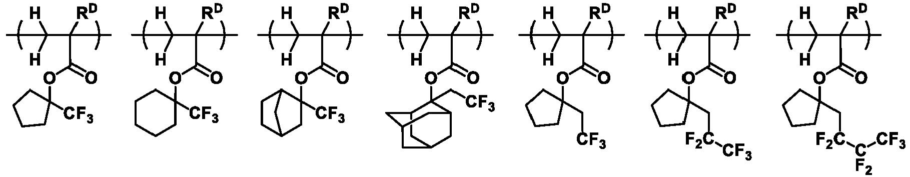

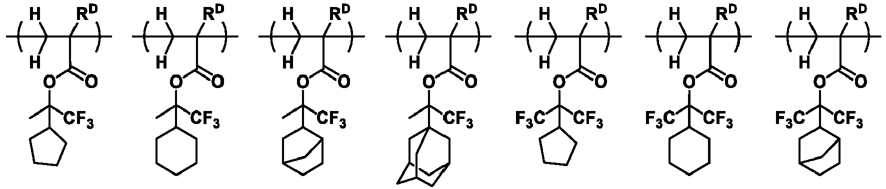

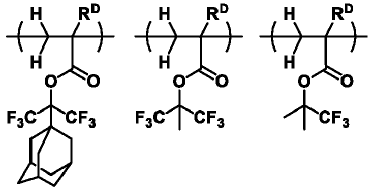

The content of repeat units D1 to D4 is preferably 15 to 95 mol%, more preferably 20 to 85 mol% based on the overall repeat units of the fluorinated polymer. The content of repeat unit D5 and/or D6 is preferably 5 to 85 mol%, more preferably 15 to 80 mol% based on the overall repeat units of the fluorinated polymer. Each of repeat units D 1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 may help acid diffusion, degrading resolution and detracting from age stability. A polymer with too high Mw may have a reduced solubility in solvent, with a risk of leaving coating defects. The fluorinated polymer preferably has a dispersity (Mw/Mn) of 1.0 to 2.2, more preferably 1.0 to 1.7.

In the resist composition, the fluorinated polymer (D) is preferably used in an amount of 0.01 to 30 parts by weight, more preferably 0.1 to 20 parts by weight, even more preferably 0.5 to 10 parts by weight per 80 parts by weight of the base polymer (B). The fluorinated polymer may be used alone or in admixture.

### (E) Organic solvent

The chemically amplified positive resist composition may further comprise an organic solvent as component (E). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, t-butyl acetate, t-butyl propionate, and propylene glycol mono-t-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (E) is preferably used in an amount of 200 to 10,000 parts, more preferably 400 to 5,000 parts by weight per 80 parts by weight of the base polymer (B). The organic solvent may be used alone or in admixture.

### (F) Basic compound

In the positive resist composition, (F) a basic compound may be added as the quencher other than component (A) for the purpose of correcting a pattern profile or the like. The basic compound is effective for controlling acid diffusion. Even when the resist film is applied to a substrate having an outermost surface layer made of a material containing chromium, tantalum or silicon, the basic compound is effective for minimizing the influence of the acid generated in the resist film on the substrate.

Numerous basic compounds are known useful including primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, carbamate derivatives, and ammonium salts. Examples are described in Patent Document 9, for example, and any such compounds are useful. Of the foregoing basic compounds, preferred are tris[2-(methoxymethoxy)ethyl]amine, tris[2-(methoxymethoxy)ethyl]amine-N-oxide, dibutylaminobenzoic acid, morpholine derivatives and imidazole derivatives.

In the positive resist composition, the basic compound (F) is preferably added in an amount of 0 to 10 parts, and more preferably 0 to 5 parts by weight per 80 parts by weight of the base polymer (B). The basic compounds may be used alone or in admixture.

### (G) Surfactant

The positive resist composition may contain any conventional surfactants for facilitating to coat the composition to the substrate. A number of surfactants are known in the art as described in JP-A 2004-115630, and any suitable one may be chosen therefrom. The amount of the surfactant (F) added is preferably 0 to 5 parts by weight per 80 parts by weight of the base polymer (B). The surfactant may be used alone or in admixture.

### Process

Another embodiment of the invention is a resist pattern forming process comprising the steps of applying the chemically amplified positive resist composition defined above onto a substrate to form a resist film thereon, exposing the resist film patternwise to high-energy radiation, and developing the exposed resist film in an alkaline developer to form a resist pattern.

The substrate used herein may be selected from, for example, substrates for IC fabrication, e.g., Si, SiO, SiOz, SiN, SiON, TiN, WSi, BPSG, SOG, and organic antireflective coating, and substrates for mask circuit fabrication, e.g., Cr, CrO, CrON, MoSi₂, Si, SiO, SiOz, SiON, SiONC, CoTa, NiTa, TaBN, and SnOz.

First the resist composition is applied onto a substrate by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV, x-ray, γ-ray, synchrotron radiation or EB. The resist composition of the invention is especially effective in the EUV or EB lithography.

On use of UV, deep-UV, EUV, excimer laser, x-ray, γ-ray or synchrotron radiation as the high-energy radiation, the resist film is exposed through a mask having a desired pattern, preferably in a dose of 1 to 500 mJ/cm², more preferably 10 to 400 mJ/cm². On use of EB, a pattern may be written directly in a dose of preferably 1 to 500 µC/cm², more preferably 10 to 400 µC/cm², even more preferably 100 to 400 µC/cm².

The exposure may be performed by conventional lithography whereas the immersion lithography of holding a liquid, typically water between the mask and the resist film may be employed if desired. In the immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

From the positive resist composition, a pattern with a high resolution and reduced LER can be formed. The resist composition is effectively applicable to a substrate, specifically a substrate having a surface layer of material to which a resist film is less adherent and which is likely to invite pattern stripping or pattern collapse, and particularly a substrate having sputter deposited on its outermost surface metallic chromium or a chromium compound containing at least one light element selected from oxygen, nitrogen and carbon or a substrate having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

Even on a substrate (typically mask blank) whose outermost surface is made of a material tending to affect resist pattern profile such as a chromium or silicon-containing material, the resist pattern forming process is successful in forming patterns of rectangular profile having a high resolution, reduced LER, fidelity and improved dose margin because the resist composition is effective for controlling acid diffusion at the substrate interface.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards using THF or DMF solvent.

### [1] Preparation of chemically amplified positive resist compositions

### Examples 1-1 to 1-42 and Comparative Examples 1-1 to 1-3

Chemically amplified positive resist compositions (R-1 to R-42, CR-1 to CR-3) were prepared by dissolving selected components in an organic solvent in accordance with the formulation shown in Tables 1 to 3, and filtering the solution through a UPE filter and/or nylon filter with a pore size of up to 10 nm. The organic solvent was a mixture of 1,000 pbw of PGMEA, 2,000 pbw of EL, and 2,000 pbw of PGME.

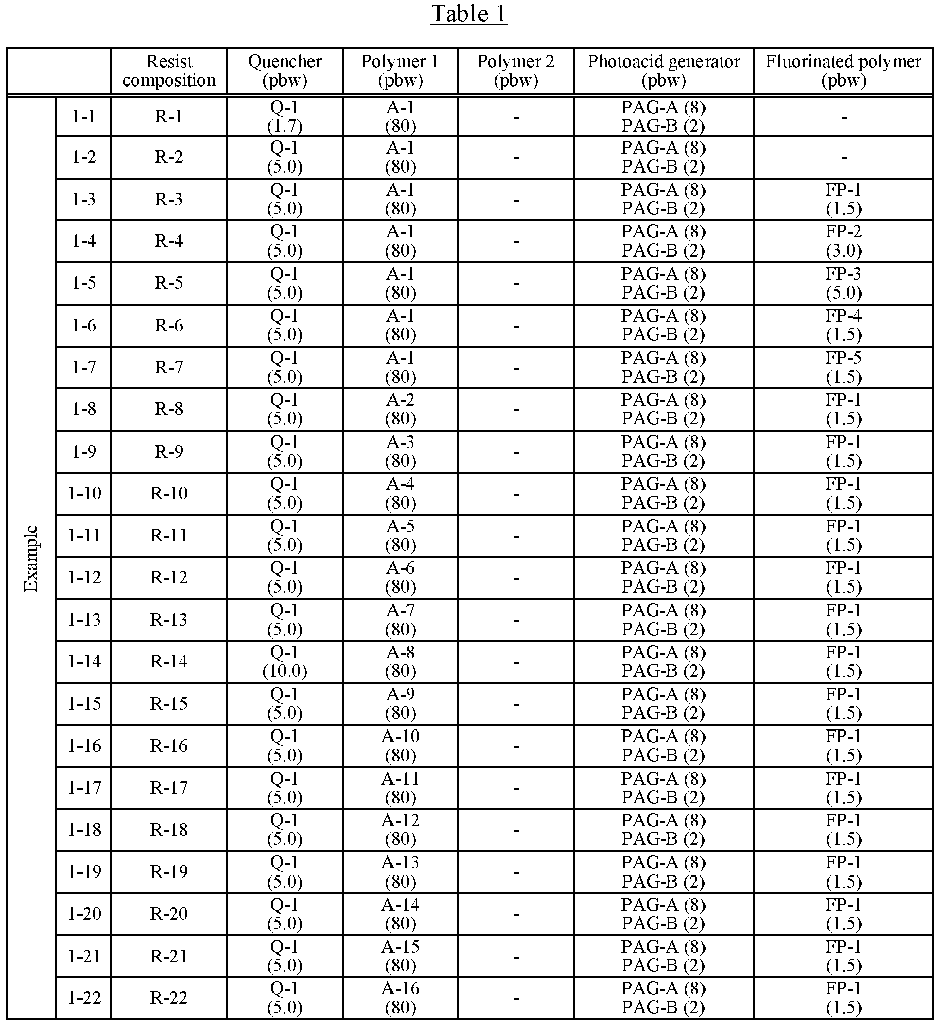

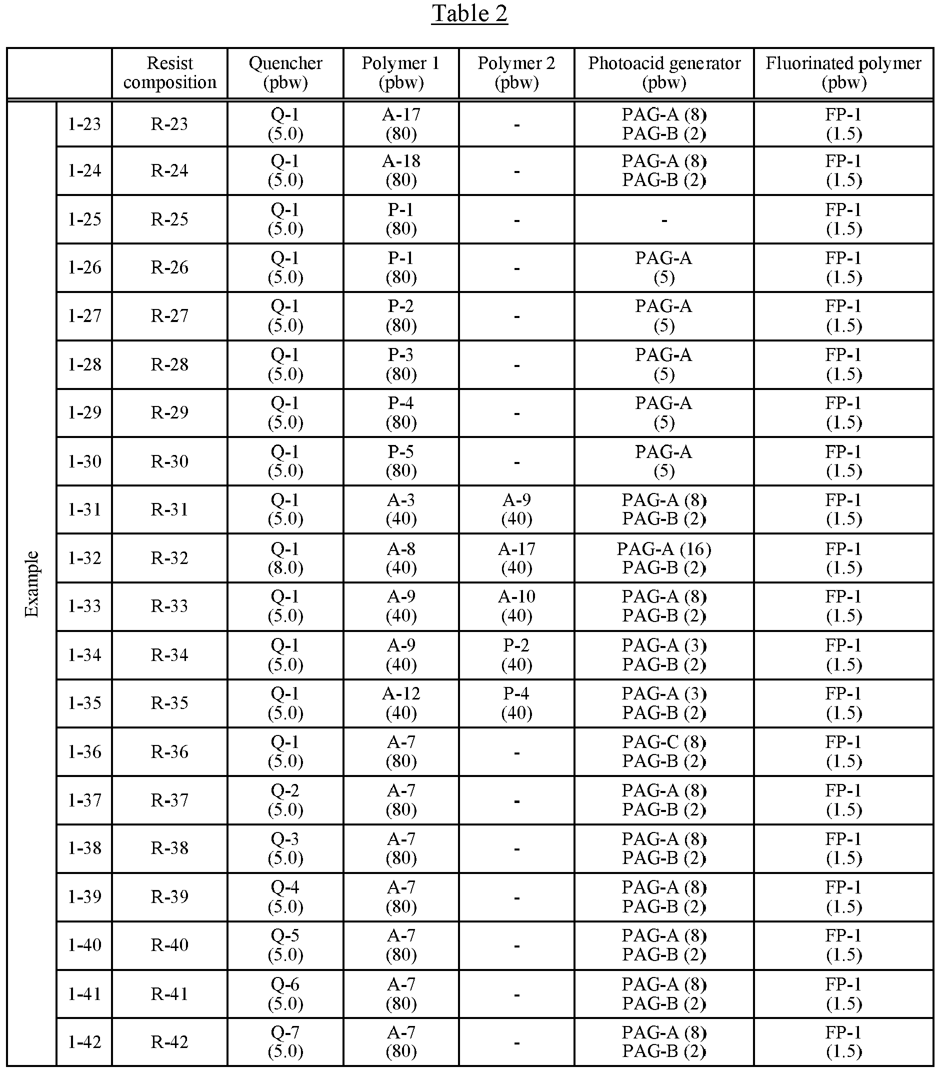

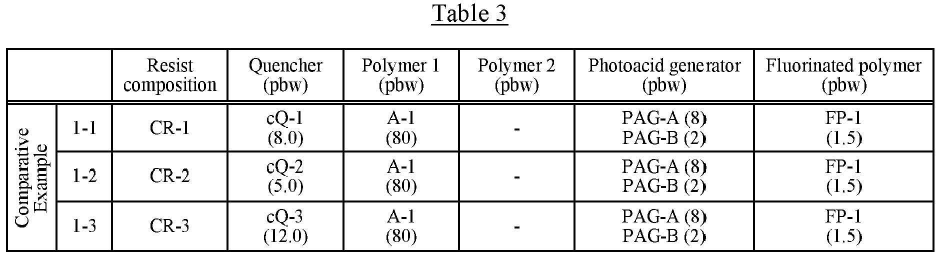

In Tables 1 to 3, quenchers Q-1 to Q-7, comparative quenchers cQ-1 to cQ-3, polymers A-1 to A-18, polymers P-1 to P-5, photoacid generators PAG-A to PAG-C, and fluorinated polymers FP-1 to FP-5 are identified below.

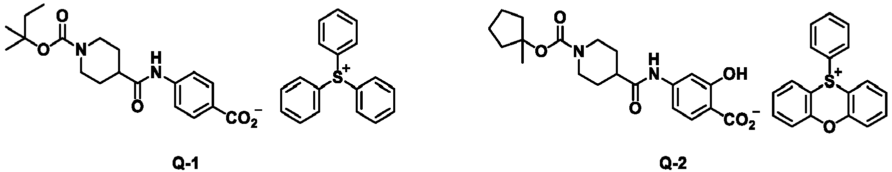

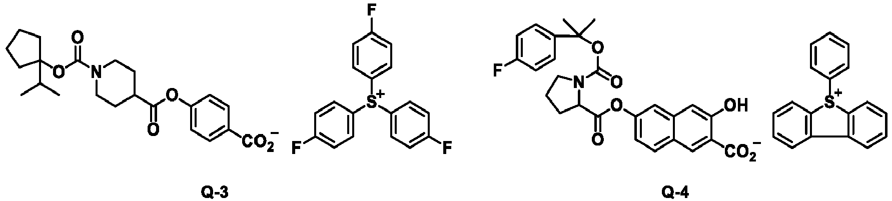

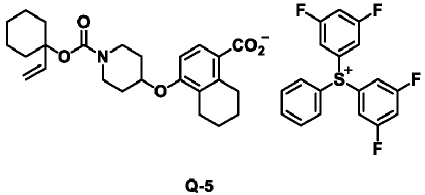

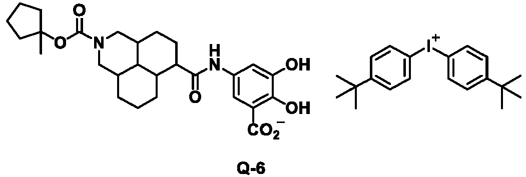

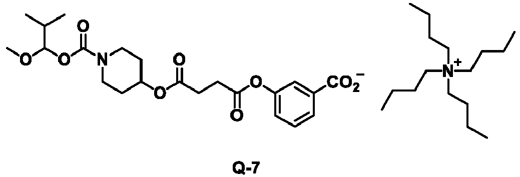

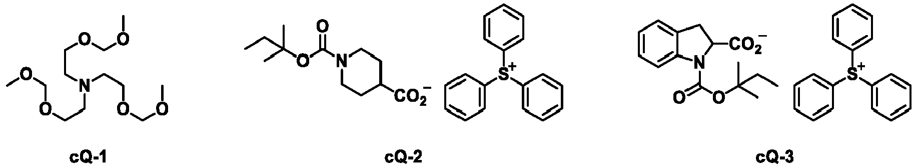

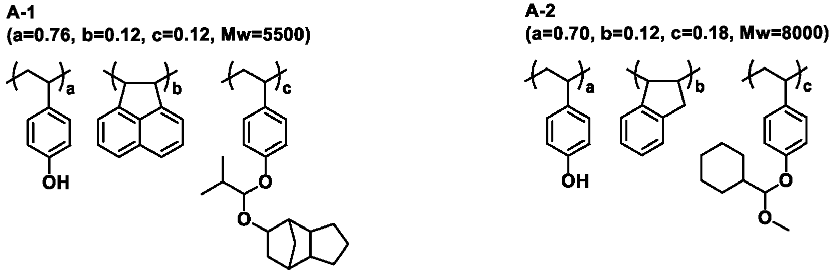

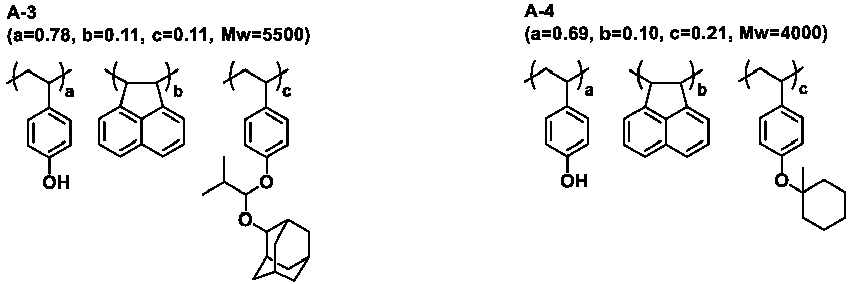

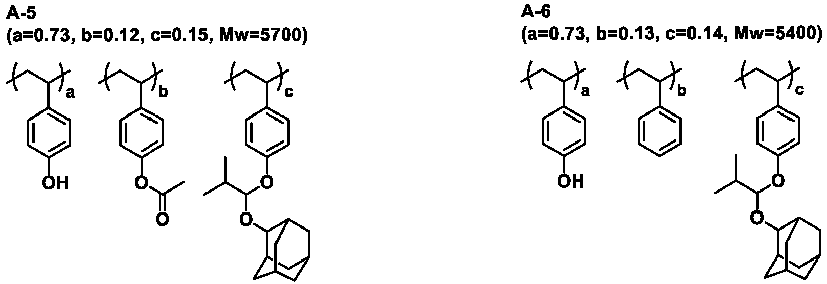

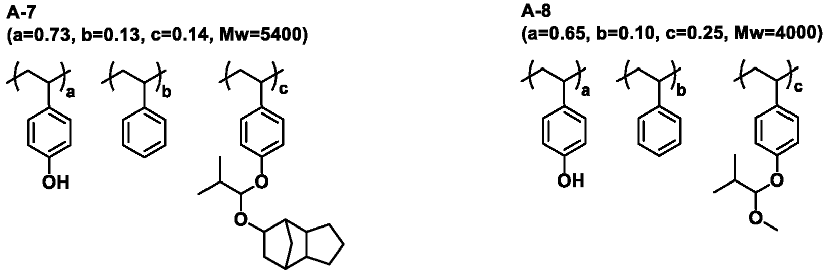

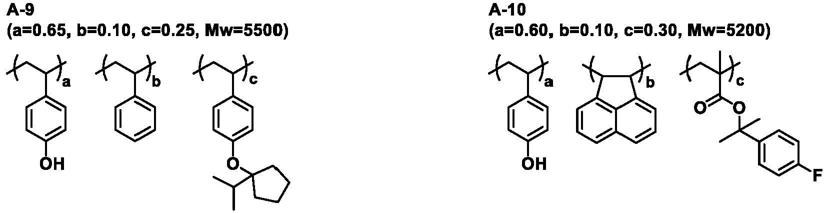

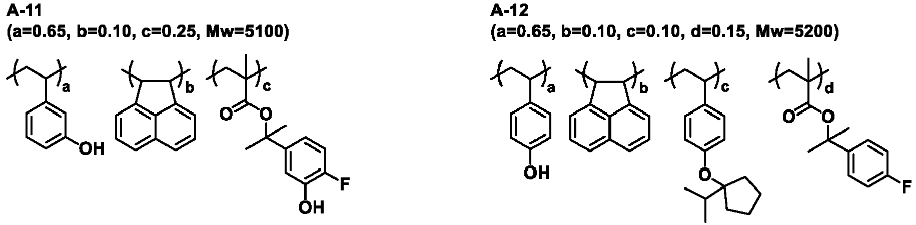

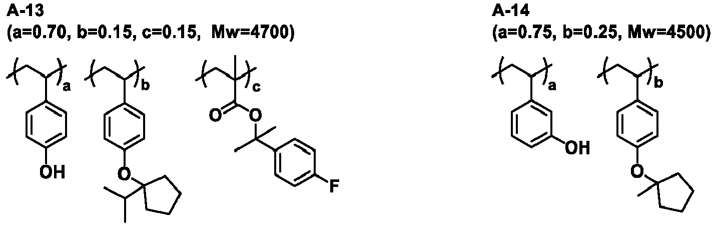

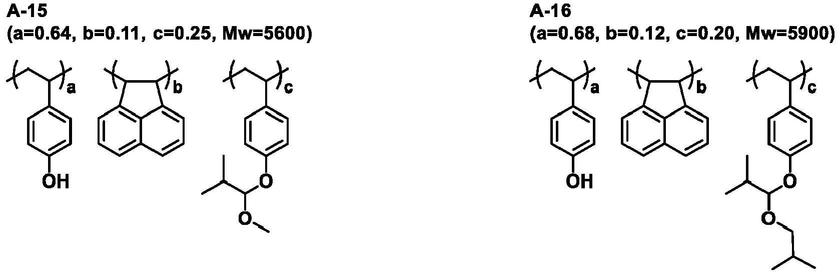

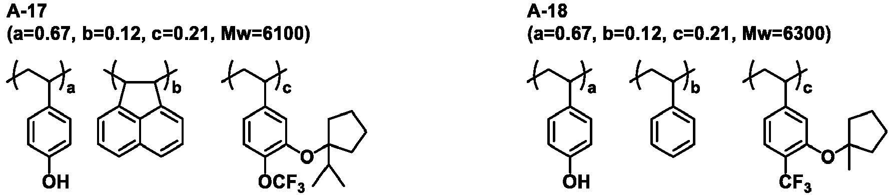

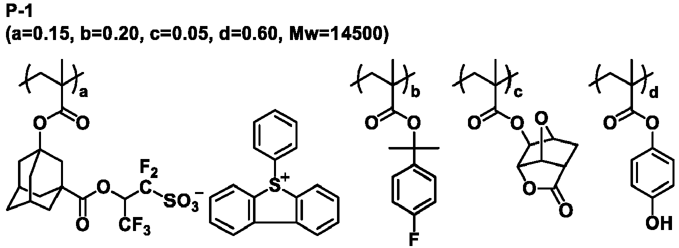

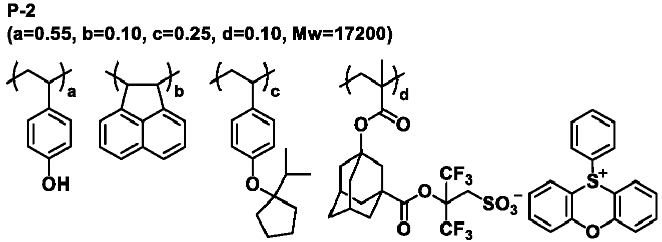

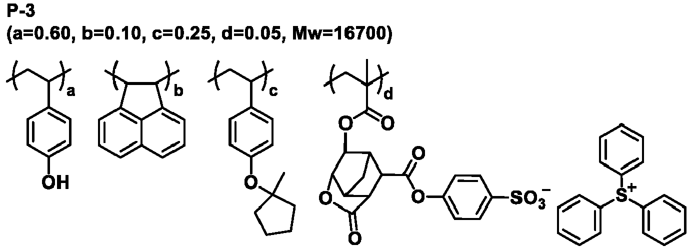

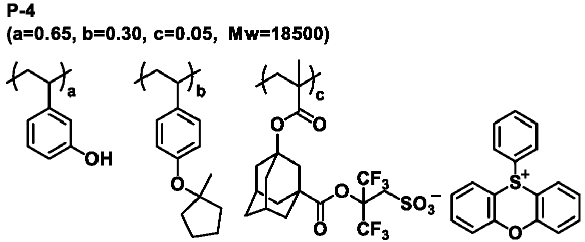

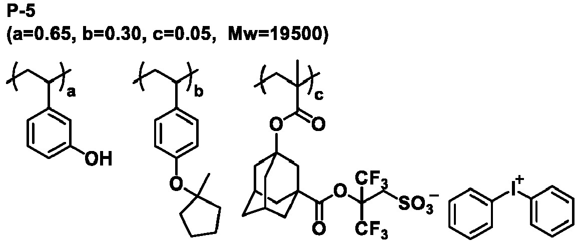

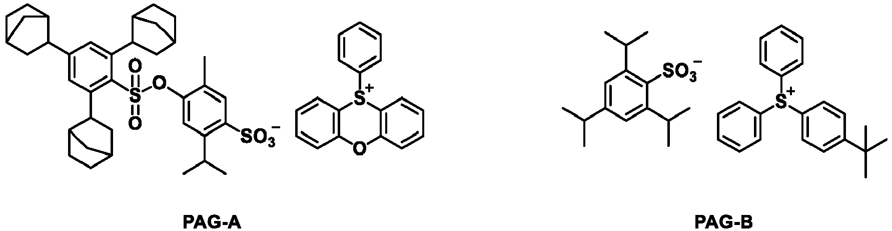

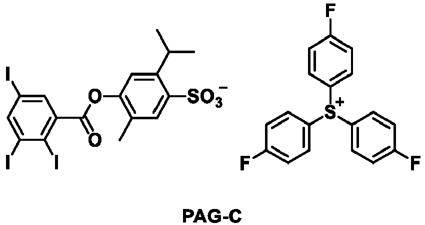

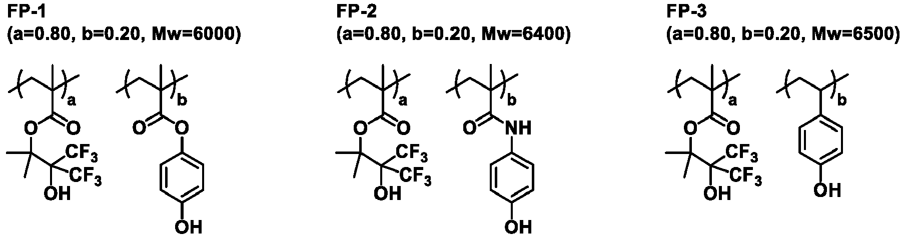

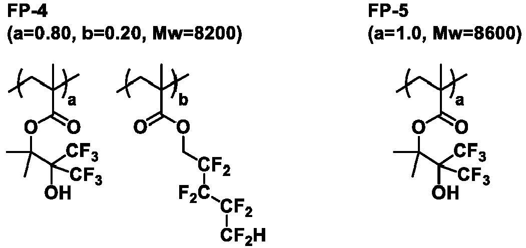

### [2] EB lithography test

### Examples 2-1 to 2-42 and Comparative Examples 2-1 to 2-3

A mask blank of reflection type for an EUV lithography mask was furnished by starting with a low-coefficient-of-thermal-expansion glass substrate and depositing thereon a multilayer reflective film of 40 Mo/Si layers with a thickness of 284 nm, a Ru film of 3.5 nm thick as protective film, a TaN film of 70 nm thick as absorbing layer, and a CrN film of 6 nm thick as hard mask. Using a coater/developer system ACT-M (Tokyo Electron Ltd.), each of the resist compositions (R-1 to R-42, CR-1 to CR-3) was spin coated onto the mask blank, and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TDSEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum line width of a LS pattern that could be resolved at the optimum dose. The 200-nm LS pattern printed by exposure at the optimum dose (Eop) was observed under SEM. For each of the edges of 32 lines of the LS pattern, edge detection was carried out at 80 points, from which a 3-fold value (3σ) of the standard deviation (σ) or variation was determined and reported as LER (nm). A change of CD per µC relative to the exposure dose providing 1: 1 resolution was determined from the dose curve. The results are shown in Tables 4 to 6.

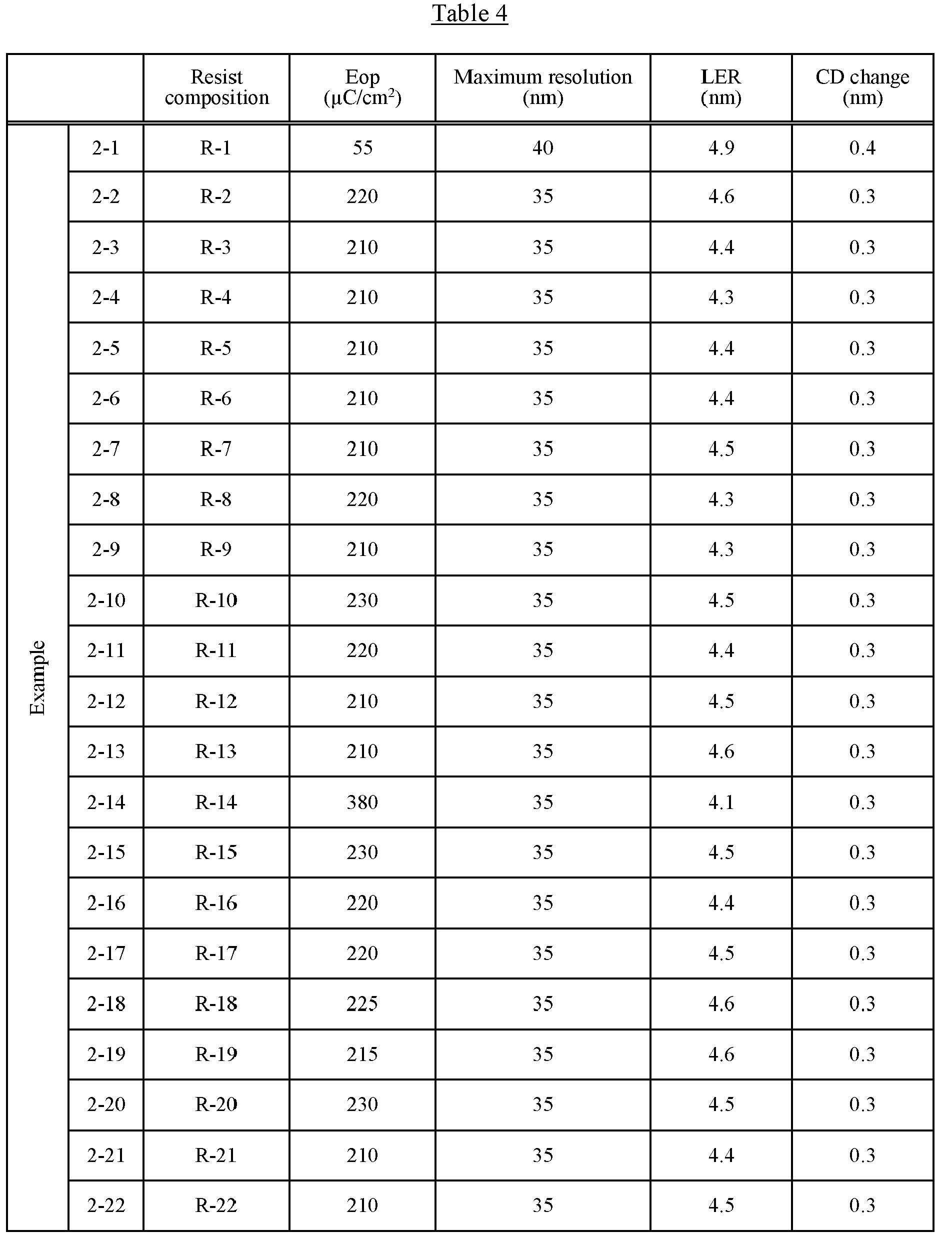

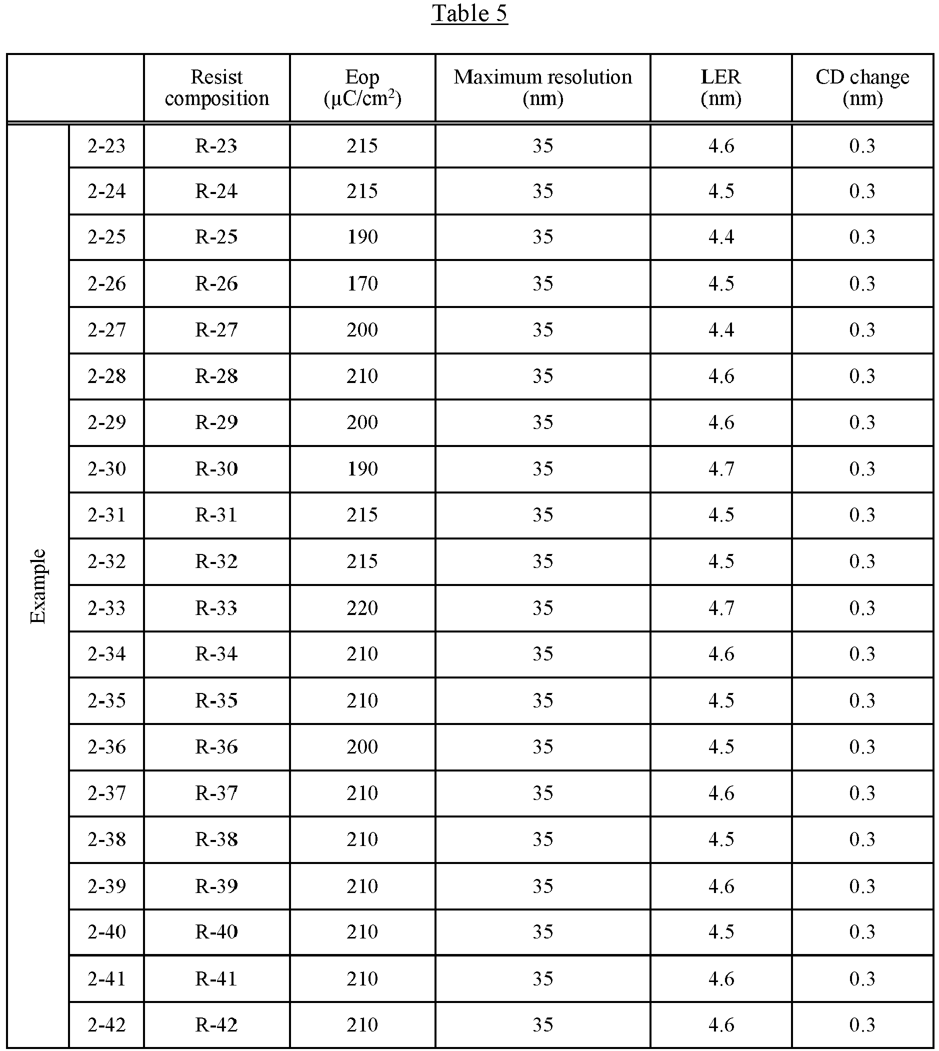

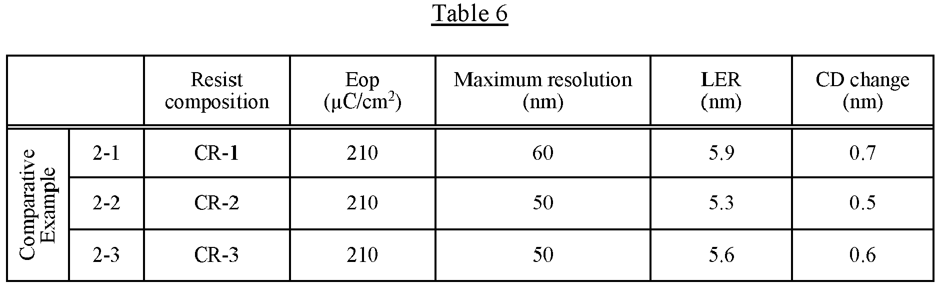

As compared with comparative resist compositions (CR-1 to CR-3), the chemically amplified positive resist compositions (R-1 to R-42) within the scope of the invention show satisfactory resolution and acceptable values of LER and dose margin because the onium salt having formula (A) exerts an acid diffusion-suppressing effect.

Because of a high quenching ability, the onium salt having formula (A) is effective for adjusting the resist sensitivity even when used in a small amount, highly compatible with the solvent, and uniformly dispersed in the resist film. These contribute to acceptable values of LER. An appropriate degree of lipophilicity leads to improved rigidity and suppressed swell. Consequently, patterns of rectangular profile with satisfactory resolution are obtainable in contrast to the rounded top profile of CR-1 to CR-3.

Using the chemically amplified positive resist composition within the scope of the invention, a resist pattern of rectangular profile having a very high resolution, reduced LER and improved dose margin can be formed. The resist pattern forming process using the positive resist composition is useful in photolithography for the fabrication of semiconductor devices and the processing of photomask blanks of transmission or reflection type.

## Claims

1. A chemically amplified positive resist composition comprising (A) a quencher containing an onium salt having the formula (A) and (B) a base polymer containing a polymer which is decomposed under the action of acid to increase its solubility in alkaline developer, the polymer comprising repeat units having the formula (B1), 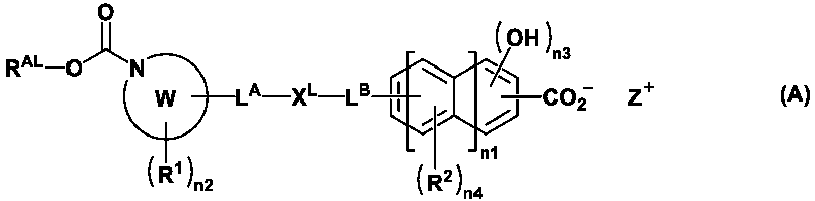
wherein n1 is 0 or 1, n2 is an integer of 0 to 6, n3 is an integer of 0 to 3, n4 is an integer of 0 to 4,
W is a C₂-C₂₀ nitrogen-containing aliphatic heterocycle which may contain a heteroatom,
L^{A} and L^{B} are each independently a single bond, ether bond, ester bond, amide bond, sulfonate ester bond, carbonate bond or carbamate bond,
X^{L} is a single bond or a C₁-C₄₀ hydrocarbylene group which may contain a heteroatom,
R¹ is a C₁-C₂₀ hydrocarbyl group which may contain a heteroatom, and when n2 is 2 or more, a plurality of R¹ may bond together to form a ring with the carbon atoms on W to which they are attached,
R² is halogen or a C₁-C₂₀ hydrocarbyl group which may contain a heteroatom, and when n4 is 2 or more, a plurality of R² may bond together to form a ring with the carbon atoms on the aromatic ring to which they are attached,
R^{AL} is an acid labile group, and
Z⁺ is an onium cation, 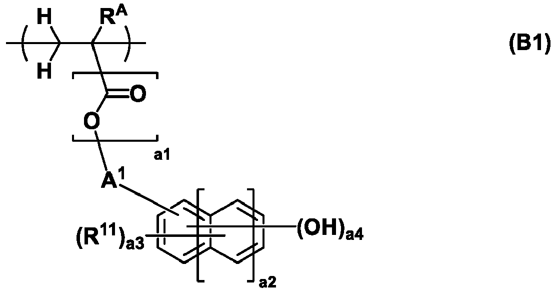
wherein a1 is 0 or 1, a2 is an integer of 0 to 2, a3 is an integer satisfying 0 ≤ a3 ≤ 5+2(a2)-a4, a4 is an integer of 1 to 3,
R^{A} is hydrogen, fluorine, methyl or trifluoromethyl,
R¹¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, and
A¹ is a single bond or C₁-C₁₀ saturated hydrocarbylene group in which some constituent -CH₂- may be replaced by -O-.

2. The positive resist composition of claim 1 wherein R^{AL} is a group having the formula (AL-1) or (AL-2): 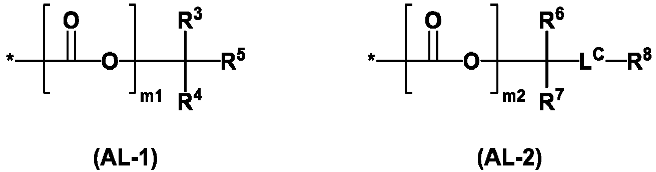 wherein L^{C} is -O- or -S-,
R³, R⁴ and R⁵ are each independently a C₁-C₁₀ hydrocarbyl group, any two of R³, R⁴ and R⁵ may bond together to form a ring with the carbon atom to which they are attached,
R⁶ and R⁷ are each independently hydrogen or a C₁-C₁₀ hydrocarbyl group, R⁸ is a C₁-C₂₀ hydrocarbyl group in which -CH₂- may be replaced by -O- or -S-, R⁷ and R⁸ may bond together to form a C₃-C₂₀ heterocyclic group with the carbon atom and L^{C} to which they are attached, -CH₂- in the heterocyclic group may be replaced by -O- or -S-,
m1 and m2 are each independently 0 or 1, and
* designates a point of attachment to the adjacent -O-.

3. The positive resist composition of claim 1 or 2 wherein Z⁺ is a sulfonium cation having the formula (cation-1), iodonium cation having the formula (cation-2), or ammonium cation having the formula (cation-3): 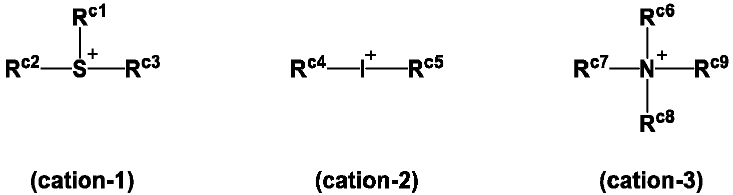 wherein R^{c1} to R^{c9} are each independently halogen or a C₁-C₃₀ hydrocarbyl group which may contain a heteroatom, R^{c1} and R^{c2} may bond together to form a ring with the sulfur atom to which they are attached.

4. The positive resist composition of any one of claims 1 to 3 wherein the onium salt has the formula (A1): 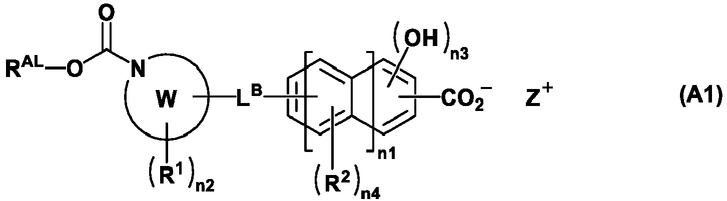 wherein n1 to n4, W, L^{B}, R¹, R², R^{AL} and Z⁺ are as defined above.

5. The positive resist composition of any one of claims 1 to 4 wherein the polymer further comprises repeat units of at least one type selected from repeat units having the formula (B2-1) and repeat units having the formula (B2-2): 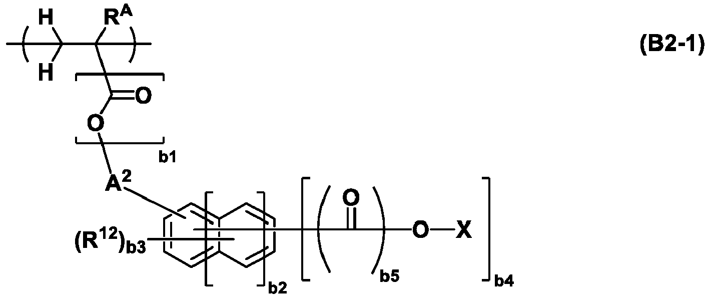 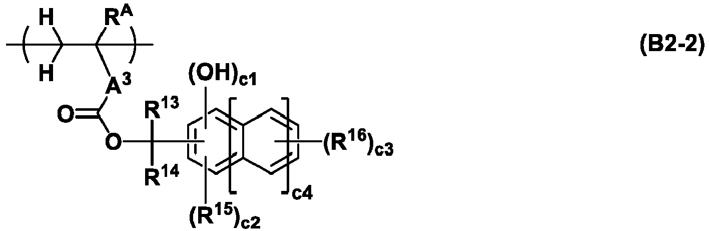 wherein b1 is 0 or 1, b2 is an integer of 0 to 2, b3 is an integer meeting 0 ≤ b3 ≤ 5+2(b2)-b4, b4 is an integer of 1 to 3, b5 is 0 or 1,
c1 is an integer of 0 to 2, c2 is an integer of 0 to 2, c3 is an integer of 0 to 5, c4 is an integer of 0 to 2,
R^{A} is hydrogen, fluorine, methyl or trifluoromethyl,
R¹² is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R¹³ and R¹⁴ are each independently a C₁-C₁₀ hydrocarbyl group which may contain a heteroatom, R¹³ and R¹⁴ may bond together to form a ring with the carbon atom to which they are attached,
R¹⁵ is each independently fluorine, a C₁-C₅ fluorinated alkyl group or C₁-C₅ fluorinated alkoxy group,
R¹⁶ is each independently a C₁-C₁₀ hydrocarbyl group which may contain a heteroatom,
A² is a single bond or a C₁-C₁₀ saturated hydrocarbylene group in which -CH₂- may be replaced by -O-,
X is an acid labile group in case of b4=1, and X is each independently hydrogen or an acid labile group, at least one being an acid labile group, in case of b4=2 or 3, and
A³ is a single bond, phenylene group, naphthylene group or *-C(=O)-O-A³¹-, A³¹ is a C₁-C₂₀ aliphatic hydrocarbylene group which may contain a hydroxy moiety, ether bond, ester bond or lactone ring, or a phenylene group or naphthylene group, and * designates a point of attachment to the carbon atom in the backbone.

6. The positive resist composition of any one of claims 1 to 5 wherein the polymer further comprises repeat units of at least one type selected from repeat units having the formula (B3), repeat units having the formula (B4), and repeat units having the formula (B5): 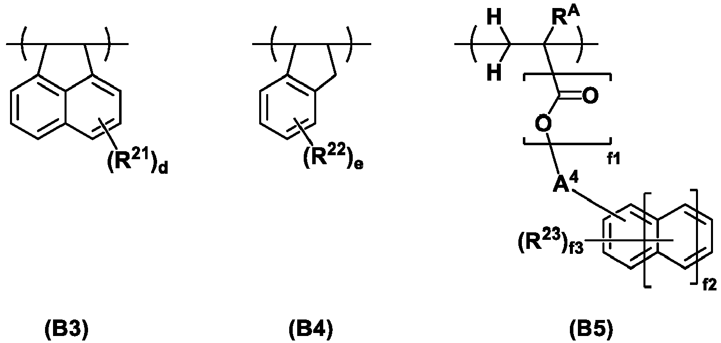 wherein d and e are each independently an integer of 0 to 4, f1 is 0 or 1, f2 is an integer of 0 to 2, f3 is an integer of 0 to 5,
R^{A} is hydrogen, fluorine, methyl or trifluoromethyl,
R²¹ and R²² are each independently hydroxy, halogen, optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R²³ is halogen, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbyl sulfonyl group, and
A⁴ is a single bond or C₁-C₁₀ saturated hydrocarbylene group in which -CH₂- may be replaced by -O-.

7. The positive resist composition of any one of claims 1 to 6 wherein the polymer further comprises repeat units of at least one type selected from repeat units having the formulae (B6) to (B13): 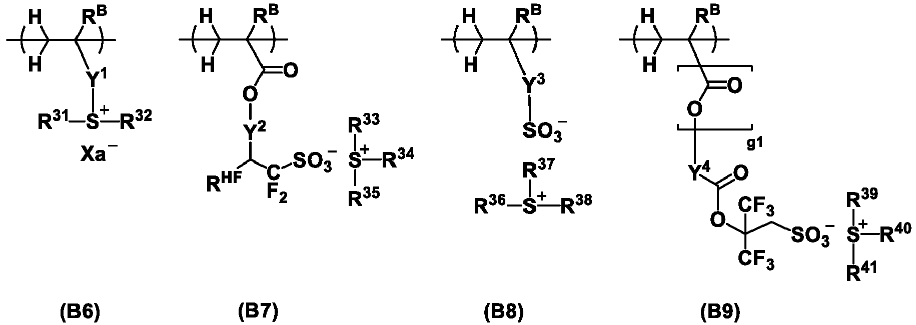 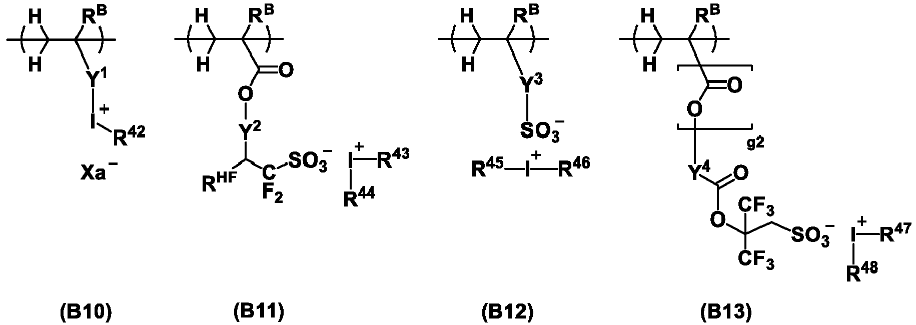 wherein R^{B} is each independently hydrogen or methyl,
Y¹ is a single bond, a C₁-C₆ aliphatic hydrocarbylene group, phenylene group, naphthylene group or C₇-C₁₈ group obtained by combining the foregoing, *-O-Y¹¹-, *-C(=O)-O-Y¹¹-, or *-C(=O)-NH-Y¹¹-, Y¹¹ is a C₁-C₆ aliphatic hydrocarbylene group, phenylene group, naphthylene group or C₇-C₁₈ group obtained by combining the foregoing, which may contain a carbonyl moiety, ester bond, ether bond or hydroxy moiety,
Y² is a single bond or **-Y^{Z1}-C(=O)-O-, Y²¹ is a C₁-C₂₀ hydrocarbylene group which may contain a heteroatom,
Y³ is a single bond, methylene, ethylene, phenylene, fluorinated phenylene, trifluoromethyl-substituted phenylene, *-O-Y³¹-, *-C(=O)-O-Y³¹-, or *-C(=O)-NH-Y³¹-, Y³¹ is a C₁-C₆ aliphatic hydrocarbylene group, phenylene group, fluorinated phenylene group, trifluoromethyl-substituted phenylene group, or C₇-C₂₀ group obtained by combining the foregoing, which may contain a carbonyl moiety, ester bond, ether bond or hydroxy moiety,
* designates a point of attachment to the carbon atom in the backbone, ** designates a point of attachment to the oxygen atom in the formula,
Y⁴ is a single bond or C₁-C₃₀ hydrocarbylene group which may contain a heteroatom,
g1 and g2 are each independently 0 or 1, g1 and g2 are 0 when Y⁴ is a single bond,
R³¹ to R⁴⁸ are each independently halogen or a C₁-C₂₀ hydrocarbyl group which may contain a heteroatom, R³¹ and R³² may bond together to form a ring with the sulfur atom to which they are attached, R³³ and R³⁴, R³⁶ and R³⁷, or R³⁹ and R⁴⁰ may bond together to form a ring with the sulfur atom to which they are attached,
R^{HF} is hydrogen or trifluoromethyl, and
Xa⁻ is a non-nucleophilic counter ion.

8. The positive resist composition of any one of claims 1 to 7 wherein repeat units having an aromatic ring structure account for at least 60 mol% of the overall repeat units of the polymer in the base polymer.

9. The positive resist composition of any one of claims 1 to 8, further comprising (C) a photoacid generator.

10. The positive resist composition of any one of claims 1 to 9, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 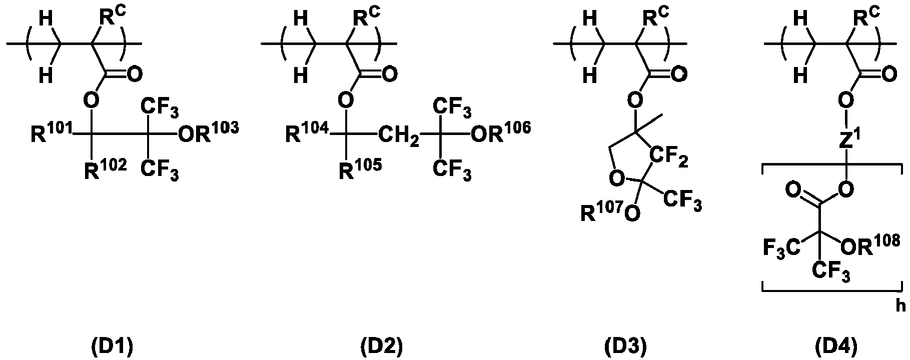 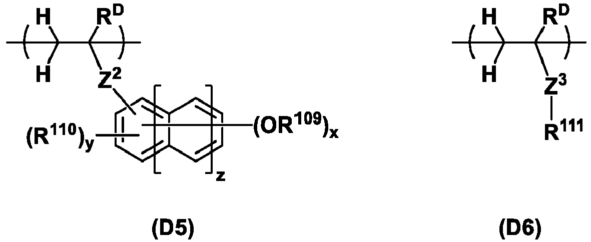 wherein x is an integer of 1 to 3, y is an integer satisfying 0 ≤ y ≤ 5+2z-x, z is 0 or 1, h is an integer of 1 to 3,
R^{C} is each independently hydrogen, fluorine, methyl or trifluoromethyl,
R^{D} is each independently hydrogen or methyl,
R¹⁰¹, R¹⁰² , R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some constituent -CH₂- may be replaced by an ester bond or ether bond,
Z¹ is a C₁-C₂₀ (h+1)-valent hydrocarbon group or C₁-C₂₀ (h+1)-valent fluorinated hydrocarbon group,
Z² is a single bond, *-C(=O)-O- or *-C(=O)-NH-, * designates a point of attachment to the carbon atom in the backbone,
Z³ is a single bond, -O-, *-C(=O)-O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

11. The positive resist composition of any one of claims 1 to 10, further comprising (E) an organic solvent.

12. A resist pattern forming process comprising the steps of:
applying the chemically amplified positive resist composition of any one of claims 1 to 11 onto a substrate to form a resist film thereon,
exposing the resist film patternwise to high-energy radiation, and
developing the exposed resist film in an alkaline developer.

13. The process of claim 12 wherein the high-energy radiation is EUV or EB.

14. The process of claim 12 or 13 wherein the substrate has the outermost surface of a material containing at least one element selected from chromium, silicon, tantalum, molybdenum, cobalt, nickel, tungsten, and tin.

15. A mask blank of transmission or reflection type which is coated with the chemically amplified positive resist composition of any one of claims 1 to 11.
